(19) Europäisches Patentamt
European Patent Office
Office européen des brevets

(11) EP 4 220 859 A1

(12) EUROPEAN PATENT APPLICATION
published in accordance with Art. 153(4) EPC

(43) Date of publication:
**02.08.2023 Bulletin 2023/31**

(21) Application number: **21872137.1**

(22) Date of filing: **06.09.2021**

(51) International Patent Classification (IPC):
***H01Q 1/52*** (2006.01) ***H01Q 17/00*** (2006.01)
***H05K 9/00*** (2006.01)

(52) Cooperative Patent Classification (CPC):
**H01Q 1/52; H01Q 17/00; H05K 9/00**

(86) International application number:
**PCT/JP2021/032590**

(87) International publication number:
**WO 2022/065006 (31.03.2022 Gazette 2022/13)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **28.09.2020 JP 2020162310**

(71) Applicant: **FUJIFILM Corporation**
**Tokyo 106-8620 (JP)**

(72) Inventor: **MASUDA Seiya**
**Haibara-gun, Shizuoka 421-0396 (JP)**

(74) Representative: **HGF**
**HGF Limited**
**1 City Walk**
**Leeds LS11 9DX (GB)**

# (54) LAMINATE MANUFACTURING METHOD, ANTENNA-IN PACKAGE MANUFACTURING METHOD, LAMINATE, AND COMPOSITION

(57) Provided are a method for producing a laminate, which enables easy production of a laminate having a magnetic pattern that absorbs electromagnetic waves transmitted from or received by an antenna; a method for producing an antenna-in-package; a laminate having a magnetic pattern that absorbs electromagnetic waves transmitted from or received by an antenna; and a composition. The method for producing a laminate is a method for producing a laminate including a step of applying a composition containing magnetic particles and a polymerizable compound onto a substrate on which an antenna is disposed to form a composition layer, and a step of subjecting the composition layer to an exposure treatment and a development treatment to form a magnetic pattern portion, in which the magnetic pattern portion is disposed on at least a part of a periphery of the antenna while being spaced apart from the antenna on the substrate.

FIG. 1

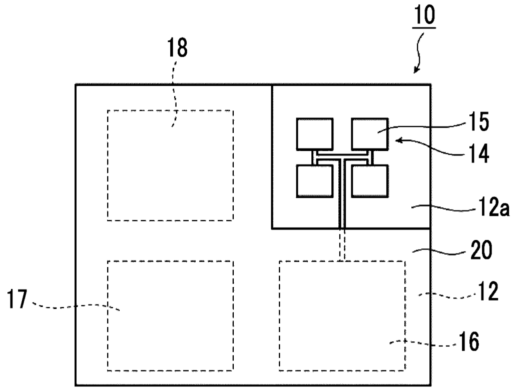


EP 4 220 859 A1

## Description

## BACKGROUND OF THE INVENTION

1. Field of the Invention

The present invention relates to a method for producing a laminate having a magnetic pattern that absorbs electromagnetic waves transmitted from or received by an antenna, a method for producing an antenna-in-package, a laminate, and a composition.

2. Description of the Related Art

Currently, there are various communication systems using wireless technology such as a mobile communication terminal such as a mobile phone, a smartphone or a tablet, Internet communication, wireless fidelity (WiFi), Bluetooth (registered trademark), and global positioning system (GPS).

In order to support various communication systems, an antenna capable of transmitting and receiving radio waves used for each communication system is required. In addition, a mounting density of a semiconductor element, an antenna, and the like is increasing due to the recent multi-functionalization and miniaturization of a mobile communication terminal and the miniaturization of a wireless communication module disposed at a communication access point or the like. For this reason, in the mobile communication terminal and the wireless communication module, for example, the semiconductor element may receive electromagnetic interference and be prevented from operating normally, which may lead to a malfunction. Therefore, the mobile communication terminal is provided with an electromagnetic wave absorber that absorbs electromagnetic waves that electromagnetically interfere with the semiconductor element.

For example, JP2019-057730A discloses a sheet-like electromagnetic wave absorber having a dielectric layer and a conductive layer provided on one side of the dielectric layer as the electromagnetic wave absorber. In this electromagnetic wave absorber, a thickness of the conductive layer is in a range of 20 nm to 100 μm, and a bandwidth of a frequency band in which an electromagnetic wave absorption amount is 20 dB or more in a frequency band of 60 to 90 GHz is 2 GHz or more.

## SUMMARY OF THE INVENTION

A recent mobile communication terminal has a high mounting density of a semiconductor element, an antenna, and the like as described above, and therefore is not capable of securing a sufficient space for disposing an electromagnetic wave absorber. It is difficult to provide a sheet-like electromagnetic wave absorber having a conductive layer provided on one side of a dielectric layer as disclosed in JP2019-057730A in a limited installation space.

An object of the present invention is to provide a method for producing a laminate, which enables easy production of a laminate having a magnetic pattern that absorbs electromagnetic waves transmitted from or received by an antenna, and a method for producing an antenna-in-package.

Another object of the present invention is to provide a laminate having a magnetic pattern that absorbs electromagnetic waves transmitted from or received by an antenna, and a composition.

The above-mentioned objects can be achieved by the following configuration.

One aspect of the present invention provides a method for producing a laminate including a step of applying a composition containing magnetic particles and a polymerizable compound onto a substrate on which an antenna is disposed to form a composition layer, and a step of subjecting the composition layer to an exposure treatment and a development treatment to form a magnetic pattern portion, in which the magnetic pattern portion is disposed on at least a part of a periphery of the antenna while being spaced apart from the antenna on the substrate.

It is preferable that a semiconductor element is further disposed on the substrate, and the magnetic pattern portion is disposed between the antenna and the semiconductor element on the substrate.

It is preferable that the magnetic pattern portion is present on an entire periphery of the antenna.

It is preferable that a width of the magnetic pattern portion is an integral multiple of 1/4 of a wavelength of an electromagnetic wave transmitted from or received by the antenna.

It is preferable that the magnetic pattern portion has an interval of an integral multiple of 1/4 of a wavelength of an electromagnetic wave transmitted from or received by the antenna.

It is preferable that the magnetic pattern portion is composed of a combination of a line and a space, in which each of the line and the space has a width of an integral multiple of a magnitude of 1/4 of a wavelength of an electromagnetic wave transmitted from or received by the antenna.

It is preferable that a thickness of the magnetic pattern portion is 300 μm or less.

It is preferable that the magnetic particles are magnetic particles containing at least one metal atom selected

from the group consisting of Fe, Ni, and Co, and an average primary particle diameter of the magnetic particles is 20 to 1,000 nm.

One aspect of the present invention provides a method for producing an antenna-in-package, including a method for producing the laminate of the present invention.

One aspect of the present invention provides a laminate having a substrate, an antenna disposed on the substrate, and a magnetic pattern portion disposed on at least a part of a periphery of the antenna while being spaced apart from the antenna.

One aspect of the present invention provides a composition that is used for forming the magnetic pattern portion in the laminate of the present invention, the composition containing magnetic particles and a polymerizable compound.

According to an aspect of the present invention, it is possible to provide a method for producing a laminate, which enables easy production of a laminate having a magnetic pattern that absorbs electromagnetic waves transmitted from or received by an antenna, and a method for producing an antenna-in-package.

According to another aspect of the present invention, it is possible to provide a laminate having a magnetic pattern that absorbs electromagnetic waves transmitted from or received by an antenna, and a composition.

## BRIEF DESCRIPTION OF THE DRAWINGS

Fig. 1 is a schematic perspective view showing an example of a laminate according to an embodiment of the present invention.

Fig. 2 is a schematic perspective view showing one step of a method for producing an example of the laminate according to the embodiment of the present invention.

Fig. 3 is a schematic perspective view showing one step of a method for producing an example of the laminate according to the embodiment of the present invention.

Fig. 4 is a schematic view showing a first example of a magnetic pattern portion of the laminate according to the embodiment of the present invention.

Fig. 5 is a schematic view showing a second example of the magnetic pattern portion of the laminate according to the embodiment of the present invention.

Fig. 6 is a schematic view showing a third example of the magnetic pattern portion of the laminate according to the embodiment of the present invention.

Fig. 7 is a schematic view showing a fourth example of the magnetic pattern portion of the laminate according to the embodiment of the present invention.

Fig. 8 is a schematic view showing a fifth example of the magnetic pattern portion of the laminate according to the embodiment of the present invention.

Fig. 9 is a schematic view showing a sixth example of the magnetic pattern portion of the laminate according to the embodiment of the present invention.

Fig. 10 is a schematic view showing a seventh example of the magnetic pattern portion of the laminate according to the embodiment of the present invention.

Fig. 11 is a schematic view showing an eighth example of the magnetic pattern portion of the laminate according to the embodiment of the present invention.

Fig. 12 is a schematic view showing a ninth example of the magnetic pattern portion of the laminate according to the embodiment of the present invention.

Fig. 13 is a schematic view showing a tenth example of the magnetic pattern portion of the laminate according to the embodiment of the present invention.

Fig. 14 is a schematic view showing an eleventh example of the magnetic pattern portion of the laminate according to the embodiment of the present invention.

Fig. 15 is a schematic view showing a twelfth example of the magnetic pattern portion of the laminate according to the embodiment of the present invention.

Fig. 16 is a schematic view showing a thirteenth example of the magnetic pattern portion of the laminate according to the embodiment of the present invention.

Fig. 17 is a schematic view showing a fourteenth example of the magnetic pattern portion of the laminate according to the embodiment of the present invention.

Fig. 18 is a schematic view showing a fifteenth example of the magnetic pattern portion of the laminate according to the embodiment of the present invention.

Fig. 19 is a schematic view showing a sixteenth example of the magnetic pattern portion of the laminate according to the embodiment of the present invention.

Fig. 20 is a schematic view showing a seventeenth example of the magnetic pattern portion of the laminate according

to the embodiment of the present invention.

Fig. 21 is a schematic view showing an eighteenth example of the magnetic pattern portion of the laminate according to the embodiment of the present invention.

Fig. 22 is a schematic view showing a nineteenth example of the magnetic pattern portion of the laminate according to the embodiment of the present invention.

Fig. 23 is a schematic view showing a twentieth example of the magnetic pattern portion of the laminate according to the embodiment of the present invention.

Fig. 24 is a schematic view showing a twenty-first example of the magnetic pattern portion of the laminate according to the embodiment of the present invention.

Fig. 25 is a schematic view showing a twenty-second example of the magnetic pattern portion of the laminate according to the embodiment of the present invention.

Fig. 26 is a schematic view showing a twenty-third example of the magnetic pattern portion of the laminate according to the embodiment of the present invention.

Fig. 27 is a schematic view showing a twenty-fourth example of the magnetic pattern portion of the laminate according to the embodiment of the present invention.

Fig. 28 is a schematic view showing a twenty-fifth example of the magnetic pattern portion of the laminate according to the embodiment of the present invention.

Fig. 29 is a schematic view showing a twenty-sixth example of the magnetic pattern portion of the laminate according to the embodiment of the present invention.

Fig. 30 is a schematic view showing a twenty-seventh example of the magnetic pattern portion of the laminate according to the embodiment of the present invention.

## DESCRIPTION OF THE PREFERRED EMBODIMENTS

Hereinafter, a method for producing a laminate, a method for producing an antenna-in-package, a laminate, and a composition according to the embodiment of the present invention will be described in detail based on the suitable embodiments shown in the accompanying drawings.

It should be noted that the drawings described below are only exemplary for illustrating the present invention, and the present invention is not limited to the drawings shown below.

In the following, the term "to" indicating a numerical range includes numerical values described on both sides of the "to". For example, in a case where $\varepsilon$ is a numerical value $\alpha$ to a numerical value $\beta$, the range of $\varepsilon$ is a range including the numerical value $\alpha$ and the numerical value $\beta$, which is $\alpha \leq \varepsilon \leq \beta$ in mathematical symbols.

Unless otherwise specified, angles such as "parallel" and "orthogonal" include an error range generally accepted in the relevant technical field.

In addition, the width of the magnetic pattern portion is preferably within a range of $\pm$ 10% with respect to a value of the width determined as will be described later.

[Laminate]

Fig. 1 is a schematic perspective view showing an example of a laminate according to an embodiment of the present invention.

A laminate 10 includes, for example, an array antenna 14, an A/D circuit 16, a memory 17, and an application specific integrated circuit (ASIC) 18 provided on a substrate 12. The A/D circuit 16, the memory 17, and the ASIC 18 are composed of, for example, various semiconductor elements.

The laminate 10 includes, in addition to the above-mentioned configuration, various circuits, elements, and the like that a mobile communication terminal such as a smartphone or a wireless communication module has, for example, a radio frequency (RF) circuit, a power amplifier for transmission, a low noise amplifier for reception, an integrated passive element, a switch, and a phase shifter.

The substrate 12 functions as a support for the laminate 10, and the A/D circuit 16, the memory 17, the ASIC 18, and the like described above are formed thereon. The substrate 12 is composed of polyimide, $SiO_2$, or the like.

The array antenna 14 has, for example, four antennas 15. For example, the four antennas 15 are all the same. The configurations of the array antenna 14 and the antenna 15 are not particularly limited, and are appropriately determined according to a frequency band for transmission or reception, a polarization direction for reception, and the like. In addition, the array antenna 14 has four antennas 15, but the present invention is not limited thereto. A single antenna may be used instead of the array antenna 14.

The A/D circuit 16 converts an analog signal into a digital signal, and a known A-D converter is used. The A/D circuit 16 converts the received signal received by the array antenna 14 by radio waves into a digital signal.

The ASIC 18 obtains the original data or signal transmitted to the array antenna 14 from the received signal

converted into a digital signal. In addition, the ASIC 18 generates transmission data or a transmission signal in a state of a digital signal. The function of the ASIC 18 is not particularly limited, and is appropriately determined according to the intended use and the like.

In addition, the A/D circuit 16 converts the transmission data or the transmission signal generated by the ASIC 18 into an analog signal that can be transmitted by the array antenna 14.

The memory 17 stores the transmission data or the transmission signal generated in the ASIC 18, the digitalized received signal received by the array antenna 14, and the like. For the memory 17, for example, a volatile memory such as a dynamic random access memory (DRAM) is used, but a high bandwidth memory (HBM) is preferable.

In the laminate 10, a magnetic pattern portion 20 is disposed on at least a part of the periphery of the array antenna 14 while being spaced from the array antenna 14 on the substrate 12. The magnetic pattern portion 20 absorbs electromagnetic waves transmitted from or received by the array antenna 14.

The magnetic pattern portion 20 of Fig. 1 is provided on a surface 12a of the substrate 12, covering the A/D circuit 16, the memory 17, and the ASIC 18 except for the array antenna 14.

The width of the magnetic pattern portion 20 is preferably an integral multiple of 1/4 of the wavelength of the electromagnetic wave transmitted from or received by the array antenna 14, in order to absorb the electromagnetic wave transmitted from or received by the array antenna 14.

The magnetic pattern portion 20 suppresses electromagnetic interference of the A/D circuit 16, the memory 17, and the ASIC 18 due to electromagnetic waves emitted by the array antenna 14. As a result, normal operation of the A/D circuit 16, memory 17, and ASIC 18 is not hindered, and therefore a malfunction is also suppressed.

It is possible to strengthen the directivity of an antenna output by controlling the absorption of electromagnetic waves by the magnetic pattern portion 20, and further, it is also possible to achieve high integration and high performance of the laminate by inserting a magnetic body as a structure inside the laminate of a wafer level package.

[Method for producing laminate]

The method for producing a laminate has a step of applying a composition containing magnetic particles and a polymerizable compound onto a substrate on which an antenna is disposed to form a composition layer, and a step of subjecting the composition layer to an exposure treatment and a development treatment to form a magnetic pattern portion.

Fig. 2 and Fig. 3 are schematic perspective views showing a method for producing an example of the laminate according to the embodiment of the present invention in the order of steps. In Fig. 2 and Fig. 3, the same components as those shown in Fig. 1 are denoted by the same reference numerals, and detailed description thereof will be omitted.

As shown in Fig. 2, a substrate 12 provided with, for example, an array antenna 14, an A/D circuit 16, a memory 17, and an ASIC 18 is prepared.

The array antenna 14, the A/D circuit 16, the memory 17, and the ASIC 18 are formed on the substrate 12 using various well-known production methods for semiconductor elements.

Next, as shown in Fig. 2, a composition layer 22 that covers an entire surface 12a of the substrate 12 is formed. The array antenna 14, the A/D circuit 16, the memory 17, and the ASIC 18 are covered with the composition layer 22. For example, the composition layer 22 is of a negative type, and a non-exposed portion is removed by a development treatment.

Next, a photo mask 24 shown in Fig. 3 is disposed. The photo mask 24 is provided with mask portions 25 in, for example, a region where the array antenna 14 is disposed and a region corresponding to the magnetic pattern portion 20. A region 26 other than the mask portion 25 transmits the exposure light Lv to which the composition layer 22 is exposed. The mask portion 25 blocks the exposure light Lv.

The composition layer 22 exposed to light using the photo mask 24 shown in Fig. 3 is of a negative type, and a non-exposed portion is removed by a development treatment. That is, the array antenna 14 and the magnetic pattern portion 20 are non-exposed portions.

In a case where the composition layer 22 is of a positive type, an exposed portion is removed by a development treatment. Therefore, the photo mask 24 has a light shielding region opposite to that of the photo mask 24 shown in Fig. 3.

The photo mask 24 is disposed on the substrate 12 and exposure to light is carried out, which is followed by a development treatment to form the magnetic pattern portion 20 (see Fig. 1). As a result, the laminate 10 shown in Fig. 1 is obtained.

As described above, the magnetic pattern portion 20 (see Fig. 1) can be formed by the exposure treatment and the development treatment, which makes it possible to easily produce a laminate having high integration and high performance.

Conventionally, there has been used a non-photosensitive material which is a magnetic body that maximizes $\mu''$, which represents electromagnetic wave absorption, out of a real part ($\mu'$) of magnetic permeability of the magnetic body and a complex part ($\mu''$) of magnetic permeability of the magnetic body, and which absorbs an electromagnetic

wave of 28 GHz, 47 GHz, or 78 GHz used in the 5G (Generation) communication standards. However, in addition to this characteristic, in a case where patterning is carried out so that the size of the magnetic body is set to an integral multiple of 1/4 of the wavelength of the electromagnetic wave transmitted from or received by the antenna, it is possible to absorb electromagnetic waves due to resonance, which saves space and greatly improves shielding efficiency.

[Magnetic pattern portion]

In a case where the magnetic pattern portion is disposed on at least a part of the periphery of the antenna while being spaced from the antenna on the substrate 12, the magnetic pattern portion 20 provided on the surface 12a of the substrate 12 to cover the A/D circuit 16, the memory 17, and the ASIC 18, except for the array antenna 14, shown in Fig. 1, is not particularly limited. The magnetic pattern portion that can be used is one having various patterns, and may be in the form of a frequency selective surface (FSS) element. The FSS element shape is composed of a combination of a line and a space, in which each of the line and the space has a width of an integral multiple of a magnitude of 1/4 of a wavelength of an electromagnetic wave transmitted from or received by the antenna.
The magnetic pattern portion 20 being disposed spaced apart from the antenna on the substrate 12 means a form in which the antenna and the magnetic pattern portion 20 are provided on the same surface of the substrate, and does not mean a form in which the antenna is provided on the front surface of the substrate and the magnetic pattern portion is provided on the back surface of the substrate. A case where the substrate has a step, a case where the substrate is bent, or a case where another layer such as an adhesion layer is included between the substrate and the magnetic pattern portion is also regarded as the same surface.
The magnetic pattern portion is disposed on at least a part of the periphery of the antenna, and is preferably disposed at 120° or more out of 360° in a horizontal direction around the antenna.
It is preferable that the magnetic pattern portion exists on the entire periphery of the antenna in order to shield electromagnetic waves from the antenna. The entire periphery of the antenna means that it is 337.5° or more out of 360° in a horizontal direction around the antenna.
Hereinafter, the magnetic pattern portion 20 will be described in more detail. Fig. 4 to Fig. 30 are schematic views showing first to twenty-seventh examples of the magnetic pattern portion of the laminate according to the embodiment of the present invention. In Fig. 4 to Fig. 30, it is configured such that a magnetic pattern portion is disposed between one antenna 27 and one semiconductor element 28 on the substrate 12.
In Fig. 4, a single annular magnetic pattern portion 30 that surrounds the entire periphery of an antenna 27 is provided. The magnetic pattern portion 30 is disposed around the entire periphery of the antenna 27 and is disposed in an annular shape. A width of the magnetic pattern portion 30 is, for example, 1/4 of the wavelength of the electromagnetic wave transmitted from or received by the antenna 27. Therefore, the width of the magnetic pattern portion 30 is appropriately set depending on the wavelength of the electromagnetic wave transmitted from or received by the antenna 27. In a case where a frequency of the electromagnetic wave transmitted from or received by the antenna 27 is, for example, 60 GHz, the wavelength of the electromagnetic wave is about 5.00 mm, and the width of the magnetic pattern portion 30 is about 1.25 mm. The width of the magnetic pattern portion 30 may be an integral multiple of 2 or more of 1/4 of the wavelength of the electromagnetic wave transmitted from or received by the antenna 27 and is allowed to be about ± 10% with respect to a value of a predetermined width.
In Fig. 5, a double annular magnetic pattern portion 32 that surrounds the entire periphery of the antenna 27 is provided. The magnetic pattern portion 32 is disposed around the entire periphery of the antenna 27 and is disposed in a double annular shape. The magnetic pattern portion 32 has an annular first pattern portion 32a and an annular second pattern portion 32b that encloses the entire periphery of the first pattern portion 32a. The first pattern portion 32a and the second pattern portion 32b are disposed in a concentric pattern. The first pattern portion 32a and the second pattern portion 32b have the same width, which is, for example, 1/4 of the wavelength of the electromagnetic wave transmitted from or received by the antenna 27. In this case, for example, in a case where the frequency of the transmitted or received electromagnetic wave is 60 GHz, the width of the first pattern portion 32a and the width of the second pattern portion 32b are about 1.25 mm. In addition, the interval between the first pattern portion 32a and the second pattern portion 32b is also, for example, an integral multiple of 1/4 of the wavelength of the electromagnetic wave transmitted from or received by the antenna 27. The above-mentioned width and interval may be an integral multiple of 2 or more of 1/4 of the wavelength of the electromagnetic wave transmitted from or received by the antenna 27 and are allowed to be about ± 10% with respect to a value of a predetermined width.
In Fig. 6, a triple annular magnetic pattern portion 34 that surrounds the entire periphery of the antenna 27 is provided. The magnetic pattern portion 34 is disposed around the entire periphery of the antenna 27 and is disposed in a triple annular shape. The magnetic pattern portion 34 has an annular first pattern portion 34a, an annular second pattern portion 34b that encloses the entire periphery of the first pattern portion 34a, and an annular third pattern portion 34c that encloses the entire periphery of the second pattern portion 34b. The first pattern portion 34a, the second pattern portion 34b, and the third pattern portion 34c have the same width and are disposed in a concentric pattern. The width

of the first pattern portion 32a, the width of the second pattern portion 32b, and the width of the third pattern portion 34c are, for example, 1/4 of the wavelength of the electromagnetic wave transmitted from or received by the antenna 27. In this case, for example, in a case where the frequency of the transmitted or received electromagnetic wave is 60 GHz, the width of the first pattern portion 32a, the width of the second pattern portion 32b, and the width of the third pattern portion 34c are about 1.25 mm. In addition, the interval among the first pattern portion 32a, the second pattern portion 32b, and the third pattern portion 34c is also, for example, 1/4 of the wavelength of the electromagnetic wave transmitted from or received by the antenna 27.

In Fig. 7, a quadruple annular magnetic pattern portion 36 that surrounds the entire periphery of the antenna 27 is provided. The magnetic pattern portion 36 is disposed around the entire periphery of the antenna 27 and is disposed in a quadruple annular shape. The magnetic pattern portion 36 has an annular first pattern portion 36a, an annular second pattern portion 36b that encloses the entire periphery of the first pattern portion 36a, an annular third pattern portion 36c that encloses the entire periphery of the second pattern portion 36b, and an annular fourth pattern portion 36d that encloses the entire periphery of the third pattern portion 36c. The first pattern portion 36a, the second pattern portion 36b, the third pattern portion 36c, and the fourth pattern portion 36d have the same width and are disposed in a concentric pattern. The width of the first pattern portion 36a, the width of the second pattern portion 36b, the width of the third pattern portion 36c, and the width of the fourth pattern portion 36d are, for example, 1/4 of the wavelength of the electromagnetic wave transmitted from or received by the antenna 27. In this case, for example, in a case where the frequency of the transmitted or received electromagnetic wave is 60 GHz, the width of the first pattern portion 32a, the width of the second pattern portion 32b, the width of the third pattern portion 34c, and the width of the fourth pattern portion 36d are about 1.25 mm. The interval among the first pattern portion 32a, the second pattern portion 32b, the third pattern portion 34c, and the fourth pattern portion 36d is also, for example, 1/4 of the wavelength of the electromagnetic wave transmitted from or received by the antenna 27. The width of the above-mentioned pattern portions and the interval between the above-mentioned pattern portions in Fig. 5 to Fig. 7 may be an integral multiple of 2 or more of 1/4 of the wavelength of the electromagnetic wave transmitted from or received by the antenna 27.

Fig. 4 to Fig. 7 are all annular magnetic pattern portions that surround the entire periphery of the antenna, and the quadruple annular magnetic pattern portion shown in Fig. 7 is preferable from the viewpoint of an ability to shield electromagnetic waves.

In Fig. 8 to Fig. 12 referred to below, both the width of each pattern portion and the interval between the pattern portions are, for example, 1/4 of the wavelength of the electromagnetic wave transmitted from or received by the antenna 27, as described above. For example, in a case where the frequency of the transmitted or received electromagnetic wave is 60 GHz, the width of each of the above-mentioned pattern portions and the interval between the above-mentioned pattern portions are about 1.25 mm. In Fig. 8 to Fig. 12 referred to below, the width of each pattern portion and the interval between the pattern portions may be an integral multiple of 2 or more of 1/4 of the wavelength of the electromagnetic wave transmitted from or received by the antenna 27 and are allowed to be about ± 10% with respect to a value of a predetermined width.

In Fig. 8, a magnetic pattern portion 38 that surrounds the entire periphery of the antenna 27 is provided. The magnetic pattern portion 38 is disposed around the entire periphery of the antenna 27, has a triple triangular pattern, and has a triangular first pattern portion 38a, a triangular second pattern portion 38b that encloses the entire periphery of the first pattern portion 38a, and a triangular third pattern portion 38c that encloses the entire periphery of the second pattern portion 38b. The first pattern portion 38a, the second pattern portion 38b, and the third pattern portion 38c have the same width and similar shapes. The first pattern portion 38a, the second pattern portion 38b, and the third pattern portion 38c are disposed with centroids thereof aligned.

In Fig. 9, a magnetic pattern portion 40 that surrounds the entire periphery of the antenna 27 is provided. The magnetic pattern portion 40 is disposed around the entire periphery of the antenna 27, has a triple quadrangular pattern, and has a quadrangular first pattern portion 40a, a quadrangular second pattern portion 40b that encloses the entire periphery of the first pattern portion 40a, and a quadrangular third pattern portion 40c that encloses the entire periphery of the second pattern portion 40b. The first pattern portion 40a, the second pattern portion 40b, and the third pattern portion 40c have similar shapes and are disposed with centroids thereof aligned. The centroid is a point where two diagonal lines intersect.

In Fig. 10, a magnetic pattern portion 42 that surrounds the entire periphery of the antenna 27 is provided. The magnetic pattern portion 42 is disposed around the entire periphery of the antenna 27, has a triple hexagonal pattern, and has a hexagonal first pattern portion 42a, a hexagonal second pattern portion 42b that encloses the entire periphery of the first pattern portion 42a, and a hexagonal third pattern portion 42c that encloses the entire periphery of the second pattern portion 42b. The first pattern portion 42a, the second pattern portion 42b, and the third pattern portion 42c have the same width and similar shapes. The first pattern portion 42a, the second pattern portion 42b, and the third pattern portion 42c are disposed with centroids thereof aligned.

In Fig. 11, a magnetic pattern portion 44 that surrounds the entire periphery of the antenna 27 is provided. The magnetic pattern portion 44 is disposed around the entire periphery of the antenna 27, has a triple octagonal pattern,

and has an octagonal first pattern portion 44a, an octagonal second pattern portion 44b that encloses the entire periphery of the first pattern portion 44a, and an octagonal third pattern portion 44c that encloses the entire periphery of the second pattern portion 44b. The first pattern portion 44a, the second pattern portion 44b, and the third pattern portion 44c have the same width and similar shapes. The first pattern portion 44a, the second pattern portion 44b, and the third pattern portion 44c are disposed with centroids thereof aligned.

In Fig. 12, a magnetic pattern portion 46 that surrounds the entire periphery of the antenna 27 is provided. The magnetic pattern portion 46 is disposed around the entire periphery of the antenna 27, has a triple decagonal pattern, and has a decagonal first pattern portion 46a, a decagonal second pattern portion 46b that encloses the entire periphery of the first pattern portion 46a, and a decagonal third pattern portion 46c that encloses the entire periphery of the second pattern portion 46b. The first pattern portion 46a, the second pattern portion 46b, and the third pattern portion 46c have the same width and similar shapes. The first pattern portion 46a, the second pattern portion 46b, and the third pattern portion 46c are disposed with centroids thereof aligned.

Fig. 8 to Fig. 12 described above all have triple polygonal magnetic pattern portions. The polygonal outer shapes shown in Fig. 8 to Fig. 10 are triangular, quadrangular, and hexagonal, which suppress the concentration of reflected electromagnetic waves, and have a higher ability to shield electromagnetic waves than the triple annular magnetic pattern portion shown in Fig. 6. On the other hand, Fig. 10 has an octagonal outer shape and Fig. 11 has a decagonal outer shape, in which the outer shape is close to a circle, thus providing about the same level of ability to shield electromagnetic waves as that of the triple annular magnetic pattern portion shown in Fig. 6.

In Fig. 13, a magnetic pattern portion 48 that surrounds the entire periphery of the antenna 27 is provided. The magnetic pattern portion 48 is provided around the entire periphery of the antenna 27 and has a linear first pattern portion 48a, a linear second pattern portion 48b, and a linear third pattern portion 48c, which are disposed parallel to each other. In addition, the first pattern portion 48a, the second pattern portion 48b, and the third pattern portion 48c are disposed to face each other with the antenna 27 interposed therebetween.

At both ends of the first pattern portion 48a, the second pattern portion 48b, and the third pattern portion 48c, there is disposed a linear fourth pattern portion 48d extending in a direction orthogonal to the first pattern portion 48a, the second pattern portion 48b, and the third pattern portion 48c, respectively. A linear fifth pattern portion 48e and a linear sixth pattern portion 48f are disposed in parallel with each other with a gap from the fourth pattern portion 48d. None of the first pattern portion 48a to the sixth pattern portion 48f is connected to other pattern portions. In addition, the first pattern portion 48a to the sixth pattern portion 48f have the same width. The magnetic pattern portion 48 is a pattern in which three lines and spaces are combined.

For example, in a case where two or more parallel rods are connected like a tuning fork, energy is transmitted and resonates, but since none of the first pattern portion 48a to the sixth pattern portion 48f is connected to other pattern portions, resonance is suppressed and a high ability to shield electromagnetic waves is obtained.

The width of the first pattern portion 48a to the sixth pattern portion 48f is, for example, 1/4 of the wavelength of the electromagnetic wave transmitted from or received by the antenna 27. In this case, for example, in a case where the frequency of the transmitted or received electromagnetic wave is 60 GHz, the width of the first pattern portion 48a to the sixth pattern portion 48f is about 1.25 mm. In addition, the interval among the first pattern portion 48a to the sixth pattern portion 48f is also, for example, 1/4 of the wavelength of the electromagnetic wave transmitted from or received by the antenna 27. The above-mentioned width and interval may be an integral multiple of 2 or more of 1/4 of the wavelength of the electromagnetic wave transmitted from or received by the antenna 27 and are allowed to be about ± 10% with respect to a value of a predetermined width.

In Fig. 14, a magnetic pattern portion 50 is provided between the antenna 27 and the semiconductor element 28 on the substrate 12. The magnetic pattern portion 50 is provided on one side of the antenna 27. In the magnetic pattern portion 50, a linear first pattern portion 50a, a linear second pattern portion 50b, and a linear third pattern portion 50c are disposed in parallel with each other at intervals. The first pattern portion 50a, the second pattern portion 50b, and the third pattern portion 50c have the same width, and the interval therebetween is the same as the width.

The width of the first pattern portion 50a, the width of the second pattern portion 50b, and the width of the third pattern portion 50c are, for example, 1/4 of the wavelength of the electromagnetic wave transmitted from or received by the antenna 27. For example, the frequency of the transmitted or received electromagnetic wave is 60 GHz, the width of the first pattern portion 50a, the width of the second pattern portion 50b, and the width of the third pattern portion 50c are about 1.25 mm. The interval between the pattern portions is also, for example, 1/4 of the wavelength of the electromagnetic wave transmitted from or received by the antenna 27. The above-mentioned width and interval may be an integral multiple of 2 or more of 1/4 of the wavelength of the electromagnetic wave transmitted from or received by the antenna 27.

The magnetic pattern portion 50 of Fig. 15 has the same configuration as that of Fig. 14, except that the interval among the first pattern portion 50a, the second pattern portion 50b, and the third pattern portion 50c is different from that of the magnetic pattern portion 50 of Fig. 14. The interval among the first pattern portion 50a, the second pattern portion 50b, and the third pattern portion 50c is two times the width of the first pattern portion 50a, the width of the second

pattern portion 50b, and the width of the third pattern portion 50c. The interval is, for example, two times 1/4 of the wavelength of the electromagnetic wave transmitted from or received by the antenna 27.

The magnetic pattern portion 50 of Fig. 16 has the same configuration as that of Fig. 14, except that the interval among the first pattern portion 50a, the second pattern portion 50b, and the third pattern portion 50c is different from that of the magnetic pattern portion 50 of Fig. 14. The interval among the first pattern portion 50a, the second pattern portion 50b, and the third pattern portion 50c is three times the width of the first pattern portion 50a, the width of the second pattern portion 50b, and the width of the third pattern portion 50c. The interval is, for example, three times 1/4 of the wavelength of the electromagnetic wave transmitted from or received by the antenna 27.

The magnetic pattern portion 50 of Fig. 17 has the same configuration as that of Fig. 14, except that the interval among the first pattern portion 50a, the second pattern portion 50b, and the third pattern portion 50c is different from that of the magnetic pattern portion 50 of Fig. 14. The interval among the first pattern portion 50a, the second pattern portion 50b, and the third pattern portion 50c is four times the width of the first pattern portion 50a, the width of the second pattern portion 50b, and the width of the third pattern portion 50c. The interval is, for example, four times 1/4 of the wavelength of the electromagnetic wave transmitted from or received by the antenna 27.

Fig. 14 to Fig. 17 are so-called line-and-space patterns.

As for the relationship between the interval among the first pattern portion 50a, the second pattern portion 50b, and the third pattern portion 50c and the width of the first pattern portion 50a, the second pattern portion 50b, and the third pattern portion 50c, the interval may be five times, six times, or seven times the width. The interval may be, for example, five times, six times, or seven times 1/4 of the wavelength of the electromagnetic wave transmitted from or received by the antenna 27.

In a case where the width of the magnetic pattern portion is defined as L and the interval of the magnetic pattern portion is defined as S, the width and the interval of the magnetic pattern portion are represented by L/S. In a case where L/S=1, the width and interval of the magnetic pattern portion are the same, which is the configuration shown in Fig. 14. In a case where L/S = 2, the interval of the magnetic pattern portion is two times the width of the magnetic pattern portion, which is the configuration shown in Fig. 15.

An increase in L/S ratio leads to an increase in ability to shield electromagnetic waves in calculation, but an increase in L/S ratio results in an increased region where the magnetic pattern is disposed. Therefore, the upper limit of the L/S ratio is appropriately determined depending on the size of the region where the magnetic pattern is disposed, and the upper limit of the L/S ratio is about 10.

Also in Fig. 14 to Fig. 17, as well as in Fig. 18 to Fig. 21, Fig. 23 to Fig. 27, Fig. 29, and Fig. 30 which will be described later, the width and the interval of each pattern portion are allowed to be about ± 10% with respect to a value of a predetermined width.

In Fig. 18, a magnetic pattern portion 52 that surrounds the periphery of the antenna 27 is provided. The magnetic pattern portion 52 has, for example, four annular pattern portions 53 which are partially notched.

The width of a notched portion 53a of the pattern portion 53 is, for example, 1/4 of the wavelength of the electromagnetic wave transmitted from or received by the antenna 27. In this case, for example, in a case where the frequency of the transmitted or received electromagnetic wave is 60 GHz, the width of the notched portion 53a is about 1.25 mm. The pattern portions 53 are disposed around the antenna 27 at intervals of 90° with the notched portions 53a facing the antenna 27. The pattern portions 53 are disposed on a virtual square 53b. The distance between the centers of the opposing pattern portions 53 is, for example, 14 mm. The width of the notched portion 53a may be an integral multiple of 2 or more of 1/4 of the wavelength of the electromagnetic wave transmitted from or received by the antenna 27.

Since the reflection of electromagnetic waves is canceled by the notched portion 53a, an ability to shield electromagnetic waves is increased as compared with the configuration of the annular pattern portion having no notched portion.

A magnetic pattern portion 54 of Fig. 19 differs in the number of pattern portions 53 from that in Fig. 18, and has eight pattern portions 53, for example. In the magnetic pattern portion 54 of Fig. 19, the pattern portions 53 are disposed at the corners of the four pattern portions 53 of the magnetic pattern portion 52 of Fig. 18. The entire periphery of the antenna 27 is surrounded by the pattern portions 53. The pattern portions 53 provided at the corners of the four pattern portions 53 of the magnetic pattern portion 52 in Fig. 18 are disposed such that the notched portions 53a are in contact with the other pattern portions 53. The magnetic pattern portion 54 shown in Fig. 19 has a higher shielding effect of electromagnetic waves than the magnetic pattern portion 52 shown in Fig. 18, and is more preferable.

In Fig. 20, a magnetic pattern portion 56 is provided between the antenna 27 and the semiconductor element 28 on the substrate 12. In the magnetic pattern portion 56, pattern portions 53 are disposed in a row on a line CL, for example, and notched portions 53a are directed toward the antenna 27 side. In addition, the antenna 27 and the line CL on which the pattern portions 53 are disposed are separated by a distance Lc.

A magnetic pattern portion 58 of Fig. 21 has the same configuration as the magnetic pattern portion 56 shown in Fig. 20, except that the configuration of a pattern portion 58a is different from that of the magnetic pattern portion 56. The pattern portion 58a has an annular shape and is not provided with the notched portion 53a.

A magnetic pattern portion 60 of Fig. 22 has the same configuration as the magnetic pattern portion 56 shown in Fig. 20, except that the configuration of a pattern portion 60a is different from that of the magnetic pattern portion 56. The pattern portion 60a has a disk shape and is not provided with the notched portion 53a.

A magnetic pattern portion 37 of Fig. 23 has the same configuration as the magnetic pattern portion 36 of Fig. 6, except that the configurations of a first pattern portion 37a, a second pattern portion 37b, and a third pattern portion 37c are different from those of the magnetic pattern portion 36 of Fig. 6. A notched portion 37d is provided in each of the first pattern portion 37a, the second pattern portion 37b, and the third pattern portion 37c. The first pattern portion 37a, the second pattern portion 37b, and the third pattern portion 37c are disposed in a concentric pattern with the notched portions 37d aligned. The notched portion 37d is disposed facing the opposite side of the semiconductor element 28. The notched portion 37d has the same configuration as the notched portion 53a described above.

In addition, the magnetic pattern portion 37 of Fig. 23 has the first pattern portion 37a, the second pattern portion 37b, and the third pattern portion 37c, but the present invention is not limited thereto, and the magnetic pattern portion 37 may have only the first pattern portion 37a.

A magnetic pattern portion 62 of Fig. 24 has a pattern using a fractal and has an FSS element-like configuration.

The magnetic pattern portion 62 has, for example, four H-shaped pattern portions 62a which are disposed in the same direction, and has a pattern portion 62b connecting the vertically disposed pattern portions 62a and a pattern portion 62c connecting the pattern portions 62b. The pattern portion 62a is composed of sub-pattern portions 62d to 62f. A configuration pattern portion 62g is formed by the pattern portion 62a, the pattern portion 62b, and the pattern portion 62c. The magnetic pattern portion 62 has two configuration pattern portions 62g. The magnetic pattern portion 62 has a fractal structure, which leads to an increase in the number of combinations in which the pattern portion is repeated three times, resulting in an increased ability to shield electromagnetic waves.

The width of each of the pattern portion 62a, the pattern portion 62b, the pattern portion 62c, and the sub-pattern portion 62d is, for example, an integral multiple of 1/4 of the wavelength of the electromagnetic wave transmitted from or received by the antenna 27. In addition, the interval between the pattern portions in the extending direction of the pattern portion 62c is, for example, an integral multiple of 1/4 of the wavelength of the electromagnetic wave transmitted from or received by the antenna 27.

For example, the width of the sub-pattern portion 62f of the pattern portion 62a extending in the direction from the antenna 27 toward the semiconductor element 28 is six times 1/4 of the wavelength, the width of the sub-pattern portion 62e extending in a direction orthogonal to the above-mentioned direction is five times 1/4 of the wavelength, and the width of the sub-pattern portion 62e is three times 1/4 of the wavelength. The width of the pattern portion 62b is ten times 1/4 of the wavelength, and the width of the pattern portion 62c is eleven times 1/4 of the wavelength.

A magnetic pattern portion 64 of Fig. 25 has a pattern using a space-filling curve and has an FSS element-like configuration. For example, the magnetic pattern portion 64 is a pattern having a recursive structure using a Hilbert curve.

The width of the magnetic pattern portion 64 is, for example, an integral multiple of 1/4 of the wavelength of the electromagnetic wave transmitted from or received by the antenna 27. In addition, the interval between the magnetic pattern portions 64 in the direction from the antenna 27 toward the semiconductor element 28, that is, the space between the magnetic pattern portions 64 is, for example, an integral multiple of 1/4 of the wavelength of the electromagnetic wave transmitted from or received by the antenna 27.

In the magnetic pattern portion 64, for example, a length Lt is three times 1/4 of the wavelength and a length Lw is three times 1/4 of the wavelength.

A magnetic pattern portion 66 of Fig. 26 has a spiral pattern portion 66a and a pattern portion 66b that connects the spiral pattern portions 66a to each other. For example, six spiral pattern portions 66a are disposed three in one row, for a total of two rows. The spiral pattern portion 66a and the pattern portion 66b have, for example, the same width, and the width thereof is, for example, an integral multiple of 1/4 of the wavelength of the electromagnetic wave transmitted from or received by the antenna 27. The magnetic pattern portion 66 has an FSS element-like configuration. In addition, the interval between the magnetic pattern portions 66 in the direction from the antenna 27 toward the semiconductor element 28, that is, the space between the magnetic pattern portions 66 is, for example, an integral multiple of 1/4 of the wavelength of the electromagnetic wave transmitted from or received by the antenna 27.

In the magnetic pattern portion 66, for example, a length Lt is three times 1/4 of the wavelength and a length Lw is three times 1/4 of the wavelength.

A magnetic pattern portion 68 of Fig. 27 has a pattern using a fractal. The magnetic pattern portion 68 has a pattern portion 68a and a pattern portion 68b that connects the pattern portions 68a disposed spaced apart from each other.

The pattern portions 68a are disposed with their directions changed, and the pattern portions 68a disposed facing each other are connected. The pattern portions 68a spaced apart from each other are connected by the pattern portion 68b as described above. The magnetic pattern portion 68 has an FSS element-like configuration. The pattern portion 68a and the pattern portion 68b have, for example, the same width, and the width thereof is an integral multiple of 1/4 of the wavelength of the electromagnetic wave transmitted from or received by the antenna 27. In addition, the

interval between the magnetic pattern portions 68 in the direction from the antenna 27 toward the semiconductor element 28, that is, the space between the magnetic pattern portions 68 is, for example, an integral multiple of 1/4 of the wavelength of the electromagnetic wave transmitted from or received by the antenna 27.

In the magnetic pattern portion 68, for example, a length Lt is three times 1/4 of the wavelength and a length Lw is three times 1/4 of the wavelength.

A magnetic pattern portion 69 of Fig. 28 is a pattern having an opening portion 69a in a portion of the antenna 27.

A magnetic pattern portion 70 of Fig. 29 has a plurality of hexagonal pattern portions 70a. The magnetic pattern portion 70 is a honeycomb-shaped pattern. Each pattern portion 70a has a hexagonal opening portion 70b. For example, the hexagonal pattern portions 70a are disposed on the surface 12a of the substrate 12 in a two-dimensional close-packed manner. The width of the hexagonal pattern portion 70a is an integral multiple of 1/4 of the wavelength of the electromagnetic wave transmitted from or received by the antenna 27.

The magnetic pattern portion 70 has, for example, a length Ld that is three times 1/4 of the wavelength.

In Fig. 29, the hexagonal pattern portion 70a is used as the pattern portion, but the present invention is not limited thereto. The pattern portion may be a regular pattern portion, a rectangular pattern portion, a triangular pattern portion, or a pattern portion, such as a Voronoi pattern, in which opening regions having an irregular shape are irregularly defined.

A magnetic pattern portion 72 of Fig. 30 is, for example, a pattern having a cross-shaped opening portion 72a. The magnetic pattern portion 72 of Fig. 30 also has an FSS element-like configuration.

In the magnetic pattern portion 72, a pattern portion 72b, excluding the opening portion 72a, has a width in the direction from the antenna 27 toward the semiconductor element 28, a length in the above-mentioned direction, and a length in a direction orthogonal to the above-mentioned direction which are each an integral multiple of 1/4 of the wavelength of the electromagnetic wave transmitted from or received by the antenna 27. In addition, the width of the cross-shaped opening portion 72a is also an integral multiple of 1/4 of the wavelength of the electromagnetic wave transmitted from or received by the antenna 27. The width of the cross-shaped opening portion 72a is a length in a direction orthogonal to a direction in which the opening portion 72a extends.

The magnetic pattern portion 72 has, for example, a length Lf that is nine times 1/4 of the wavelength, a length Lg that is nine times 1/4 of the wavelength, and a length Lh that is three times 1/4 of the wavelength.

The shape of the opening portion 72a is not limited to a cross shape as long as the dimensions of each portion are integral multiples of 1/4 of the wavelength of the electromagnetic wave transmitted from or received by the antenna 27 as described above.

In any of the above-mentioned magnetic pattern portions, the thickness of the magnetic pattern portion is not particularly limited as long as it is other than an integral multiple of 1/4 of the wavelength of the electromagnetic wave transmitted from or received by the antenna 27. Meanwhile, the thickness of the magnetic pattern portion is preferably 300 $\mu$m or less from the viewpoint of pattern formation.

In addition, in a case where the thickness of the magnetic pattern portion is 300 $\mu$m or less, it is possible to reduce the height of the laminate.

Although the array antenna 14 is shown in Fig. 1, the antenna is not particularly limited, and examples of the antenna include the following.

[Antenna]

A variety of antennas used in the communication standard fifth generation (5G) using a frequency band of 28 GHz to 80 GHz can be used.

For example, a patch antenna, a dipole antenna, or a phased array antenna can be used as the antenna.

The antenna is composed of, for example, copper or aluminum. In addition, the thickness of the antenna is preferably 20 to 50 $\mu$m. For example, in a case where a printed circuit board such as Flame Retardant Type 1 to Type 5 (FR-1 to FR-5) is used, a thickness of a copper wiring line is determined by standards, and the thickness of the antenna also conforms to the thickness of the copper wiring line. In addition, the thickness of the antenna may conform to the thickness (see Table 6 and the like of the Japanese Industrial Standards (JIS) C 6484: 2005) of copper foil of copper clad laminate specified in JIS C 6484: 2005. Further, in a case where the antenna is formed of copper by electrolytic plating, the thickness of the antenna is preferably a film thickness that can be formed by electrolytic plating.

Examples of the semiconductor element include the following.

[Semiconductor element]

The semiconductor element is not particularly limited, and examples thereof include logic large scale integration (LSI) (for example, an application specific integrated circuit (ASIC), a field programmable gate array (FPGA), and an application specific standard product (ASSP)), microprocessors (for example, a central processing unit (CPU) and a

graphics processing unit (GPU)), memories (for example, a dynamic random access memory (DRAM), a hybrid memory cube (HMC), a magnetic RAM (MRAM), a phase-change memory (PCM), a resistive RAM (ReRAM), a ferroelectric RAM (FeRAM), and a flash memory (such as a Not AND (NAND) flash)), power devices, analog integrated circuits (IC) (for example, a direct current (DC)-direct current (DC) converter and an isolated gate bipolar transistor (IGBT)), A/D converters, micro electro mechanical systems (MEMS) (for example, an acceleration sensor, a pressure sensor, an oscillator, and a gyro sensor), power amplifiers, wireless (for example, a global positioning system (GPS), frequency modulation (FM), near field communication (NFC), an RF expansion module (RFEM), a monolithic microwave integrated circuit (MMIC), and a wireless local area network (WLAN)), discrete elements, back side illumination (BSI), contact image sensors (CIS), camera modules, complementary metal oxide semiconductors (CMOS), passive devices, bandpass filters, surface acoustic wave (SAW) filters, radio frequency (RF) filters, radio frequency integrated passive devices (RFIPD), and broadband (BB).

[Antenna-in-package and method for producing antenna-in-package]

The antenna-in-package has a configuration in which an antenna and a front end module (FEM) are laminated. The FEM is a circuit portion of a transmission/reception end on the antenna side in a wireless circuit.

For example, the antenna-in-package has a configuration in which at least an antenna, an A/D circuit 16, a memory 17, and an ASIC 18 are provided on a substrate, for example, as in the laminate 10 shown in Fig. 1 above. Further, a magnetic pattern portion 20 is provided.

As for the method for producing the antenna-in-package, other than the method for producing the magnetic pattern portion 20, a known method can be appropriately used for the antenna, the A/D circuit 16, the memory 17, the ASIC 18, and the like.

Hereinafter, a composition containing magnetic particles and a polymerizable compound, and a method for producing a laminate will be described.

In the following, first, various components contained in the composition will be described in detail.

[Magnetic particles]

The magnetic particles contain a metal atom.

In the present specification, the metal atom also includes metalloid atoms such as boron, silicon, germanium, arsenic, antimony, and tellurium.

The metal atom may be contained in the magnetic particles as an alloy containing a metal element (preferably, a magnetic alloy), a metal oxide (preferably, a magnetic oxide), a metal nitride (preferably, a magnetic oxide), or a metal carbide (preferably, a magnetic carbide).

The content of the metal atom with respect to the total mass of the magnetic particles is preferably 50% to 100% by mass, more preferably 75% to 100% by mass, and still more preferably 95% to 100% by mass.

The metal atom is not particularly limited, and the magnetic particles preferably contain at least one metal atom selected from the group consisting of Fe, Ni, and Co.

The content of at least one metal atom selected from the group consisting of Fe, Ni, and Co (the total content of a plurality of types of metal atoms in a case where the plurality of types of metal atoms are contained) is preferably 50% by mass or more, more preferably 60% by mass or more, and still more preferably 70% by mass or more with respect to the total mass of the metal atoms in the magnetic particles. The upper limit value of the content of the metal atom is not particularly limited, and is, for example, 100% by mass or less, preferably 98% by mass or less, and more preferably 95% by mass or less.

The magnetic particles may contain a material other than Fe, Ni, and Co, specific examples of which include Al, Si, S, Sc, Ti, V, Cu, Y, Mo, Rh, Pd, Ag, Sn, Sb, Te, Ba, Ta, W, Re, Au, Bi, La, Ce, Pr, Nd, P, Zn, Zr, Mn, Cr, Nb, Pb, Ca, B, C, N, and O.

In a case where the magnetic particles contain a metal atom other than Fe, Ni, and Co, it is preferable that the magnetic particles contain one or more metal atoms selected from the group consisting of Si, Cr, B, and Mo.

Examples of the magnetic particles include alloys such as a Fe-Co-based alloy (preferably, Permendur), a Fe-Ni-based alloy (for example, Permalloy), a Fe-Zr-based alloy, a Fe-Mn-based alloy, a Fe-Si-based alloy, a Fe-Al-based alloy, a Ni-Mo-based alloy (preferably, Supermalloy), a Fe-Ni-Co-based alloy, a Fe-Si-Cr-based alloy, a Fe-Si-B-based alloy, a Fe-Si-Al-based alloy (preferably, Sendust), a Fe-Si-B-C-based alloy, a Fe-Si-B-Cr-based alloy, a Fe-Si-B-Cr-C-based alloy, a Fe-Co-Si-B-based alloy, a Fe-Si-B-Nb-based alloy, a Fe nanocrystalline alloy, a Fe-based amorphous alloy, and a Co-based amorphous alloy, as well as ferrites such as a spinel ferrite (preferably, a Ni-Zn-based ferrite or a Mn-Zn-based ferrite) and a hexagonal ferrite (preferably, a barium ferrite or a magnetoplumbite type hexagonal ferrite). The alloy may be amorphous.

The hexagonal ferrite preferable from the viewpoint of radio wave absorption performance may be, for example, a substituted magnetoplumbite type hexagonal ferrite in which some of iron atoms in hexagonal ferrite are substituted with aluminum atoms. Further, a Ba-Fe-Al-based alloy, a Ca-Fe-Al-based alloy, or a Pb-Fe-Al-based alloy in which a

part of the alloy is substituted with Ba, Ca, or Pb is more preferable from the viewpoint of absorption of radio waves in a high frequency band.

One type of magnetic particle may be used alone, or two or more types of magnetic particles may be used in combination.

A surface layer may be provided on the surface of the magnetic particle. In a case where the magnetic particle has a surface layer in this manner, the magnetic particle can be provided with a function according to the material of the surface layer.

The surface layer may be, for example, an inorganic layer or an organic layer.

The thickness of the surface layer is not particularly limited, and is preferably 3 to 1,000 nm from the viewpoint that the function of the surface layer is more exhibited.

The average primary particle diameter of the magnetic particles is preferably 20 to 1,000 nm. The average primary particle diameter of the magnetic particles is more preferably 20 to 500 nm from the viewpoint of dispersion in a composition and pattern resolution.

The particle diameter of the primary particle of the magnetic particle is measured in such a manner that the magnetic particle is imaged with a transmission electron microscope at an imaging magnification of 100,000x, the magnetic particle image is printed on a printing paper at a total magnification of 500,000x, and in the obtained particle image, the contour of the particle (primary particle) is traced with a digitizer and then the diameter of a circle having the same area as the traced region (circular area phase diameter) is calculated. Here, the primary particle refers to an independent particle without aggregation. Imaging using a transmission electron microscope shall be carried out by a direct method using a transmission electron microscope at an acceleration voltage of 300 kV. The observation and measurement with the transmission electron microscope can be carried out using, for example, a transmission electron microscope H-9000 (manufactured by Hitachi Ltd.) and an image analysis software KS-400 (manufactured by Carl Zeiss AG). The average primary particle diameter is calculated by arithmetically averaging the particle diameters of at least 100 primary particles of the magnetic particles measured above.

The shape of the magnetic particle is not particularly limited, and may be any of a plate shape, an elliptical shape, a spherical shape, and an amorphous shape.

The content of the magnetic particles is preferably 20% to 99% by mass, more preferably 25% to 80% by mass, and still more preferably 30% to 60% by mass with respect to the total mass of the composition.

The content of the magnetic particles is preferably 30% to 99% by mass, more preferably 30% to 80% by mass, and still more preferably 40% to 70% by mass with respect to the total solid content of the composition.

The total solid content of the composition means a component constituting the magnetic pattern portion excluding the solvent in the composition. As long as such a component is a component constituting the magnetic pattern portion, it is regarded as a solid content even in a case where the property thereof is liquid.

[Polymerizable compound]

The polymerizable compound is a compound having a polymerizable group (photopolymerizable compound), and examples thereof include a compound containing a group containing an ethylenically unsaturated bond (hereinafter, also simply referred to as an "ethylenically unsaturated group"), and a compound having an epoxy group and/or an oxetanyl group, among which a compound containing an ethylenically unsaturated group is preferable.

The composition preferably contains a low-molecular-weight compound containing an ethylenically unsaturated group as the polymerizable compound.

The polymerizable compound is preferably a compound containing one or more ethylenically unsaturated bonds, more preferably a compound containing two or more ethylenically unsaturated bonds, still more preferably a compound containing three or more ethylenically unsaturated bonds, and particularly preferably a compound containing five or more ethylenically unsaturated bonds. The upper limit of the number of ethylenically unsaturated bonds is, for example, 15 or less. Examples of the ethylenically unsaturated group include a vinyl group, a (meth)allyl group, and a (meth)acryloyl group.

For example, the compounds described in paragraph [0050] of JP2008-260927A, the entire contents of which are incorporated herein by reference, and the compounds described in paragraph [0040] of JP2015-068893A, the entire contents of which are incorporated herein by reference, can be used as the polymerizable compound.

The polymerizable compound may be in any chemical form such as a monomer, a prepolymer, an oligomer, a mixture thereof, and a multimer thereof.

The polymerizable compound is preferably a (meth)acrylate compound having 3 to 15 functionalities, and more preferably a (meth)acrylate compound having 3 to 6 functionalities.

The polymerizable compound is also preferably a compound containing one or more ethylenically unsaturated groups and having a boiling point of 100°C or higher under normal pressure. For example, reference can be made to the compounds described in paragraph [0227] of JP2013-029760A, the entire contents of which are incorporated herein

by reference, and the compounds described in paragraphs [0254] to [0257] of JP2008-292970A, the entire contents of which are incorporated herein by reference.

The polymerizable compound is preferably dipentaerythritol triacrylate (commercially available as KAYARAD D-330, manufactured by Nippon Kayaku Co., Ltd.), dipentaerythritol tetraacrylate (commercially available as KAYARAD D-320, manufactured by Nippon Kayaku Co., Ltd.), dipentaerythritol penta(meth)acrylate (commercially available as KAYARAD D-310, manufactured by Nippon Kayaku Co., Ltd.), dipentaerythritol hexa(meth)acrylate (commercially available as KAYARAD DPHA, manufactured by Nippon Kayaku Co., Ltd., and A-DPH-12E, manufactured by Shin-Nakamura Chemical Co., Ltd.), or a structure in which the (meth)acryloyl group thereof is through an ethylene glycol residue or a propylene glycol residue (for example, SR454 and SR499 commercially available from Sartomer Company). An oligomer type thereof can also be used. In addition, NK ESTER A-TMMT (pentaerythritol tetraacrylate, manufactured by Shin-Nakamura Chemical Co., Ltd.), KAYARAD RP-1040, KAYARAD DPEA-12LT, KAYARAD DPHA LT, KAYARAD RP-3060, and KAYARAD DPEA-12 (all trade names, manufactured by Nippon Kayaku Co., Ltd.), and the like may be used.

The polymerizable compound may have an acid group such as a carboxylic acid group, a sulfonic acid group, or a phosphoric acid group. The polymerizable compound containing an acid group is preferably an ester of an aliphatic polyhydroxy compound and an unsaturated carboxylic acid, more preferably the polymerizable compound obtained by reacting an unreacted hydroxyl group of an aliphatic polyhydroxy compound with a non-aromatic carboxylic acid anhydride to have an acid group, and still more preferably a compound in which, in the ester of an aliphatic polyhydroxy compound and an unsaturated carboxylic acid, the aliphatic polyhydroxy compound is pentaerythritol and/or dipentaerythritol.

The acid value of the polymerizable compound containing an acid group is preferably 0.1 to 40 mgKOH/g and more preferably 5 to 30 mgKOH/g. In a case where the acid value of the polymerizable compound is 0.1 mgKOH/g or more, the development dissolution characteristics are favorable, and in a case where the acid value of the polymerizable compound is 40 mgKOH/g or less, it is advantageous in terms of production and/or handling. Furthermore, the photopolymerization performance is favorable and therefore the curability is excellent.

A compound containing a caprolactone structure is also a preferred aspect of the polymerizable compound.

The compound containing a caprolactone structure is not particularly limited as long as it contains a caprolactone structure in the molecule. The compound containing a caprolactone structure may be, for example, ε-caprolactone-modified polyfunctional (meth)acrylate obtained by esterifying a polyhydric alcohol, such as trimethylolethane, ditrimethylolethane, trimethylolpropane, ditrimethylolpropane, pentaerythritol, dipentaerythritol, tripentaerythritol, glycerin, diglycerol, or trimethylolmelamine, with (meth)acrylic acid and ε-caprolactone. Above all, a compound containing a caprolactone structure represented by Formula (Z-1) is preferable.

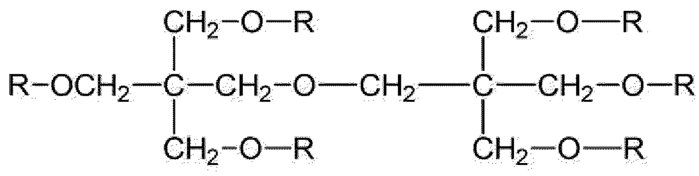

(Z-1)

In Formula (Z-1), all six R's are groups represented by Formula (Z-2), or 1 to 5 R's of the six R's are groups represented by Formula (Z-2) and the remaining R's are groups represented by Formula (Z-3).

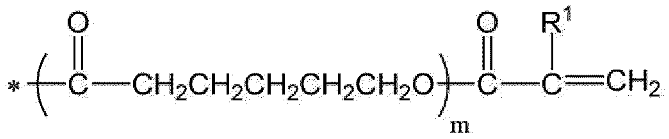

(Z-2)

In Formula (Z-2), $R^1$ represents a hydrogen atom or a methyl group, m represents a number of 1 or 2, and "*" represents a bonding site.

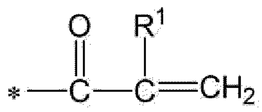

(Z-3)

In Formula (Z-3), $R^1$ represents a hydrogen atom or a methyl group, and "*" represents a bonding site.

A compound represented by Formula (Z-4) or Formula (Z-5) can also be used as the polymerizable compound.

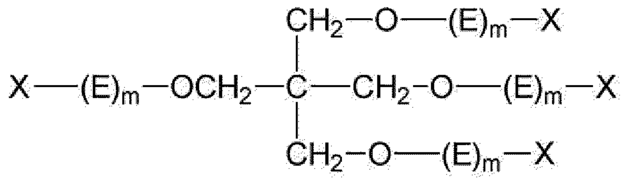

(Z-4)

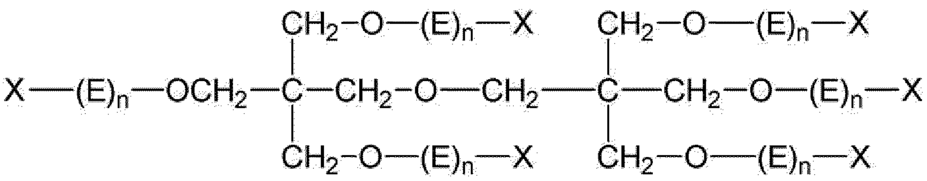

(Z-5)

In Formula (Z-4) and Formula (Z-5), E represents $-((CH_2)_yCH_2O)-$ or $-((CH_2)_yCH(CH_3)O)-$, y represents an integer of 0 to 10, and X represents a (meth)acryloyl group, a hydrogen atom, or a carboxylic acid group.

In Formula (Z-4), the total number of (meth)acryloyl groups is 3 or 4, m represents an integer of 0 to 10, and the sum of each m is an integer of 0 to 40.

In Formula (Z-5), the total number of (meth)acryloyl groups is 5 or 6, n represents an integer of 0 to 10, and the sum of each n is an integer of 0 to 60.

In Formula (Z-4), m is preferably an integer of 0 to 6 and more preferably an integer of 0 to 4.

In addition, the sum of each m is preferably an integer of 2 to 40, more preferably an integer of 2 to 16, and still more preferably an integer of 4 to 8.

In Formula (Z-5), n is preferably an integer of 0 to 6 and more preferably an integer of 0 to 4.

In addition, the sum of each n is preferably an integer of 3 to 60, more preferably an integer of 3 to 24, and still more preferably an integer of 6 to 12.

In addition, $-((CH_2)_yCH_2O)-$ or $-((CH_2)_yCH(CH_3)O)-$ in Formula (Z-4) or Formula (Z-5) preferably has a form in which the terminal on the oxygen atom side is bonded to X.

The compound represented by Formula (Z-4) or Formula (Z-5) may be used alone or in combination of two or more thereof. In particular, a preferred aspect is an aspect in which all six X's are acryloyl groups in Formula (Z-5), or an aspect which is a mixture of a compound in which all six X's are acryloyl groups in Formula (Z-5) and a compound in which at least one of the six X's is a hydrogen atom in Formula (Z-5). Such a configuration makes it possible to further improve the developability.

In addition, the total content of the compound represented by Formula (Z-4) or Formula (Z-5) in the polymerizable compound is preferably 20% by mass or more and more preferably 50% by mass or more.

Among the compounds represented by Formula (Z-4) or Formula (Z-5), a pentaerythritol derivative and/or a dipentaerythritol derivative is more preferable.

In addition, the polymerizable compound may contain a cardo skeleton.

The polymerizable compound containing a cardo skeleton is preferably the polymerizable compound containing a 9,9-bisarylfluorene skeleton.

The content of ethylenically unsaturated groups in the polymerizable compound (meaning a value obtained by dividing the number of ethylenically unsaturated groups in the polymerizable compound by the molecular weight (g/mol) of the polymerizable compound) is preferably 5.0 mmol/g or more. The upper limit of the content of ethylenically unsaturated groups is not particularly limited, and is generally 20.0 mmol/g or less.

The content of the polymerizable compound in the composition is not particularly limited, and is preferably 1% to 40% by mass, more preferably 5% to 30% by mass, and still more preferably 10% to 25% by mass with respect to the total solid content of the composition.

The composition may contain materials other than the above-mentioned magnetic particles and polymerizable compound.

[Resin]

The composition may contain a resin.

Examples of the resin include a (meth)acrylic resin, an epoxy resin, an ene-thiol resin, a polycarbonate resin, a polyether resin, a polyarylate resin, a polysulfone resin, a polyethersulfone resin, a polyphenylene resin, a polyarylene ether phosphine oxide resin, a polyimide resin, a polyamide imide resin, a polyolefin resin, a cyclic olefin resin, a polyester resin, a styrene resin, and a phenoxy resin.

One type of these resins may be used alone, or two or more types of these resins may be used in admixture.

A suitable aspect of the resin may be, for example, a resin having an unsaturated double bond (for example, an ethylenically unsaturated double bond) and a polymerizable group such as an epoxy group or an oxetanyl group.

In addition, a suitable aspect of the resin may be, for example, a resin having an acid group, a basic group, or an amide group. The resin having an acid group, a basic group, or an amide group tends to exhibit a function as a dispersing agent for dispersing magnetic particles.

Examples of the acid group include a carboxy group, a phosphoric acid group, a sulfo group, and a phenolic hydroxyl group, among which a carboxy group is preferable.

Examples of the basic group include an amino group (a group obtained by removing one hydrogen atom from ammonia, a primary amine, or a secondary amine) and an imino group.

Above all, the resin preferably has a carboxy group or an amide group.

In a case where the resin has an acid group, the acid value of the resin is preferably 10 to 500 mgKOH/g and more preferably 30 to 400 mgKOH/g.

As the resin, from the viewpoint of improving the dispersibility of the resin in the composition, it is preferable to use a resin having a solubility in a solvent of 10 g/L or more, and it is more preferable to use a resin having a solubility in a solvent of 20 g/L or more.

The upper limit value of the solubility of the resin in a solvent is preferably 2,000 g/L or less and more preferably 1,000 g/L or less.

The solubility of the resin in a solvent means a dissolution amount (g) of the resin in 1 L of the solvent at 25°C.

The content of the resin is preferably 0.1% to 30% by mass, more preferably 1% to 25% by mass, and still more preferably 5% to 20% by mass with respect to the total mass of the composition.

A suitable aspect of the resin may be, for example, a resin that functions as a dispersing agent for dispersing magnetic particles in the composition (hereinafter, also referred to as a "dispersion resin"). The effect of the present invention is more excellent by using the dispersion resin.

[Resin having repeating unit containing graft chain]

The dispersion resin may be, for example, a resin having a repeating unit containing a graft chain (hereinafter, also referred to as "resin A"). In this regard, the resin A can be used for a purpose other than exhibiting the function as a dispersing agent.

In a case where the composition contains the resin A, the content of the resin A is preferably 0.1% to 30% by mass, more preferably 0.5% to 20% by mass, and still more preferably 1% to 10% by mass with respect to the total mass of the composition, from the viewpoint that the effect of the present invention is more excellent.

· Repeating unit containing graft chain

In the repeating unit containing a graft chain, a longer graft chain leads to a higher steric repulsion effect, which improves the dispersibility of magnetic particles. On the other hand, in a case where the graft chain is too long, the adsorption power to the magnetic particles tends to decrease, and therefore the dispersibility of the magnetic particles tends to decrease. For this reason, the graft chain preferably has 40 to 10,000 atoms excluding hydrogen atoms, more preferably 50 to 2,000 atoms excluding hydrogen atoms, and still more preferably 60 to 500 atoms excluding hydrogen atoms.

Here, the graft chain indicates from a root of a main chain (an atom bonded to the main chain in a group branched from the main chain) to a terminal of the group branched from the main chain.

In addition, the graft chain preferably contains a polymer structure, and examples of such a polymer structure include a poly(meth)acrylate structure (for example, a poly(meth)acrylic structure), a polyester structure, a polyurethane structure, a polyurea structure, a polyamide structure, and a polyether structure.

In order to improve the interactivity between the graft chain and the solvent, thereby enhancing the dispersibility of magnetic particles, the graft chain is preferably a graft chain containing at least one selected from the group consisting of a polyester structure, a polyether structure, and a poly(meth)acrylate structure, and more preferably a graft chain containing at least one of a polyester structure or a polyether structure.

The resin A may be a resin obtained using a macromonomer containing a graft chain (a monomer having a polymer structure and being bonded to a main chain to constitute a graft chain).

The macromonomer containing a graft chain (the monomer having a polymer structure and being bonded to a main chain to constitute a graft chain) is not particularly limited, and a macromonomer containing a reactive double bond group can be suitably used.

As a commercially available macromonomer that corresponds to the repeating unit containing a graft chain and is suitably used for the synthesis of the resin A, AA-6, AA-10, AB-6, AS-6, AN-6, AW-6, AA-714, AY-707, AY-714, AK-5, AK-30, and AK-32 (all trade names, manufactured by Toagosei Co., Ltd.), and BLEMMER PP-100, BLEMMER

PP-500, BLEMMER PP-800, BLEMMER PP-1000, BLEMMER 55-PET-800, BLEMMER PME-4000, BLEMMER PSE-400, BLEMMER PSE-1300, and BLEMMER 43PAPE-600B (all trade names, manufactured by NOF CORPORATION) are used.

The resin A preferably contains at least one structure selected from the group consisting of a poly(methyl acrylate), a poly(methyl methacrylate), and a cyclic or chain-like polyester, more preferably contains at least one structure selected from the group consisting of a poly(methyl acrylate), a poly(methyl methacrylate), and a chain-like polyester, and still more preferably contains at least one structure selected from the group consisting of a poly(methyl acrylate) structure, a poly(methyl methacrylate) structure, a polycaprolactone structure, and a polyvalerolactone structure. The resin A may contain one type of the above-mentioned structure alone, or may contain a plurality of the above-mentioned structures.

Here, the polycaprolactone structure refers to a structure containing a structure in which ε-caprolactone is ring-opened as a repeating unit. The polyvalerolactone structure refers to a structure containing a structure in which δ-valerolactone is ring-opened as a repeating unit.

In a case where the resin A contains a repeating unit in which j and k in Formula (1) and Formula (2), each of which will be described later, are 5, the above-mentioned polycaprolactone structure can be introduced into the resin A.

In addition, in a case where the resin A contains a repeating unit in which j and k in Formula (1) and Formula (2), each of which will be described later, are 4, the above-mentioned polyvalerolactone structure can be introduced into the resin.

In addition, in a case where the resin A contains a repeating unit in which, in Formula (4) which will be described later, $X^5$ is a hydrogen atom and $R^4$ is a methyl group, the above-mentioned poly(methyl acrylate) structure can be introduced into the resin A.

In addition, in a case where the resin A contains a repeating unit in which, in Formula (4) which will be described later, $X^5$ is a methyl group and $R^4$ is a methyl group, the above-mentioned poly(methyl methacrylate) structure can be introduced into the resin A.

The resin A preferably contains a repeating unit represented by any one of Formula (1) to Formula (4), and more preferably a repeating unit represented by any one of Formula (1A), Formula (2A), Formula (3A), Formula (3B), and Formula (4), as the repeating unit containing a graft chain.

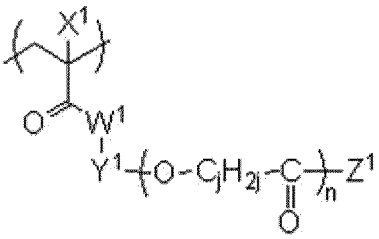 (1)

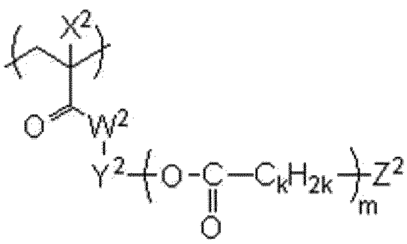 (2)

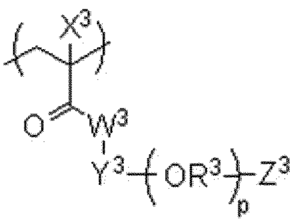 (3)

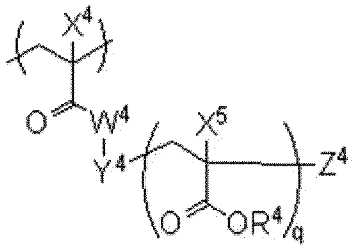 (4)

In Formula (1) to Formula (4), $W^1$, $W^2$, $W^3$, and $W^4$ each independently represent an oxygen atom or NH. $W^1$, $W^2$, $W^3$, and $W^4$ are each preferably an oxygen atom.

In Formula (1) to Formula (4), $X^1$, $X^2$, $X^3$, $X^4$, and $X^5$ each independently represent a hydrogen atom or a monovalent organic group. From the viewpoint of synthetic restrictions, $X^1$, $X^2$, $X^3$, $X^4$, and $X^5$ are each independently preferably a hydrogen atom or an alkyl group having 1 to 12 carbon atoms, more preferably a hydrogen atom or a methyl group, and still more preferably a methyl group.

In Formula (1) to Formula (4), $Y^1$, $Y^2$, $Y^3$, and $Y^4$ each independently represent a divalent linking group, and the linking group is not particularly restricted in structure. Specific examples of the divalent linking group represented by $Y^1$, $Y^2$, $Y^3$, and $Y^4$ include the following linking groups (Y-1) to (Y-21). In the structures shown below, A and B respectively mean bonding sites with a left terminal group and a right terminal group in Formula (1) to Formula (4). Among the structures shown below, (Y-2) or (Y-13) is more preferable from the viewpoint of ease of synthesis.

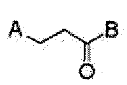
(Y-1)

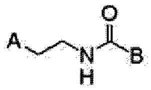
(Y-2)

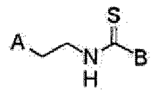
(Y-3)

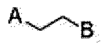
(Y-4)

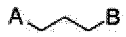
(Y-5)

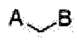
(Y-6)

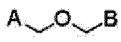
(Y-7)

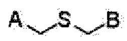
(Y-8)

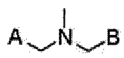
(Y-9)

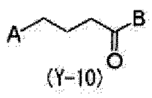
(Y-10)

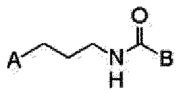
(Y-11)

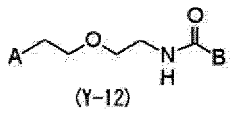
(Y-12)

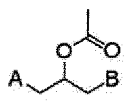
(Y-13)

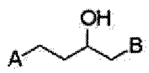
(Y-14)

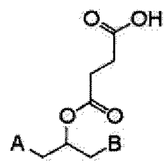
(Y-15)

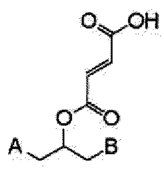
(Y-16)

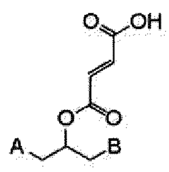
(Y-17)

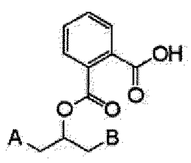
(Y-18)

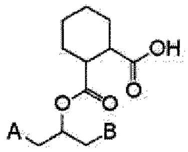
(Y-19)

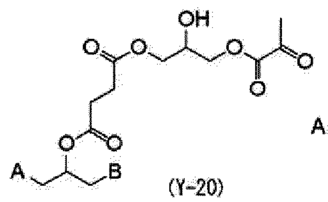
(Y-20)

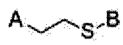
(Y-21)

In Formula (1) to Formula (4), $Z^1$, $Z^2$, $Z^3$, and $Z^4$ each independently represent an organic group. The structure of the organic group is not particularly limited, and specific examples of the organic group include an alkyl group, an alkyl group containing -O-, an alkoxy group, an aryloxy group, a heteroaryloxy group, an alkylthioether group, an arylthioether group, a heteroarylthioether group, and an amino group. The above-mentioned substituent may be further substituted with a substituent (for example, a hydroxyl group or a (meth)acryloyloxy group).

Among these groups, particularly from the viewpoint of improving dispersibility, the organic group represented by $Z^1$, $Z^2$, $Z^3$, and $Z^4$ is preferably a group having a steric repulsion effect, more preferably an alkyl group having 5 to 24 carbon atoms or an alkoxy group having 5 to 24 carbon atoms, and still more preferably a branched alkyl group having 5 to 24 carbon atoms, a cyclic alkyl group having 5 to 24 carbon atoms, or an alkoxy group having 5 to 24 carbon atoms. The alkyl group contained in the alkoxy group may be linear, branched, or cyclic.

In Formula (1) to Formula (4), n, m, p, and q are each independently an integer of 1 to 500.

In addition, in Formula (1) and Formula (2), j and k each independently represent an integer of 2 to 8. j and k in Formula (1) and Formula (2) are each preferably an integer of 4 to 6, and more preferably 5.

In addition, in Formula (1) and Formula (2), n and m are each preferably an integer of 10 or more and more

preferably an integer of 20 or more. In addition, in a case where the resin A contains a polycaprolactone structure and a polyvalerolactone structure, the sum of the number of repetitions of the polycaprolactone structure and the number of repetitions of the polyvalerolactone is preferably an integer of 10 or more, and more preferably an integer of 20 or more.

In Formula (3), $R^3$ represents a branched or linear alkylene group, preferably an alkylene group having 1 to 10 carbon atoms, and more preferably an alkylene group having 2 or 3 carbon atoms. In a case where p is 2 to 500, a plurality of $R^3$'s may be the same as or different from each other.

In Formula (4), $R^4$ represents a hydrogen atom or a monovalent organic group, and the structure of the monovalent organic group is not particularly limited. $R^4$ is preferably a hydrogen atom, an alkyl group, an aryl group, or a heteroaryl group, and more preferably a hydrogen atom or an alkyl group. In a case where $R^4$ is an alkyl group, the alkyl group is preferably a linear alkyl group having 1 to 20 carbon atoms, a branched alkyl group having 3 to 20 carbon atoms, or a cyclic alkyl group having 5 to 20 carbon atoms, more preferably a linear alkyl group having 1 to 20 carbon atoms, and still more preferably a linear alkyl group having 1 to 6 carbon atoms. In Formula (4), in a case where q is 2 to 500, a plurality of $X^5$'s and a plurality of $R^4$'s present in the graft chain each may be the same as or different from each other.

In addition, the resin A may contain two or more repeating units containing a graft chain, which have different structures. That is, the molecule of the resin A may contain repeating units having different structures and represented by Formula (1) to Formula (4), and in a case where n, m, p, and q in Formula (1) to Formula (4) each represent an integer of 2 or more, in Formula (1) and Formula (2), the side chain may contain a structure in which j and k are different from each other, and in Formula (3) and Formula (4), a plurality of $R^3$'s, a plurality of $R^4$'s, and a plurality of $X^5$'s present in the molecule each may be the same as or different from each other.

The repeating unit represented by Formula (1) is more preferably a repeating unit represented by Formula (1A).

In addition, the repeating unit represented by Formula (2) is more preferably a repeating unit represented by Formula (2A).

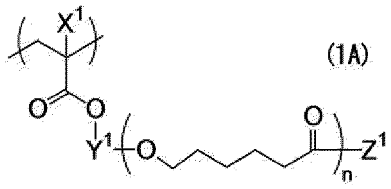

(1A)

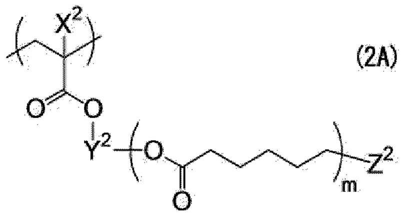

(2A)

In Formula (1A), $X^1$, $Y^1$, $Z^1$, and n have the same definition as $X^1$, $Y^1$, $Z^1$, and n in Formula (1), and the preferred ranges thereof are also the same as in Formula (1). In Formula (2A), $X^2$, $Y^2$, $Z^2$, and m have the same definition as $X^2$, $Y^2$, $Z^2$, and m in Formula (2), and the preferred ranges thereof are also the same as in Formula (2).

In addition, the repeating unit represented by Formula (3) is more preferably a repeating unit represented by Formula (3A) or Formula (3B).

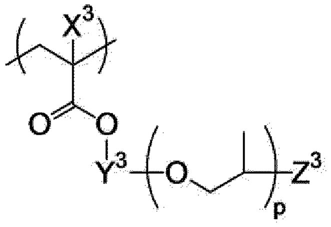

(3A)

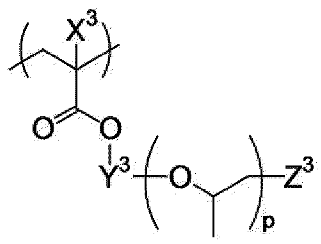

(3B)

In Formula (3A) or Formula (3B), $X^3$, $Y^3$, $Z^3$, and p have the same definition as $X^3$, $Y^3$, $Z^3$, and p in Formula

(3), and the preferred ranges thereof are also the same as in Formula (3).

It is more preferable that the resin A contains a repeating unit represented by Formula (1A) as the repeating unit containing a graft chain.

In addition, it is also preferable that the resin A contains a repeating unit containing a polyalkyleneimine structure and a polyester structure. It is preferable that the repeating unit containing a polyalkyleneimine structure and a polyester structure contains the polyalkyleneimine structure in a main chain and the polyester structure as a graft chain.

The polyalkyleneimine structure is a polymerization structure containing two or more alkyleneimine chains that are the same as or different from each other. Specific examples of the alkyleneimine chain include alkyleneimine chains represented by Formula (4A) and Formula (4B).

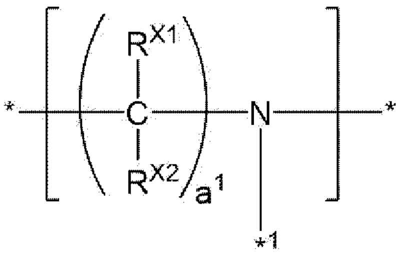

(4A)

In Formula (4A), $R^{X1}$ and $R^{X2}$ each independently represent a hydrogen atom or an alkyl group. $a^1$ represents an integer of 2 or more. $*^1$ represents a bonding position with a polyester chain, an adjacent alkyleneimine chain, or a hydrogen atom or a substituent.

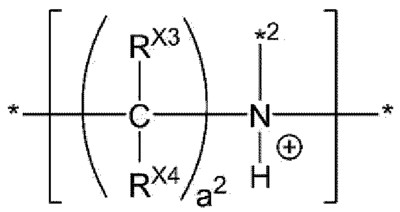

(4B)

In Formula (4B), $R^{X3}$ and $R^{X4}$ each independently represent a hydrogen atom or an alkyl group. $a^2$ represents an integer of 2 or more. The alkyleneimine chain represented by Formula (4B) is bonded to a polyester chain having an anionic group by the formation of a salt crosslinking group by $N^+$ specified in Formula (4B) and an anionic group contained in the polyester chain.

* in Formula (4A) and Formula (4B) and $*^2$ in Formula (4B) each independently represent a position that bonds to an adjacent alkyleneimine chain, a hydrogen atom, or a substituent.

Above all, * in Formula (4A) and Formula (4B) preferably represents a position that bonds to an adjacent alkyleneimine chain.

$R^{X1}$ and $R^{X2}$ in Formula (4A) and $R^{X3}$ and $R^{X4}$ in Formula (4B) each independently represent a hydrogen atom or an alkyl group.

The number of carbon atoms in the alkyl group is preferably 1 to 6 carbon atoms, and more preferably 1 to 3 carbon atoms.

In Formula (4A), both $R^{X1}$ and $R^{X2}$ are preferably hydrogen atoms.

In Formula (4B), both $R^{X3}$ and $R^{X4}$ are preferably hydrogen atoms.

$a^1$ in Formula (4A) and $a^2$ in Formula (4B) are not particularly limited as long as $a^1$ and $a^2$ are each an integer of 2 or more. The upper limit value of each of $a^1$ and $a^2$ is preferably 10 or less, more preferably 6 or less, still more preferably 4 or less, even still more preferably 2 or 3, and particularly preferably 2.

In Formula (4A) and Formula (4B), * represents a bonding position with an adjacent alkyleneimine chain, a hydrogen atom, or a substituent.

Examples of the substituent include substituents such as an alkyl group (for example, an alkyl group having 1 to 6 carbon atoms). In addition, a polyester chain may be bonded as the substituent.

The alkyleneimine chain represented by Formula (4A) is preferably linked to the polyester chain at the position of $*^1$ described above. Specifically, the carbonyl carbon in the polyester chain is preferably bonded at the position of $*^1$ described above.

The polyester chain may be, for example, a polyester chain represented by Formula (5A).

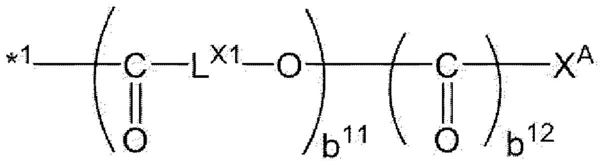

(5A)

In a case where the alkyleneimine chain is an alkyleneimine chain represented by Formula (4B), it is preferable that the polyester chain contains an anionic group (preferably an oxygen anion $O^-$) and this anionic group and $N^+$ in Formula (4B) form a salt crosslinking group.

Such a polyester chain may be, for example, a polyester chain represented by Formula (5B).

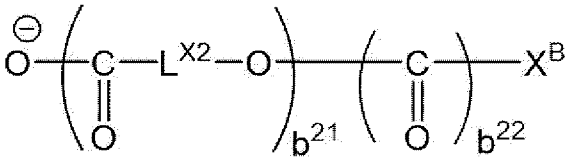

(5B)

$L^{X1}$ in Formula (5A) and $L^{X2}$ in Formula (5B) each independently represent a divalent linking group. The divalent linking group is preferably an alkylene group having 3 to 30 carbon atoms.

$b^{11}$ in Formula (5A) and $b^{21}$ in Formula (5B) each independently represent an integer of 2 or more, and the upper limit of each of $b^{11}$ and $b^{21}$ is, for example, 200 or less.

$b^{12}$ in Formula (5A) and $b^{22}$ in Formula (5B) each independently represent 0 or 1.

$X^A$ in Formula (5A) and $X^B$ in Formula (5B) each independently represent a hydrogen atom or a substituent. Examples of the substituent include an alkyl group, an alkoxy group, a polyalkyleneoxyalkyl group, and an aryl group.

The number of carbon atoms in the alkyl group (which may be linear, branched, or cyclic) and the alkyl group (which may be linear, branched, or cyclic) contained in the alkoxy group is preferably 1 to 30 and more preferably 1 to 10. In addition, the alkyl group may further have a substituent, and examples of the substituent include a hydroxyl group and a halogen atom (such as a fluorine atom, a chlorine atom, a bromine atom, or an iodine atom).

The polyalkyleneoxyalkyl group is a substituent represented by $R^{X6}(OR^{X7})_p(O)_q$-. $R^{X6}$ represents an alkyl group, $R^{X7}$ represents an alkylene group, p represents an integer of 2 or more, and q represents 0 or 1.

The alkyl group represented by $R^{X6}$ has the same definition as the alkyl group represented by $X^A$. In addition, the alkylene group represented by $R^{X7}$ may be, for example, a group obtained by removing one hydrogen atom from the alkyl group represented by $X^A$.

p is an integer of 2 or more, and the upper limit value of p is, for example, 10 or less, and preferably 5 or less.

The aryl group may be, for example, an aryl group having 6 to 24 carbon atoms (which may be monocyclic or polycyclic).

The aryl group may further have a substituent, and examples of the substituent include an alkyl group, a halogen atom, and a cyano group.

The polyester chain is preferably a structure in which a lactone is ring-opened, such as ε-caprolactone, δ-caprolactone, β-propiolactone, γ-butyrolactone, δ-valerolactone, γ-valerolactone, enantholactone, β-butyrolactone, γ-hexanolactone, γ-octanolactone, δ-hexanolactone, δ-octanolactone, δ-dodecanolactone, α-methyl-γ-butyrolactone, or lactide (which may be either L-form or D-form), and more preferably a structure in which ε-caprolactone or δ-valerolactone is ring-opened.

The repeating unit containing a polyalkyleneimine structure and a polyester structure can be synthesized according to the synthesis method described in JP5923557B.

The content of the repeating unit containing a graft chain in the resin A is preferably 2% to 100% by mass, more preferably 2% to 90% by mass, and still more preferably 5% to 30% by mass with respect to the total mass of the resin A in terms of mass. The effect of the present invention is more excellent in a case where the repeating unit containing a graft chain is contained in this range.

· Hydrophobic repeating unit

In addition, the resin A may contain a hydrophobic repeating unit that is different from the repeating unit containing a graft chain (that is, a hydrophobic repeating unit that does not correspond to the repeating unit containing a graft chain).

In this regard, in the present specification, the hydrophobic repeating unit is a repeating unit that does not have an acid group (for example, a carboxylic acid group, a sulfonic acid group, a phosphoric acid group, or a phenolic hydroxyl group).

The hydrophobic repeating unit is preferably a repeating unit derived from (corresponding to) a compound (monomer) having a ClogP value of 1.2 or more, and more preferably a repeating unit derived from a compound having a ClogP value of 1.2 to 8. In this manner, the effect of the present invention can be more reliably exhibited.

The ClogP value is a value calculated by the program "CLOGP", which is available from Daylight Chemical Information System, Inc. This program provides a value of a "calculated logP" calculated by the Hansch and Leo's fragment approach (see literature below). The fragment approach is based on a chemical structure of a compound, and divides the chemical structure into partial structures (fragments) and sums the logP contributions allocated to the fragments to estimate the logP value of the compound. The details thereof are described in the following literature. In the present specification, the ClogP value calculated by the program CLOGP v4.82 is used.

A. J. Leo, Comprehensive Medicinal Chemistry, Vol. 4, C. Hansch, P. G. Sammnens, J. B. Taylor and C. A. Ramsden, Eds., p. 295, Pergamon Press, 1990 C. Hansch & A. J. Leo. Substituent Constants For Correlation Analysis in Chemistry and Biology. John Wiley & Sons. A. J. Leo. Calculating log Poct from structure. Chem. Rev., 93, 1281-1306, 1993.

The logP means a common logarithm of a partition coefficient P, and is a physical property value that expresses, as a quantitative numerical value, how a certain organic compound is partitioned at an equilibrium in a two-phase system of oil (generally 1-octanol) and water. The logP is represented by the following expression.

$$\log P = \log(Coil/Cwater)$$

In the expression, Coil represents a molar concentration of a compound in an oil phase, and Cwater represents a molar concentration of a compound in a water phase.

In a case where a value of logP increases positively across 0, the oil solubility increases, and in a case where a value of logP increases negatively in terms of an absolute value, the water solubility increases. The value of logP has a negative correlation with the water solubility of an organic compound and is widely used as a parameter for estimating the hydrophilicity and hydrophobicity of the organic compound.

The resin A preferably contains, as the hydrophobic repeating unit, one or more repeating units selected from repeating units derived from monomers represented by Formula (i) to Formula (iii).

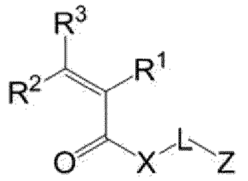

(i)

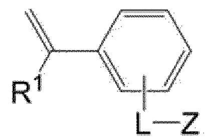

(ii)

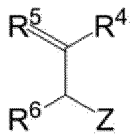

(iii)

In Formula (i) to Formula (iii), $R^1$, $R^2$, and $R^3$ each independently represent a hydrogen atom, a halogen atom (for example, a fluorine atom, a chlorine atom, or a bromine atom), or an alkyl group having 1 to 6 carbon atoms (for example, a methyl group, an ethyl group, or a propyl group).

$R^1$, $R^2$, and $R^3$ are each preferably a hydrogen atom or an alkyl group having 1 to 3 carbon atoms, and more preferably a hydrogen atom or a methyl group. $R^2$ and $R^3$ are each still more preferably a hydrogen atom.

X represents an oxygen atom (-O-) or an imino group (-NH-), among which an oxygen atom is preferable.

L is a single bond or a divalent linking group. Examples of the divalent linking group include a divalent aliphatic group (for example, an alkylene group, a substituted alkylene group, an alkenylene group, a substituted alkenylene

group, an alkynylene group, or a substituted alkynylene group), a divalent aromatic group (for example, an arylene group or a substituted arylene group), a divalent heterocyclic group, an oxygen atom (-O-), a sulfur atom (-S-), an imino group (-NH-), a substituted imino group (-$NR^{31}$- where $R^{31}$ is an aliphatic group, an aromatic group, or a heterocyclic group), a carbonyl group (-CO-), and a combination thereof.

L is preferably a single bond, an alkylene group, or a divalent linking group containing an oxyalkylene structure. The oxyalkylene structure is more preferably an oxyethylene structure or an oxypropylene structure. In addition, L may contain a polyoxyalkylene structure containing two or more repeating oxyalkylene structures. The polyoxyalkylene structure is preferably a polyoxyethylene structure or a polyoxypropylene structure. The polyoxyethylene structure is represented by $-(OCH_2CH_2)_n-$ where n is preferably an integer of 2 or more and more preferably an integer of 2 to 10.

Examples of Z include an aliphatic group (for example, an alkyl group, a substituted alkyl group, an unsaturated alkyl group, or a substituted unsaturated alkyl group), an aromatic group (for example, an aryl group, a substituted aryl group, an arylene group, or a substituted arylene group), a heterocyclic group, and a combination thereof. These groups may contain an oxygen atom (-O-), a sulfur atom (-S-), an imino group (-NH-), a substituted imino group (-$NR^{31}$- where $R^{31}$ is an aliphatic group, an aromatic group, or a heterocyclic group), or a carbonyl group (-CO-).

In Formula (iii), $R^4$, $R^5$, and $R^6$ each independently represent a hydrogen atom, a halogen atom (for example, a fluorine atom, a chlorine atom, or a bromine atom), an alkyl group having 1 to 6 carbon atoms (for example, a methyl group, an ethyl group, or a propyl group), Z, or L-Z. Here, L and Z have the same definition as the group described above. $R^4$, $R^5$, and $R^6$ are each preferably a hydrogen atom or an alkyl group having 1 to 3 carbon atoms and more preferably a hydrogen atom.

The monomer represented by Formula (i) is preferably a compound in which $R^1$, $R^2$, and $R^3$ are each a hydrogen atom or a methyl group, L is a single bond, an alkylene group, or a divalent linking group containing an oxyalkylene structure, X is an oxygen atom or an imino group, and Z is an aliphatic group, a heterocyclic group, or an aromatic group.

In addition, the monomer represented by Formula (ii) is preferably a compound in which $R^1$ is a hydrogen atom or a methyl group, L is an alkylene group, and Z is an aliphatic group, a heterocyclic group, or an aromatic group. In addition, the monomer represented by Formula (iii) is preferably a compound in which $R^4$, $R^5$, and $R^6$ are each a hydrogen atom or a methyl group, and Z is an aliphatic group, a heterocyclic group, or an aromatic group.

The content of the hydrophobic repeating unit in the resin A is preferably 10% to 90% by mass and more preferably 20% to 80% by mass with respect to the total mass of the resin A in terms of mass.

· Functional group capable of forming interaction with magnetic particles

The resin A may have a functional group capable of forming an interaction with magnetic particles.

The resin A preferably further contains a repeating unit containing a functional group capable of forming an interaction with magnetic particles.

Examples of the functional group capable of forming an interaction with magnetic particles include an acid group, a basic group, a coordinating group, and a functional group having reactivity.

In a case where the resin A contains an acid group, a basic group, a coordinating group, or a functional group having reactivity, it is preferable that the resin A contains a repeating unit containing an acid group, a repeating unit containing a basic group, a repeating unit containing a coordinating group, or a repeating unit having a functional group having reactivity.

The repeating unit containing an alkali-soluble group as the acid group may be the same repeating unit as the above-mentioned repeating unit containing a graft chain, or may be a repeating unit different from the above-mentioned repeating unit containing a graft chain, but the repeating unit containing an alkali-soluble group as the acid group is a repeating unit different from the above-mentioned hydrophobic repeating unit (that is, the repeating unit containing an alkali-soluble group as the acid group does not correspond to the above-mentioned hydrophobic repeating unit).

Examples of the acid group which is a functional group capable of forming an interaction with magnetic particles include a carboxylic acid group, a sulfonic acid group, a phosphoric acid group, and a phenolic hydroxyl group, among which at least one of a carboxylic acid group, a sulfonic acid group, or a phosphoric acid group is preferable, and a carboxylic acid group is more preferable. The carboxylic acid group has favorable adsorption power to magnetic particles and high dispersibility.

That is, it is preferable that the resin A further contains a repeating unit containing at least one of a carboxylic acid group, a sulfonic acid group, or a phosphoric acid group.

The resin A may have one or two or more repeating units containing an acid group.

In a case where the resin A contains a repeating unit containing an acid group, the content of the repeating unit containing an acid group is preferably 5% to 80% by mass and more preferably 10% to 60% by mass with respect to the total mass of the resin A in terms of mass.

Examples of the basic group which is a functional group capable of forming an interaction with magnetic particles include a primary amino group, a secondary amino group, a tertiary amino group, a heterocyclic ring containing an N

atom, and an amide group. From the viewpoint of favorable adsorption power to magnetic particles and high dispersibility, the preferred basic group is a tertiary amino group. The resin A may contain one or two or more of these basic groups.

In a case where the resin A contains a repeating unit containing a basic group, the content of the repeating unit containing a basic group is preferably 0.01% to 50% by mass and more preferably 0.01% to 30% by mass with respect to the total mass of the resin A in terms of mass.

Examples of the coordinating group and the functional group having reactivity, which are functional groups capable of forming an interaction with magnetic particles, include an acetylacetoxy group, a trialkoxysilyl group, an isocyanate group, an acid anhydride, and an acid chloride. From the viewpoint of favorable adsorption power to magnetic particles and high dispersibility of magnetic particles, the preferred functional group is an acetylacetoxy group. The resin A may have one or two or more of these groups.

In a case where the resin A contains a repeating unit containing a coordinating group or a repeating unit containing a functional group having reactivity, the content of the repeating unit containing a coordinating group or the repeating unit containing a functional group having reactivity is preferably 10% to 80% by mass and more preferably 20% to 60% by mass with respect to the total mass of the resin A in terms of mass.

In a case where the resin A contains a functional group capable of forming an interaction with magnetic particles in addition to the graft chain, it is sufficient that the resin A contains a functional group capable of forming an interaction with the various magnetic particles, and how the functional group is introduced is not particularly limited. For example, the resin contained in the composition preferably contains one or more repeating units selected from repeating units derived from monomers represented by Formula (iv) to Formula (vi).

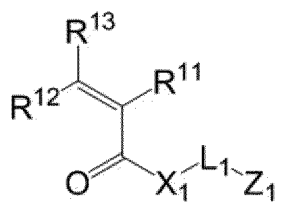

(iv)

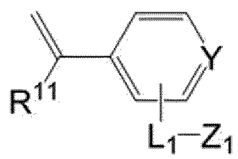

(v)

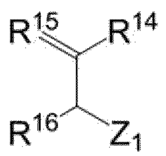

(vi)

In Formula (iv) to Formula (vi), $R^{11}$, $R^{12}$, and $R^{13}$ each independently represent a hydrogen atom, a halogen atom (for example, a fluorine atom, a chlorine atom, or a bromine atom), or an alkyl group having 1 to 6 carbon atoms (for example, a methyl group, an ethyl group, or a propyl group).

In Formula (iv) to Formula (vi), $R^{11}$, $R^{12}$, and $R^{13}$ are each preferably a hydrogen atom or an alkyl group having 1 to 3 carbon atoms, and more preferably a hydrogen atom or a methyl group. In General Formula (iv), $R^{12}$ and $R^{13}$ are each still more preferably a hydrogen atom.

$X_1$ in Formula (iv) represents an oxygen atom (-O-) or an imino group (-NH-), among which an oxygen atom is preferable.

In addition, Y in Formula (v) represents a methine group or a nitrogen atom.

In addition, Li in Formula (iv) and Formula (v) represents a single bond or a divalent linking group. The definition of the divalent linking group is the same as the definition of the divalent linking group represented by L in Formula (i) described above.

Li is preferably a single bond, an alkylene group, or a divalent linking group containing an oxyalkylene structure. The oxyalkylene structure is more preferably an oxyethylene structure or an oxypropylene structure. In addition, $L_1$ may contain a polyoxyalkylene structure containing two or more repeating oxyalkylene structures. The polyoxyalkylene structure is preferably a polyoxyethylene structure or a polyoxypropylene structure. The polyoxyethylene structure is represented by $-(OCH_2CH_2)_n-$ where n is preferably an integer of 2 or more and more preferably an integer of 2 to 10.

In Formula (iv) to Formula (vi), Zi represents a functional group capable of forming an interaction with magnetic

particles other than the graft chain, which is preferably a carboxylic acid group or a tertiary amino group, and more preferably a carboxylic acid group.

In Formula (vi), $R^{14}$, $R^{15}$, and $R^{16}$ each independently represent a hydrogen atom, a halogen atom (for example, a fluorine atom, a chlorine atom, or a bromine atom), an alkyl group having 1 to 6 carbon atoms (for example, a methyl group, an ethyl group, or a propyl group), $-Z_1$, or $L_1$-$Z_1$. Here, $L_1$ and $Z_1$ have the same definition as $L_1$ and $Z_1$ described above, and the same applies to preferred examples thereof. $R^{14}$, $R^{15}$, and $R^{16}$ are each preferably a hydrogen atom or an alkyl group having 1 to 3 carbon atoms and more preferably a hydrogen atom.

The monomer represented by Formula (iv) is preferably a compound in which $R^{11}$, $R^{12}$, and $R^{13}$ are each independently a hydrogen atom or a methyl group, $L_1$ is an alkylene group or a divalent linking group containing an oxyalkylene structure, $X_1$ is an oxygen atom or an imino group, and $Z_1$ is a carboxylic acid group.

In addition, the monomer represented by Formula (v) is preferably a compound in which $R^{11}$ is a hydrogen atom or a methyl group, $L_1$ is an alkylene group, $Z_1$ is a carboxylic acid group, and Y is a methine group.

Further, the monomer represented by Formula (vi) is preferably a compound in which $R^{14}$, $R^{15}$, and $R^{16}$ are each independently a hydrogen atom or a methyl group, and $Z_1$ is a carboxylic acid group.

From the viewpoint of interaction with magnetic particles, temporal stability, and permeability into a developer, the content of the repeating unit containing a functional group capable of forming an interaction with magnetic particles is preferably 0.05% to 90% by mass, more preferably 1.0% to 80% by mass, and still more preferably 10% to 70% by mass with respect to the total mass of the resin A in terms of mass.

· Ethylenically unsaturated group

The resin A may contain an ethylenically unsaturated group.

The ethylenically unsaturated group is not particularly limited, and examples thereof include a (meth)acryloyl group, a vinyl group, and a styryl group, among which a (meth)acryloyl group is preferable.

Above all, the resin A preferably contains a repeating unit containing an ethylenically unsaturated group in the side chain, and more preferably a repeating unit containing an ethylenically unsaturated group in the side chain and derived from (meth)acrylate (hereinafter, also referred to as "(meth)acrylic repeating unit containing an ethylenically unsaturated group in the side chain").

The (meth)acrylic repeating unit containing an ethylenically unsaturated group in the side chain is obtained, for example, by subjecting a carboxylic acid group in the resin A containing a (meth)acrylic repeating unit containing a carboxylic acid group to an addition reaction with an ethylenically unsaturated compound containing a glycidyl group or an alicyclic epoxy group. A (meth)acrylic repeating unit containing an ethylenically unsaturated group in the side chain can be obtained by reacting the ethylenically unsaturated group (glycidyl group or alicyclic epoxy group) thus introduced.

In a case where the resin A contains a repeating unit containing an ethylenically unsaturated group, the content of the repeating unit containing an ethylenically unsaturated group is preferably 30% to 70% by mass and more preferably 40% to 60% by mass with respect to the total mass of the resin A in terms of mass.

· Other repeating units

Further, for the purpose of improving various performances such as a film forming ability, the resin A may further have other repeating units having various functions, which are different from the repeating unit containing a graft chain, the hydrophobic repeating unit, and the repeating unit containing a functional group capable of forming an interaction with magnetic particles, as long as the effect of the present invention is not impaired.

Examples of such other repeating units include repeating units derived from a radically polymerizable compound selected from acrylonitriles, methacrylonitriles, and the like.

One or two or more of these other repeating units can be used in the resin A, and the content thereof is preferably 0% to 80% by mass and more preferably 10% to 60% by mass with respect to the total mass of the resin A in terms of mass.

· Physical properties of resin A

The acid value of the resin A is not particularly limited, and is, for example, preferably 0 to 400 mgKOH/g, more preferably 10 to 350 mgKOH/g, still more preferably 30 to 300 mgKOH/g, and particularly preferably 50 to 200 mgKOH/g.

In a case where the acid value of the resin A is 50 mgKOH/g or more, the precipitation stability of the magnetic particles can be further improved.

In the present specification, the acid value can be calculated, for example, from an average content of acid groups in a compound. In addition, a resin having a desired acid value can be obtained by changing the content of the repeating unit containing an acid group in the resin.

The weight-average molecular weight of the resin A is not particularly limited, and is, for example, preferably

3,000 or more, more preferably 4,000 or more, still more preferably 5,000 or more, and particularly preferably 6,000 or more. In addition, the upper limit value of the weight-average molecular weight of the resin A is, for example, preferably 300,000 or less, more preferably 200,000 or less, still more preferably 100,000 or less, and particularly preferably 50,000 or less.

The resin A can be synthesized based on a known method.

<Alkali-soluble resin>

The resin may include an alkali-soluble resin. In the present specification, the alkali-soluble resin means a resin containing a group that promotes alkali solubility (an alkali-soluble group, for example, an acid group such as a carboxylic acid group), and means a resin different from the resin A described above.

The alkali-soluble resin may be, for example, a resin containing at least one alkali-soluble group in the molecule, examples of which include a polyhydroxystyrene resin, a polysiloxane resin, a (meth)acrylic resin, a (meth)acrylamide resin, a (meth)acryl/(meth)acrylamide copolymer, an epoxy resin, and a polyimide resin.

Specific examples of the alkali-soluble resin include a copolymer of an unsaturated carboxylic acid and an ethylenically unsaturated compound.

The unsaturated carboxylic acid is not particularly limited, and examples thereof include monocarboxylic acids such as (meth)acrylic acid, crotonic acid, and vinylacetic acid; dicarboxylic acids such as itaconic acid, maleic acid, and fumaric acid, or acid anhydrides thereof; and polyvalent carboxylic acid monoesters such as mono-(2-(meth)acryloyloxyethyl) phthalate.

The copolymerizable ethylenically unsaturated compound may be, for example, methyl (meth)acrylate. In addition, the compounds described in paragraph [0027] of JP2010-097210A, the entire contents of which are incorporated herein by reference, and the compounds described in paragraphs [0036] and [0037] of JP2015-068893A, the entire contents of which are incorporated herein by reference, can also be used.

In addition, a copolymerizable ethylenically unsaturated compound which contains an ethylenically unsaturated group in the side chain may be used in combination. That is, the alkali-soluble resin may contain a repeating unit containing an ethylenically unsaturated group in the side chain.

The ethylenically unsaturated group contained in the side chain is preferably a (meth)acrylic acid group.

The repeating unit containing an ethylenically unsaturated group in the side chain is obtained, for example, by subjecting a carboxylic acid group of a (meth)acrylic repeating unit containing a carboxylic acid group to an addition reaction with an ethylenically unsaturated compound containing a glycidyl group or an alicyclic epoxy group.

An alkali-soluble resin containing a curable group is also preferable as the alkali-soluble resin.

Examples of the curable group include, but are not limited to, an ethylenically unsaturated group (for example, a (meth)acryloyl group, a vinyl group, or a styryl group), and a cyclic ether group (for example, an epoxy group or an oxetanyl group).

Above all, from the viewpoint that polymerization can be controlled by a radical reaction, the curable group is preferably an ethylenically unsaturated group and more preferably a (meth)acryloyl group.

An alkali-soluble resin having a curable group in the side chain or the like is preferable as the alkali-soluble resin containing a curable group. Examples of the alkali-soluble resin containing a curable group include DIANAL NR series (manufactured by Mitsubishi Rayon Co., Ltd.), PHOTOMER 6173 (a polyurethane acrylic oligomer containing COOH, manufactured by Diamond Shamrock Co., Ltd.), VISCOAT R-264 and KS RESIST 106 (both of which are manufactured by Osaka Organic Chemical Industry Ltd.), CYCLOMER P series (for example, ACA230AA) and PLACCEL CF200 series (both of which are manufactured by DAICEL Corporation), EBECRYL 3800 (manufactured by Daicel-Allnex Ltd.), and ACRYCURE RD-F8 (manufactured by Nippon Shokubai Co., Ltd.).

A polyimide precursor can also be used as the alkali-soluble resin. The polyimide precursor means a resin obtained by subjecting a compound containing an acid anhydride group and a diamine compound to an addition polymerization reaction at a temperature of 40°C to 100°C.

From the viewpoint of excellent balance of film hardness, sensitivity, and developability, the alkali-soluble resin is suitably a [benzyl(meth)acrylate/(meth)acrylic acid/other addition-polymerizable vinyl monomer as necessary] copolymer, or an [allyl(meth)acrylate/(meth)acrylic acid/other addition-polymerizable vinyl monomer as necessary] copolymer.

The other addition-polymerizable vinyl monomers may be only one type or may be two or more types.

The copolymer preferably has a curable group, and more preferably contains an ethylenically unsaturated group such as a (meth)acryloyl group.

For example, a curable group may be introduced into the copolymer using a monomer having a curable group as the other addition-polymerizable vinyl monomer. In addition, a curable group (preferably an ethylenically unsaturated group such as a (meth)acryloyl group) may be introduced into part or all of one or more of the units derived from (meth)acrylic acid in the copolymer and/or the units derived from the other addition-polymerizable vinyl monomer.

Examples of the other addition-polymerizable vinyl monomer include methyl (meth)acrylate, a styrene-based

monomer (hydroxystyrene or the like), and an ether dimer.

Examples of the ether dimer include a compound represented by General Formula (ED1) and a compound represented by General Formula (ED2).

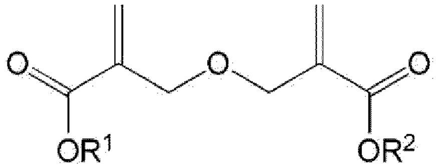

(ED1)

In General Formula (ED1), $R^1$ and $R^2$ each independently represent a hydrogen atom or a hydrocarbon group having 1 to 25 carbon atoms.

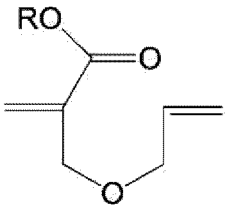

(ED2)

In General Formula (ED2), R represents a hydrogen atom or an organic group having 1 to 30 carbon atoms. With regard to specific examples of General Formula (ED2), reference can be made to the description in JP2010-168539A.

With regard to specific examples of the ether dimer, for example, reference can be made to paragraph [0317] of JP2013-029760A, the entire contents of which are incorporated herein by reference. The ether dimer may be only one type or may be two or more types.

The acid value of the alkali-soluble resin is not particularly limited, and is preferably 30 to 500 mgKOH/g and more preferably 50 to 200 mgKOH/g or more.

In a case where the composition contains an alkali-soluble resin, the content of the alkali-soluble resin is preferably 0.1% to 40% by mass, more preferably 0.5% to 30% by mass, and still more preferably 1% to 20% by mass with respect to the total mass of the composition.

[Solvent]

The composition may contain a solvent. Examples of the solvent include water and an organic solvent, among which an organic solvent is preferable.

From the viewpoint of coatability, the boiling point of the solvent is preferably 100°C to 400°C, more preferably 150°C to 300°C, and still more preferably 170°C to 250°C. In the present specification, the boiling point means a standard boiling point unless otherwise specified.

Examples of the organic solvent include, but are not limited to, acetone, methyl ethyl ketone, cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, cyclopentanone, diacetone alcohol, ethylene glycol monomethyl ether acetate, ethylene glycol ethyl ether acetate, ethylene glycol monoisopropyl ether, ethylene glycol monobutyl ether acetate, 1,4-butanediol diacetate, 3-methoxypropanol, methoxymethoxyethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 3-methoxypropyl acetate, N,N-dimethylformamide, dimethyl sulfoxide, γ-butyrolactone, ethyl acetate, butyl acetate, methyl lactate, N-methyl-2-pyrrolidone, and ethyl lactate.

From the viewpoint that the effect of the present invention is more excellent, the content of the solvent is preferably 1% to 60% by mass, more preferably 2% to 50% by mass, and still more preferably 3% to 40% by mass with respect to the total mass of the composition.

[Polymerization initiator]

The composition may contain a polymerization initiator.

The polymerization initiator is not particularly limited, and a known polymerization initiator can be used. Examples of the polymerization initiator include a photopolymerization initiator and a thermal polymerization initiator, among which

a photopolymerization initiator is preferable. The polymerization initiator is preferably a so-called radical polymerization initiator.

The content of the polymerization initiator in the composition is not particularly limited, and is preferably 0.5% to 15% by mass, more preferably 1.0% to 10% by mass, and still more preferably 1.5% to 8.0% by mass with respect to the total solid content of the composition.

Examples of the photopolymerization initiator include a halogenated hydrocarbon derivative (for example, a compound having a triazine skeleton or a compound having an oxadiazole skeleton), an acylphosphine compound, a hexaarylbiimidazole, an oxime compound, an organic peroxide, a thio compound, a ketone compound, an aromatic onium salt, an α-hydroxy ketone compound, and an α-amino ketone compound. From the viewpoint of exposure sensitivity, the photopolymerization initiator is preferably a trihalomethyltriazine compound, a benzyldimethylketal compound, an α-hydroxyketone compound, an α-aminoketone compound, an acylphosphine compound, a phosphine oxide compound, a metallocene compound, an oxime compound, a triarylimidazole dimer, an onium compound, a benzothiazole compound, a benzophenone compound, an acetophenone compound, a cyclopentadiene-benzene-iron complex, a halomethyloxadiazole compound, or a 3-aryl-substituted coumarin compound; more preferably a compound selected from an oxime compound, an α-hydroxyketone compound, an α-aminoketone compound, and an acylphosphine compound; and still more preferably an oxime compound. In addition, examples of the photopolymerization initiator include the compounds described in paragraphs [0065] to [0111] of JP2014-130173A, the compounds described in JP6301489B, the peroxide-based photopolymerization initiators described in MATERIAL STAGE, pp. 37-60, vol. 19, No. 3, 2019, the photopolymerization initiators described in WO2018/221177A, the photopolymerization initiators described in WO2018/110179A, the photopolymerization initiators described in JP2019-043864A, the photopolymerization initiators described in JP2019-044030A, the peroxide-based initiators described in JP2019-167313A, the aminoacetophenone-based initiators having an oxazolidine group described in JP2020-055992A, and the oxime-based photopolymerization initiators described in JP2013-190459A, in which the entire contents of these publications are incorporated herein by reference.

Examples of commercially available products of the α-hydroxyketone compound include OMNIRAD 184, OMNIRAD 1173, OMNIRAD 2959, and OMNIRAD 127 (all of which are manufactured by IGM Resins B.V), and IRGACURE 184, IRGACURE 1173, IRGACURE 2959, and IRGACURE 127 (all of which are manufactured by BASF SE). Examples of commercially available products of the α-aminoketone compound include OMNIRAD 907, OMNIRAD 369, OMNIRAD 369E, and OMNIRAD 379EG (all of which are manufactured by IGM Resins B.V), and IRGACURE 907, IRGACURE 369, IRGACURE 369E, and IRGACURE 379EG (all of which are manufactured by BASF SE). Examples of commercially available products of the acylphosphine compound include OMNIRAD 819 and OMNIRAD TPO (both of which are manufactured by IGM Resins B.V), and IRGACURE 819 and IRGACURE TPO (both of which are manufactured by BASF SE).

Examples of the oxime compound include the compounds described in JP2001-233842A, the compounds described in JP2000-080068A, the compounds described in JP2006-342166A, the compounds described in J. C. S. Perkin II (1979, pp. 1653 to 1660), the compounds described in J. C. S. Perkin II (1979, pp. 156 to 162), the compounds described in Journal of Photopolymer Science and Technology (1995, pp. 202 to 232), the compounds described in JP2000-066385A, the compounds described in JP2004-534797A, the compounds described in JP2006-342166A, the compounds described in JP2017-019766A, the compounds described in JP6065596B, the compounds described in WO2015/152153A, the compounds described in WO2017/051680A, the compounds described in JP2017-198865A, the compounds described in paragraphs [0025] to [0038] of WO2017/164127A, and the compounds described in WO2013/167515A. Specific examples of the oxime compound include 3-benzoyloxyiminobutan-2-one, 3-acetoxyiminobutan-2-one, 3-propionyloxyiminobutan-2-one, 2-acetoxyiminopentan-3-one, 2-acetoxyimino-1-phenylpropan-1-one, 2-benzoyloxyimino-1-phenylpropan-1-one, 3-(4-toluenesulfonyloxy)iminobutan-2-one, and 2-ethoxycarbonyloxyimino-1-phenylpropan-1-one. Examples of commercially available products of the oxime compound include IRGACURE OXE01, IRGACURE OXE02, IRGACURE OXE03, and IRGACURE OXE04 (all of which are manufactured by BASF SE), TR-PBG-304 (manufactured by Changzhou Tronly New Electronic Materials Co., Ltd.), and ADEKA OPTOMER N-1919 (manufactured by ADEKA Corporation, a photopolymerization initiator 2 described in JP2012-014052A). In addition, it is also preferable to use a compound having no colorability or a compound having high transparency and resistance to discoloration as the oxime compound. Examples of commercially available products of such compounds include ADEKA ARKLS NCI-730, NCI-831, and NCI-930 (all of which are manufactured by ADEKA Corporation).

An oxime compound having a fluorene ring can also be used as the photopolymerization initiator. Specific examples of the oxime compound having a fluorene ring include the compounds described in JP2014-137466A, the compounds described in JP6636081B, and the compounds described in KR10-2016-0109444A.

An oxime compound having a skeleton in which at least one benzene ring of a carbazole ring is a naphthalene ring can also be used as the photopolymerization initiator. Specific examples of such an oxime compound include the compounds described in WO2013/083505A.

An oxime compound having a fluorine atom can also be used as the photopolymerization initiator. Specific

examples of the oxime compound having a fluorine atom include the compounds described in JP2010-262028A, Compounds 24, and 36 to 40 described in JP2014-500852A, and Compound (C-3) described in JP2013-164471A.

An oxime compound having a nitro group can be used as the photopolymerization initiator. The oxime compound having a nitro group is also preferably a dimer. Specific examples of the oxime compound having a nitro group include the compounds described in paragraphs [0031] to [0047] of JP2013-114249A and paragraphs [0008] to [0012] and [0070] to [0079] of JP2014-137466A, the compounds described in paragraphs [0007] to [0025] of JP4223071B, and ADEKAARKLS NCI-831 (manufactured by ADEKA Corporation).

An oxime compound having a benzofuran skeleton can also be used as the photopolymerization initiator. Specific examples of the oxime compound having a benzofuran skeleton include OE-01 to OE-75 described in WO2015/036910A.

An oxime compound in which a substituent having a hydroxy group is bonded to a carbazole skeleton can also be used as the photopolymerization initiator. Examples of such a photopolymerization initiator include the compounds described in WO2019/088055A.

Specific examples of the oxime compound preferably used in the present invention are shown below, but the present invention is not limited thereto.

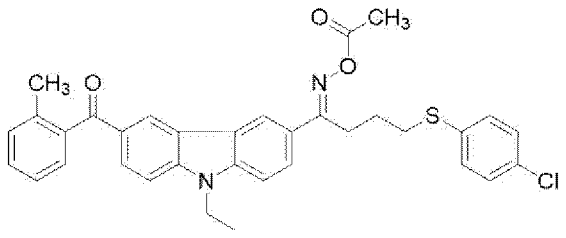

(C-1)

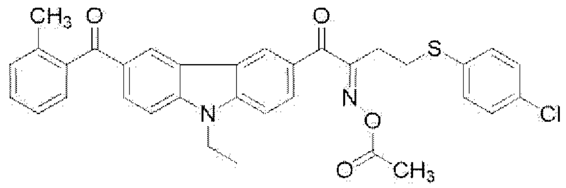

(C-2)

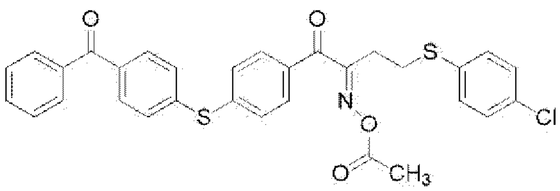

(C-3)

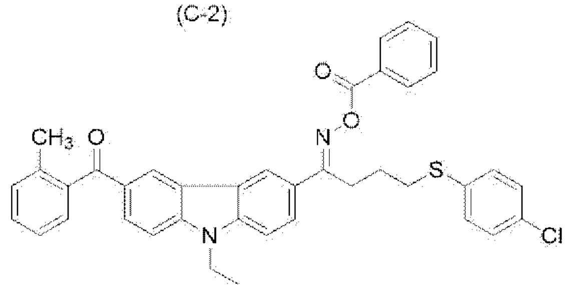

(C-4)

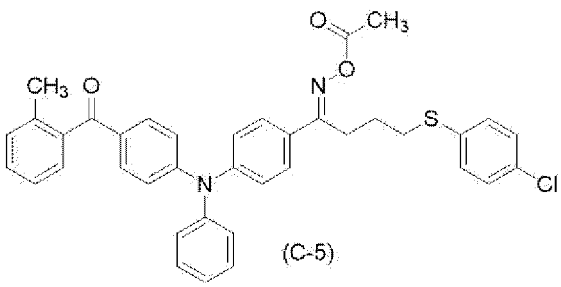

(C-5)

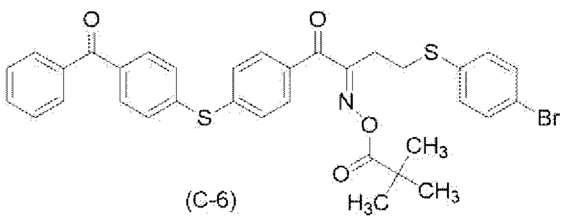

(C-6)

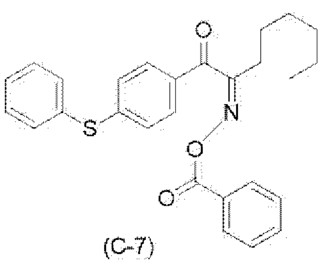

(C-7)

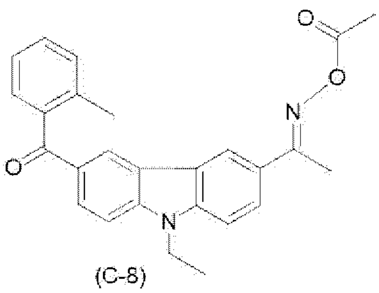

(C-8)

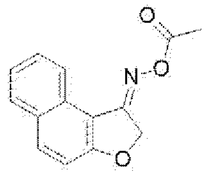

(C-9)

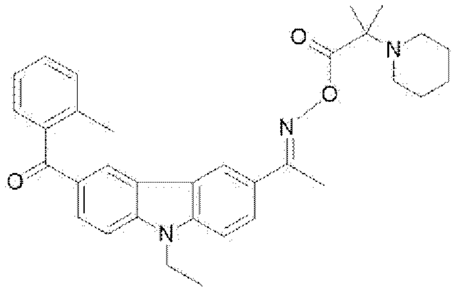

(C-10)

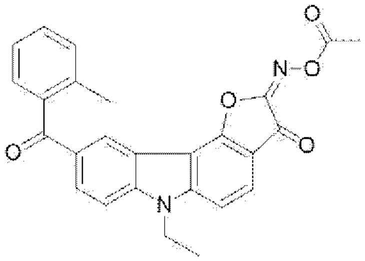

(C-11)

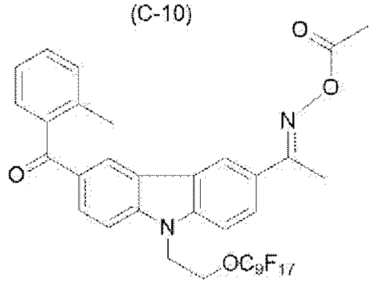

(C-12)

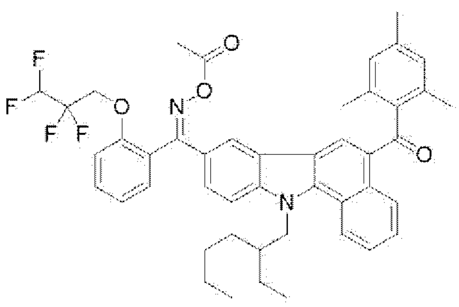

(C-13)

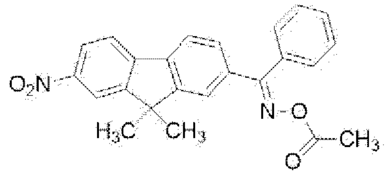

(C-14)

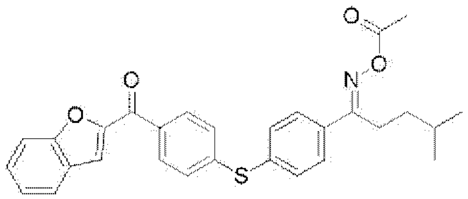

(C-15)

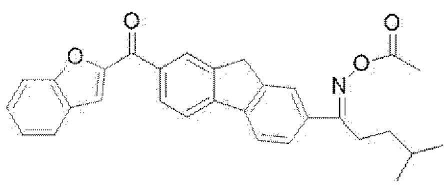

(C-16)

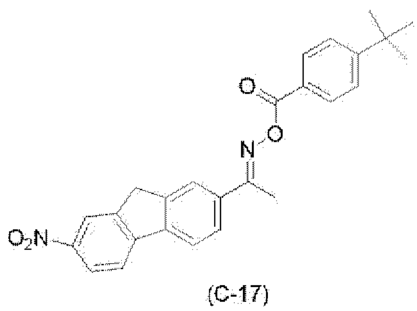

(C-17)

The oxime compound is preferably a compound having a maximum absorption wavelength in a wavelength range of 350 to 500 nm, and more preferably a compound having a maximum absorption wavelength in a wavelength

range of 360 to 480 nm. In addition, from the viewpoint of sensitivity, the molar absorption coefficient of the oxime compound at a wavelength of 365 nm or a wavelength of 405 nm is preferably high, more preferably 1,000 to 300,000, still more preferably 2,000 to 300,000, and particularly preferably 5,000 to 200,000. The molar absorption coefficient of the compound can be measured using a known method. For example, it is preferable to measure the molar absorption coefficient of the compound with a spectrophotometer (Cary-5 spectrophotometer manufactured by Varian Medical Systems, Inc.) using an ethyl acetate solvent at a concentration of 0.01 g/L.

A difunctional or trifunctional or higher functional photoradical polymerization initiator may be used as the photopolymerization initiator. By using such a photoradical polymerization initiator, two or more radicals are generated from one molecule of the photoradical polymerization initiator, so that favorable sensitivity can be obtained. In addition, in a case where a compound having an asymmetric structure is used, the crystallinity is lowered, the solubility in a solvent or the like is improved, and the precipitation is less likely to occur over time, so that the temporal stability of the composition can be improved. Specific examples of the difunctional or trifunctional or higher functional photoradical polymerization initiator include the dimers of oxime compounds described in JP2010-527339A, JP2011-524436A, WO2015/004565A, paragraphs [0407] to [0412] of JP2016-532675A, and paragraphs [0039] to [0055] of WO2017/033680A, Compound (E) and Compound (G) described in JP2013-522445A, Compound 1 to Compound 7 described in WO2016/034963A, the oxime ester photoinitiators described in paragraph [0007] of JP2017-523465A, the photoinitiators described in paragraphs [0020] to [0033] of JP2017-167399A, Photopolymerization initiator (A) described in paragraphs [0017] to [0026] of JP2017-151342A, and the oxime ester photoinitiators described in JP6469669B.

[Other optional components]

The composition may further contain optional components other than the above-mentioned components. Examples of optional components include a surfactant, a polymerization inhibitor, an antioxidant, a sensitizer, a co-sensitizer, a crosslinking agent (a curing agent), a curing accelerator, a thermal curing accelerator, a plasticizer, a diluent, an oil sensitizing agent, and a rubber component. Further, known additives such as an agent for promoting adhesion to a substrate surface and other auxiliary agents (for example, an antifoaming agent, a flame retardant, a leveling agent, a peeling accelerator, an antioxidant, a fragrance, a surface tension adjuster, and a chain transfer agent) may be added as necessary.

<<Surfactant>>

Examples of the surfactant include various surfactants such as a fluorine-based surfactant, a nonionic surfactant, a cationic surfactant, an anionic surfactant, and a silicone-based surfactant. Examples of the surfactant include the surfactants described in paragraphs [0238] to [0245] of WO2015/166779A, the entire contents of which are incorporated herein by reference.

Examples of the fluorine-based surfactant include the surfactants described in paragraphs [0060] to [0064] of JP2014-041318A (paragraphs [0060] to [0064] of corresponding WO2014/017669A), the entire contents of which are incorporated herein by reference, the surfactants described in paragraphs [0117] to [0132] of JP2011-132503A, the entire contents of which are incorporated herein by reference, and the surfactants described in JP2020-008634A, the entire contents of which are incorporated herein by reference. Examples of commercially available products of the fluorine-based surfactants include MEGAFACE F-171, F-172, F-173, F-176, F-177, F-141, F-142, F-143, F-144, F-437, F-475, F-477, F-479, F-482, F-554, F-555-A, F-556, F-557, F-558, F-559, F-560, F-561, F-563, F-565, F-568, F-575, F-780, EXP, MFS-330, R-01, R-40, R-40-LM, R-41, R-41-LM, RS-43, TF-1956, RS-90, R-94, RS-72-K, and DS-21 (all of which are manufactured by DIC Corporation), FLORARD FC430, FC431, and FC171 (all of which are manufactured by Sumitomo 3M Ltd.), SURFLON S-382, SC-101, SC-103, SC-104, SC-105, SC-1068, SC-381, SC-383, S-393, and KH-40 (all of which are manufactured by AGC Seimi Chemical Co., Ltd.), POLYFOX PF636, PF656, PF6320, PF6520, and PF7002 (all of which are manufactured by OMNOVA Solutions Inc.), and FTERGENT 208G, 215M, 245F, 601AD, 601ADH2, 602A, 610FM, 710FL, 710FM, 710FS, and FTX-218 (all of which are manufactured by NEOS Co., Ltd.).

In addition, an acrylic compound which has a molecular structure with a functional group containing a fluorine atom and in which a portion of the functional group containing a fluorine atom is cleaved to volatilize the fluorine atom in a case where heat is applied can also be suitably used as the fluorine-based surfactant. Examples of such a fluorine-based surfactant include MEGAFACE DS series (manufactured by DIC Corporation, The Chemical Daily, Feb. 22, 2016, Nikkei Business Daily, Feb. 23, 2016), for example, MEGAFACE DS-21.

In addition, it is also preferable to use a polymer of a fluorine atom-containing vinyl ether compound having a fluorinated alkyl group or a fluorinated alkylene ether group and a hydrophilic vinyl ether compound, as the fluorine-based surfactant. Examples of such a fluorine-based surfactant include the fluorine-based surfactants described in JP2016-216602A, the entire contents of which are incorporated herein by reference.

A block polymer can also be used as the fluorine-based surfactant. A fluorine-containing polymer compound

containing a repeating unit derived from a (meth)acrylate compound having a fluorine atom and a repeating unit derived from a (meth)acrylate compound having 2 or more (preferably 5 or more) alkyleneoxy groups (preferably ethyleneoxy groups or propyleneoxy groups) can also be preferably used as the fluorine-based surfactant. In addition, the fluorine-containing surfactants described in paragraphs [0016] to [0037] of JP2010-032698A and the following compound are also exemplified as the fluorine-based surfactants used in the present invention.

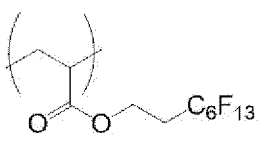

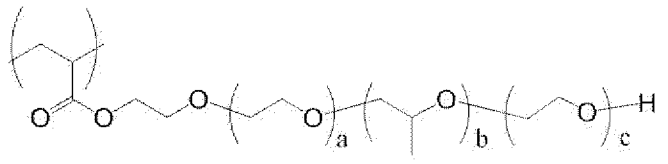

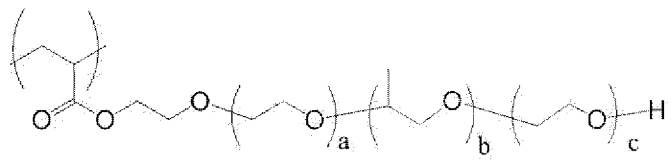

a+c=14
b=17

62%

38%

The weight-average molecular weight of the above compound is preferably 3,000 to 50,000 and is, for example, 14,000. In the above compound, % indicating the proportion of the repeating unit is mol%.

In addition, a fluorine-containing polymer having an ethylenically unsaturated bond-containing group in a side chain thereof can also be used as the fluorine-based surfactant. Specific examples of such a fluorine-containing polymer include the compounds described in paragraphs [0050] to [0090] and [0289] to [0295] of JP2010-164965A, and MEGAFACE RS-101, RS-102, RS-718K, and RS-72-K (all of which are manufactured by DIC Corporation). In addition, the compounds described in paragraphs [0015] to [0158] of JP2015-117327A can also be used as the fluorine-based surfactant.

In addition, it is also preferable from the viewpoint of environmental regulation that the surfactant described in WO2020/084854A is used as a substitute for a surfactant having a perfluoroalkyl group having 6 or more carbon atoms.

In addition, it is also preferable to use a fluorine-containing imide salt compound represented by Formula (fi-1) as the surfactant.

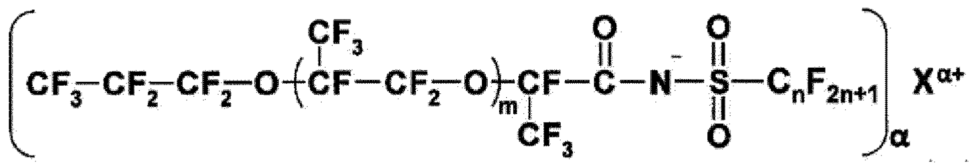

(fi-1)

In Formula (fi-1), m represents 1 or 2, n represents an integer of 1 to 4, $\alpha$ represents 1 or 2, and $X^{\alpha+}$ represents an $\alpha$-valent metal ion, a primary ammonium ion, a secondary ammonium ion, a tertiary ammonium ion, a quaternary ammonium ion, or $NH_4^+$.

Examples of the nonionic surfactant include glycerol, trimethylolpropane, trimethylolethane, and ethoxylates and propoxylates thereof (for example, glycerol propoxylate and glycerol ethoxylate), polyoxyethylene lauryl ether, polyoxyethylene stearyl ether, polyoxyethylene oleyl ether, polyoxyethylene octyl phenyl ether, polyoxyethylene nonyl phenyl ether, polyethylene glycol dilaurate, polyethylene glycol distearate, sorbitan fatty acid ester, PLURONIC (registered trademark) L10, L31, L61, L62, 10R5, 17R2, and 25R2 (all of which are manufactured by BASF SE), TETRONIC 304, 701, 704, 901, 904, and 150R1 (all of which are manufactured by BASF SE), SOLSPERSE 20000 (manufactured by The Lubrizol Corporation), NCW-101, NCW-1001, and NCW-1002 (all of which are manufactured by FUJIFILM Wako Pure Chemical Corporation), PIONIN D-6112, D-6112-W, and D-6315 (all of which are manufactured by Takemoto Oil & Fats Co., Ltd.), and OLFINE E1010 and SURFYNOL 104, 400, and 440 (all of which are manufactured by Nissin Chemical Co., Ltd.).

Examples of the cationic surfactant include a tetraalkylammonium salt, an alkylamine salt, a benzalkonium salt, an alkylpyridium salt, and an imidazolium salt. Specific examples of the cationic surfactant include dihydroxyethyl stearylamine, 2-heptadecenyl-hydroxyethyl imidazoline, lauryl dimethyl benzyl ammonium chloride, cetyl pyridinium chloride,

and stearamide methylpyridium chloride.

Examples of the anionic surfactant include dodecylbenzene sulfonic acid, sodium dodecylbenzene sulfonate, sodium lauryl sulfate, sodium alkyl diphenyl ether disulfonate, sodium alkyl naphthalene sulfonate, sodium dialkyl sulfosuccinate, sodium stearate, potassium oleate, sodium dioctyl sulfosuccinate, sodium polyoxyethylene alkyl ether sulfate, sodium polyoxyethylene alkyl ether sulfate, sodium polyoxyethylene alkyl phenyl ether sulfate, sodium dialkyl sulfosuccinate, sodium stearate, sodium oleate, and sodium t-octylphenoxyethoxypolyethoxyethyl sulfate.

Examples of the silicone-based surfactant include TORAY SILICONE DC3PA, TORAY SILICONE SH7PA, TORAY SILICONE DC11PA, TORAY SILICONE SH21PA, TORAY SILICONE SH28PA, TORAY SILICONE SH29PA, TORAY SILICONE SH30PA, and TORAY SILICONE SH8400 (all of which are manufactured by Dow Coming Toray Co., Ltd.), TSF-4440, TSF-4300, TSF-4445, TSF-4460, and TSF-4452 (all of which are manufactured by Momentive Performance Materials Co., Ltd.), KP-341, KF-6001, and KF-6002 (all of which are manufactured by Shin-Etsu Chemical Co., Ltd.), BYK-307, BYK-322, BYK-323, BYK-330, BYK-3760, and BYK-UV3510 (all of which are manufactured by BYK-Chemie GmbH), and FZ-2122 (manufactured by Dow Toray Co., Ltd.).

In addition, a compound having the following structure can also be used as the silicone-based surfactant.

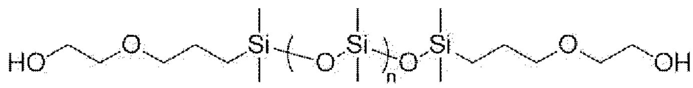

[Method for producing laminate]

The method for producing a laminate according to the present invention has the following step 1 and step 2.

Step 1: a step of applying a composition containing magnetic particles and a polymerizable compound onto a substrate on which an antenna is disposed to form a composition layer

Step 2: a step of subjecting the composition layer to an exposure treatment and a development treatment to form a magnetic pattern portion

Hereinafter, the procedures of the step 1 and the step 2 will be described in detail.

[Step 1]

In the step 1, a composition containing magnetic particles and a polymerizable compound is applied onto a substrate on which an antenna is disposed to form a composition layer.

The used composition and substrate on which an antenna is disposed are as described above.

A method of applying the composition onto the substrate is not particularly limited, and examples thereof include various application methods such as a slit coating method, an ink jet method, a rotary coating method, a cast coating method, a roll coating method, and a screen printing method.

After the application of the composition, a drying treatment may be carried out, if necessary. The drying (pre-baking) can be carried out, for example, in a hot plate, an oven, or the like at a temperature of 50°C to 140°C for 10 to 1,800 seconds.

The film thickness of the composition layer is preferably 1 to 10,000 μm, more preferably 10 to 1,000 μm, and still more preferably 15 to 800 μm.

(Step 2)

The step 2 is a step of subjecting the composition layer to an exposure treatment and a development treatment to form a magnetic pattern portion.

The method of the exposure treatment is not particularly limited, and it is preferable to irradiate the composition layer with light through a photo mask having patterned opening portions. The patterned opening portions of the photo mask are arranged such that a magnetic pattern portion having the predetermined shape described above is formed.

The exposure is preferably carried out by irradiation with radiation. The radiation that can be used for exposure is preferably ultraviolet rays such as g-line, h-line, and i-line, and a high-pressure mercury lamp is preferable as a light source. The irradiation intensity is preferably 5 to 1,500 mJ/cm$^2$ and more preferably 10 to 1,000 mJ/cm$^2$.

It is preferable to carry out a heat treatment (post-baking) after the exposure treatment.

The post-baking is a heat treatment after the development to complete curing. The heating temperature is preferably 240°C or lower and more preferably 220°C or lower. The lower limit of the heating temperature is not particularly limited, and is preferably 50°C or higher and more preferably 100°C or higher in consideration of efficient and effective

treatment.

The post-baking can be carried out continuously or batchwise using a heating unit such as a hot plate, a convection oven (hot air circulation type dryer), or a high frequency heater.

The type of developer used in the development treatment is not particularly limited, and an alkali developer that does not cause damage to a circuit or the like is desirable.

The development temperature is, for example, 20°C to 30°C.

The development time is, for example, 20 to 90 seconds. In recent years, the development treatment is sometimes carried out for 120 to 180 seconds in order to remove residues better. Further, in order to further improve the residue removability, a step of shaking off the developer every 60 seconds and then supplying a new developer may be repeated several times.

The alkali developer is preferably an alkaline aqueous solution prepared by dissolving an alkaline compound in water so that the concentration of the alkaline compound is 0.001% to 10% by mass (preferably 0.01% to 5% by mass).

Examples of the alkaline compound include sodium hydroxide, potassium hydroxide, sodium carbonate, sodium silicate, sodium metasilicate, aqueous ammonia, ethylamine, diethylamine, dimethylethanolamine, tetramethylammonium hydroxide, tetraethylammonium hydroxide, tetrapropylammonium hydroxide, tetrabutylammonium hydroxide, benzyltrimethylammonium hydroxide, choline, pyrrole, piperidine, and 1,8-diazabicyclo[5.4.0]-7-undecene (among which organic alkalis are preferable.).

In a case where the alkali developer is used, the development is generally followed by a washing treatment with water.

The present invention is basically configured as described above. Although the method for producing a laminate, the method for producing an antenna-in-package, the laminate, and the composition according to the embodiment of the present invention have been described in detail above, the present invention is not limited to the above-mentioned embodiments, and various modifications and changes can be made without departing from the spirit and scope of the present invention.

Examples

Hereinafter, features of the present invention will be described in more detail with reference to examples. The materials, reagents, amounts and ratios of substances, operations, and the like shown in the following examples can be appropriately changed without departing from the spirit and scope of the present invention. Therefore, the scope of the present invention is not limited to the following examples.

In the present examples, the attenuation of the electromagnetic wave having a frequency of 60 GHz due to electromagnetic wave shielding was evaluated.

An antenna and a dummy pattern showing a semiconductor element were disposed on a substrate.

The antenna was a square having a side of 1.25 mm. The dummy pattern was composed of a square copper patch having a side of 10 mm. The distance between the antenna and the dummy pattern was set to 24 mm. A magnetic pattern portion was provided between the antenna and the dummy pattern. The magnetic pattern portion was set to a value of a multiple based on a width of 1.25 mm and an interval of 1.25 mm.

Next, the attenuation due to electromagnetic wave shielding will be described.

[Attenuation due to electromagnetic wave shielding]

A receiving patch antenna of the same size was disposed at the position of the transmitting antenna and the dummy pattern, and using an Agilent E8361 PNA network analyzer through a cascade probe, the attenuation of the electromagnetic wave having a frequency of 60 GHz due to electromagnetic wave shielding was measured as an attenuation rate (-dB) of the electromagnetic waves having a frequency of 60 GHz.

The attenuation (dB) due to electromagnetic wave shielding was evaluated according to the evaluation standards shown below.

Evaluation standards

A: -40 dB or more
B: Less than -40 dB to -30 dB or more
C: Less than -30 dB to -20 dB or more
D: Less than -20 dB

<Example 1 to Example 11 and Comparative Example 1 to Comparative Example 3>

Various components shown in Table 1 were mixed to prepare each composition.

Individual components used are as follows.

(Magnetic particles)

· Barium ferrite: synthesized by the following method

400.0 g of water kept at a liquid temperature of 35°C was stirred, and then a raw material aqueous solution prepared by dissolving 57.0 g of iron (III) chloride hexahydrate [$FeCl_3$ ▪ $6H_2O$], 25.4 g of barium chloride dihydrate [$BaCl_2$ ▪ $2H_2O$], and 10.2 g of aluminum chloride hexahydrate [$AlCl_3$ ▪ $6H_2O$] in 216.0 g of water, and a solution prepared by adding 113.0 g of water to 181.3 g of a sodium hydroxide aqueous solution having a concentration of 5 mol/L were all added to the water being stirred at a flow rate of 10 mL/min at the same timing of addition to obtain a first liquid.

Next, the liquid temperature of the first liquid was set to 25°C, and then 39.8 g of a sodium hydroxide aqueous solution having a concentration of 1 mol/L was added thereto in a state where the liquid temperature was kept at that temperature to obtain a second liquid. The pH of the obtained second liquid was 10.5 $\pm$ 0.5. The pH was measured using a desktop pH meter (F-71, manufactured by Horiba, Ltd.).

Next, the second liquid was stirred for 15 minutes to obtain a liquid containing a precipitate serving as a precursor of magnetoplumbite type hexagonal ferrite (precursor-containing liquid).

Next, the precursor-containing liquid was subjected to a centrifugation treatment (rotation speed: 2,000 revolutions per minute (rpm), rotation time: 10 minutes) three times, and the resulting precipitate was recovered and washed with water.

Next, the recovered precipitate was dried in an oven having an internal atmospheric temperature of 95°C for 12 hours to obtain a powder of the precursor.

Next, the powder of the precursor was placed in a muffle furnace, the temperature in the furnace was set to 1,100°C, and the powder of the precursor was fired for 4 hours in an air atmosphere to obtain a lumpy fired body.

Next, the obtained fired body was crushed for 90 seconds using a cutter mill (WONDER CRUSHER WC-3, manufactured by Osaka Chemical Co., Ltd.) as a crusher, setting a variable speed dial of the crusher to "5" (rotation speed: about 10,000 to 15,000 rpm) to obtain a magnetic powder.

The crystal structure of the magnetic body constituting each of the above-mentioned magnetic powders was identified by X-ray diffraction analysis. An X'Pert Pro (manufactured by Malvern Panalytical Ltd.), which is a powder X-ray diffractometer, was used as a measurement device. The measurement conditions are shown below.

- Measurement conditions -

X-ray source: CuK$\alpha$ ray
[wavelength: 1.54 Å (0.154 nm), output: 40 mA, 45 kV]
Scan range: 20° < 2$\theta$ < 70°
Scan interval: 0.05°
Scan speed: 0.75 °/min

As a result of the X-ray diffraction analysis, it was confirmed that the obtained magnetic powder was a powder of single-phase magnetoplumbite type hexagonal ferrite having a magnetoplumbite type crystal structure, and containing no crystal structure other than the magnetoplumbite type crystal structure.

(Dispersing agent)

· X-1: a resin represented by the following structural formula. The numerical value in each repeating unit in the following formulae represents the content (% by mass) of each repeating unit with respect to all the repeating units.

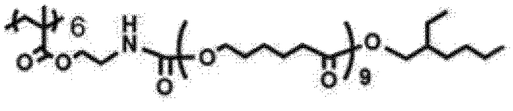 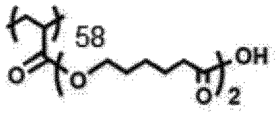

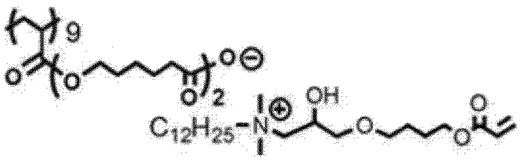 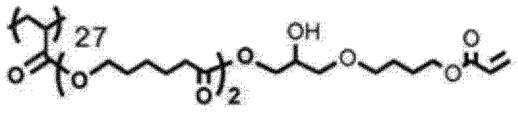

· X-2: a resin represented by the following structural formula. The numerical value in each repeating unit in the following formulae represents the content (% by mass) of each repeating unit with respect to all the repeating units.

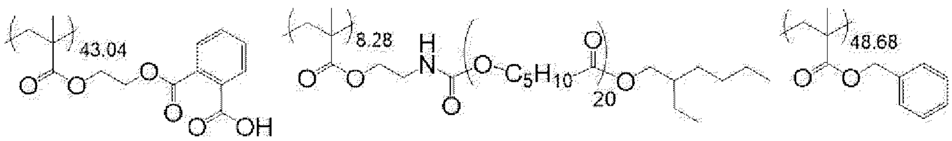

(Alkali-soluble resin)

· B-1: a resin represented by the following structural formula. The numerical value in each repeating unit in the following formulae represents the content (% by mass) of each repeating unit with respect to all the repeating units.

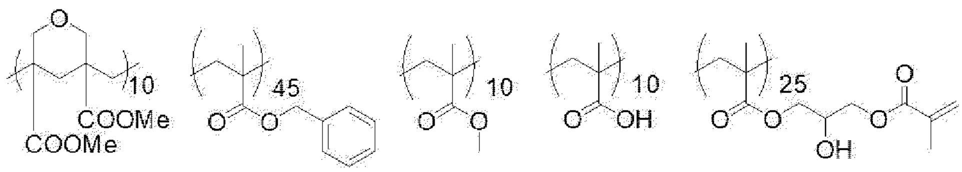

· B-2: Cyclomer P (ACA) 230AA (manufactured by Daicel Corporation)
· B-3: a resin represented by the following structural formula. The numerical value in each repeating unit in the following formulae represents the content (% by mass) of each repeating unit with respect to all the repeating units.

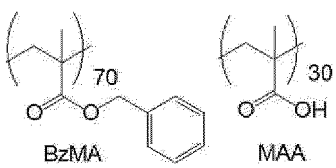

BzMA MAA

(Polymerization initiator)

· KAYARAD DPHA (a mixture of dipentaerythritol hexaacrylate and dipentaerythritol pentaacrylate, manufactured by Nippon Kayaku Co., Ltd.)
· KAYARAD RP-1040 (tetrafunctional acrylate, manufactured by Nippon Kayaku Co., Ltd.)
· NK ESTER A-TMMT (polyfunctional acrylate, manufactured by Shin-Nakamura Chemical Co., Ltd.)

(Polymerization initiator)

· IRGACURE OXE-01 (an oxime ester-based initiator, manufactured by BASF SE)
· IRGACURE OXE-03 (an oxime ester-based initiator, manufactured by BASF SE)

(Antioxidant)

- p-methoxyphenol (manufactured by Sanritsu Chemy)
- ADEKA STAB AO-80 (a compound having the following structure, manufactured by ADEKA Corporation)

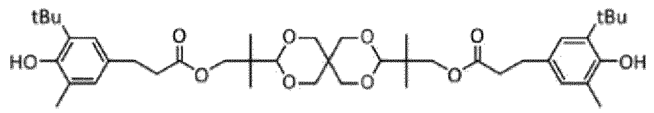

(Surfactant)

- KF-6001 (both-terminal carbinol-modified polydimethylsiloxane, hydroxyl value: 62 mgKOH/g, manufactured by Shin-Etsu Chemical Co., Ltd.)
- POLYFOX PF6320 (a fluorine-based surfactant, manufactured by OMNOVA Solutions Inc.)

(Solvent)

· Propylene glycol monomethyl ether acetate (PGMEA)

The composition prepared above was applied onto a substrate on which an antenna was disposed to form a composition layer. Then, the composition layer was subjected to a drying treatment at 100°C for 2 minutes. The coating amount of the composition was adjusted so that the thickness of the composition layer was the thickness of the magnetic pattern portion shown in Table 1.
Next, the composition layer was subjected to an exposure treatment under the condition of 10 $mJ/cm^2$ with a simple USHIO exposure device through a mask having a predetermined opening portion so that a magnetic pattern portion as shown in Fig. 13 was formed.
The exposure was followed by a shower development treatment at 23°C for 60 seconds using a simple development device (manufactured by Mikasa Corporation). An aqueous solution having a content of tetramethylammonium hydroxide (TMAH) of 0.3% by mass was used as the developer.
After the development, a spin shower rinsing treatment with pure water was carried out, followed by spin drying and then a heat treatment (post-baking) for 5 minutes using a hot plate at 220°C to form a magnetic pattern portion having a predetermined shape.
It should be noted that no magnetic particles were used in Comparative Example 1. In addition, since no polymerizable compound was used in Comparative Example 2, the composition layer was completely removed during the development treatment, and therefore no magnetic pattern portion was formed.
In addition, in Comparative Example 3, the development treatment was carried out without carrying out the exposure treatment. Therefore, the composition layer was completely removed during the development treatment, and thus no magnetic pattern portion was formed.
In Table 1, the "Pattern" represents a drawing number representing the shape of the magnetic pattern portion. In Comparative Example 2 and Comparative Example 3, "No pattern" was given because no magnetic pattern portion was formed.
In Table 1, "Magnetic particle size" represents an average primary particle diameter of magnetic particles.
In Table 1, "Thickness" represents a thickness of a magnetic pattern portion to be formed.
In Table 1, "L/S resolution" represents a minimum pattern size that a photosensitive magnetic composition can form with a simple USHIO exposure device.

[Table 1]

| | | Example 1 | Example 2 | Example 3 | Example 4 | Example 5 | Example 6 | Example 7 | Example 8 | Example 9 | Example 10 | Example 11 | Comparative Example 1 | Comparative Example 2 | Comparative Example 3 |
|---|---|---|---|---|---|---|---|---|---|---|---|---|---|---|---|
| Magnetic particle | Barium ferrite | 39.23 | 39.23 | 39.23 | 39.23 | 39.23 | 39.23 | 39.23 | 39.23 | | 39.23 | 39.23 | - | - | - |
| Dispersing agent | X-1 | 7.06 | 7.06 | 7.06 | | 7.06 | 7.06 | 7.06 | 7.06 | 7.06 | 7.06 | 7.06 | 7.06 | 7.06 | 7.06 |
| | X-2 | | | | 7.06 | | | | | | | | | | |
| Alkali-soluble resin | B-1 | 3.24 | 1.74 | 4.24 | | 3.24 | 3.24 | 3.24 | 3.24 | 3.24 | 3.24 | 3.24 | 3.24 | - | 3.24 |
| | B-2 | | | | 3.24 | | | | | | | | | | |
| | B-3 | | | | | | | | | | | | | | |
| Polymerizable compound | KAYARAD DPHA | 15.05 | 16.55 | 14.05 | 15.05 | | | 15.05 | 15.05 | 15.05 | 15.05 | 15.05 | 15.05 | - | 15.05 |
| | KAYARAD RP-1040 | | | | | 15.05 | | | | | | | | | |
| | NK ESTER A-TMMT | | | | | | 15.05 | | | | | | | | |
| Polymerization initiator | IRGACURE OXE-01 | 3.76 | 3.76 | 3.76 | 3.76 | 3.76 | 3.76 | 3.76 | 3.76 | 3.76 | 3.76 | 3.76 | 3.76 | - | 3.76 |
| | IRGACURE OXE-03 | | | | | | | | | | | | | | |
| Antioxidant | p-Methoxyphenol | 0.01 | 0.01 | 0.01 | 0.01 | 0.01 | 0.01 | | | 0.01 | 0.01 | 0.01 | 0.01 | - | 0.01 |
| | ADEKA STAB AO-80 | | | | | | | 0.01 | 0.01 | | | | | - | |
| Surfactant | KF-6001 | 0.04 | 0.04 | 0.04 | 0.04 | 0.04 | 0.04 | 0.04 | | 0.04 | 0.04 | 0.04 | 0.04 | 0.04 | 0.04 |
| | POLYFOX PF6320 | | | | | | | | 0.04 | | | | | | |
| Solvent | PGMEA | 31.61 | 31.61 | 31.61 | 31.61 | 31.61 | 31.61 | 31.61 | 31.61 | 31.61 | 31.61 | 31.61 | 31.61 | 31.61 | 31.61 |
| Pattern | | Fig. 13 | Fig. 13 | Fig. 13 | Fig. 13 | Fig. 13 | Fig. 13 | Fig. 13 | Fig. 13 | Fig. 13 | Fig. 13 | Fig. 13 | Fig. 13 | No pattern | No pattern |
| Magnetic particle size | | 100 nm | 100 nm | 100 nm | 100 nm | 100 nm | 100 nm | 100 nm | 100 nm | 100 nm | 1500 nm | 100 nm | None | 100 nm | 100 nm |
| Film thickness | | 20 µm | 20 µm | 20 µm | 20 µm | 20 µm | 20 µm | 20 µm | 20 µm | 20 µm | 100 µm | 400 µm | 20 µm | 20 µm | 20 µm |
| L/S resolution | | 100 µm | 100 µm | 100 µm | 100 µm | 100 µm | 100 µm | 100 µm | 100 µm | 100 µm | 600 µm | 1000 µm | 100 µm | No pattern | No pattern |
| Evaluation | Attenuation due to electromagnetic wave shielding | B | B | B | B | B | B | B | B | B | C | C | D | D | D |

As shown in Table 1, it was confirmed that a desired effect could be obtained by the method for producing a laminate according to the embodiment of the present invention.
Above all, from the comparison of Example 1 with Example 10, it was confirmed that a more excellent effect was obtained in a case where the magnetic particles contained at least one metal atom selected from the group consisting of Fe, Ni, and Co, and had an average primary particle diameter of 20 to 1,000 nm.
In addition, from the comparison of Example 1 with Example 11, it was confirmed that a more excellent effect was obtained in a case where the thickness of the magnetic pattern portion was 300 μm or less.

<Example 12 to Example 46>

A laminate having a magnetic pattern portion was produced in the same manner as in Example 1, except that the type of the pattern, the average primary particle diameter of the magnetic particles, and the film thickness of the magnetic pattern portion were changed as shown in a table which will be described later.
The results of each of Examples are summarized in a table which will be described later.
Example 12 was configured to have a magnetic pattern portion shown in Fig. 18. The width of a pattern portion 53 and the width of a notched portion 53a were set to 1.25 mm, and the pattern portions 53 were disposed on a virtual square 53b having a side length of 14 mm. In addition, the outer diameter of the pattern portion 53 was set to 7 mm.
Example 13 was configured to have a magnetic pattern portion shown in Fig. 19. Example 13 was the same as Example 12, except that the number of pattern portions 53 was different from that of Example 12.
Example 14 was configured to have a magnetic pattern portion shown in Fig. 20. In Example 14, a distance Lc was set to 10 mm. The pattern portion 53 was the same as that of Example 12.
Example 15 was configured to have a magnetic pattern portion shown in Fig. 21. In Example 15, the distance Lc was set to 10 mm. The outer diameter of a magnetic pattern portion 58 was set to 7 mm.
Example 16 was configured to have a magnetic pattern portion shown in Fig. 22. In Example 16, the distance Lc was set to 10 mm. The diameter of a magnetic pattern portion 60 was set to 7 mm.
Example 17 was configured to have a magnetic pattern portion shown in Fig. 14. The width of each of a first pattern portion 50a, a second pattern portion 50b, and a third pattern portion 50c was set to 1.25 mm, and the interval between the pattern portions was set to 1.25 mm.
Example 18 was configured to have a magnetic pattern portion shown in Fig. 15. The width of each of the first pattern portion 50a, the second pattern portion 50b, and the third pattern portion 50c was set to 1.25 mm, and the interval between the pattern portions was set to 2.5 mm.
Example 19 was configured to have a magnetic pattern portion shown in Fig. 16. The width of each of the first pattern portion 50a, the second pattern portion 50b, and the third pattern portion 50c was set to 1.25 mm, and the interval between the pattern portions was set to 3.75 mm.
Example 20 was configured to have a magnetic pattern portion shown in Fig. 17. The width of each of the first pattern portion 50a, the second pattern portion 50b, and the third pattern portion 50c was set to 1.25 mm, and the interval between the pattern portions was set to 5.0 mm.
Example 21 was configured to have a magnetic pattern portion shown in Fig. 14, in which the L/S was set to 1/5. The width of each of the first pattern portion 50a, the second pattern portion 50b, and the third pattern portion 50c was set to 1.25 mm, and the interval between the pattern portions was set to 6.25 mm.
Example 22 was configured to have a magnetic pattern portion shown in Fig. 14, in which the L/S was set to 1/6. The width of each of the first pattern portion 50a, the second pattern portion 50b, and the third pattern portion 50c was set to 1.25 mm, and the interval between the pattern portions was set to 7.5 mm.
Example 23 was configured to have a magnetic pattern portion shown in Fig. 14, in which the L/S was set to 1/7. The width of each of the first pattern portion 50a, the second pattern portion 50b, and the third pattern portion 50c was set to 1.25 mm, and the interval between the pattern portions was set to 8.75 mm.
Example 24 was configured to have a magnetic pattern portion shown in Fig. 4, in which the width of a magnetic pattern portion 30 was set to 1.25 mm, and the inner diameter of the magnetic pattern portion 30 was set to 14 mm.
Example 25 was configured to have a magnetic pattern portion shown in Fig. 5, in which the width of each of a first pattern portion 32a and a second pattern portion 32b was set to 1.25 mm, and the interval between the pattern portions was set to 1.25 mm. The inner diameter of the first pattern portion 32a was set to 14 mm, and the outermost diameter of the second pattern portion 32b was set to 21.5 mm.
Example 26 was configured to have a magnetic pattern portion shown in Fig. 6, in which the width of each of a first pattern portion 34a, a second pattern portion 34b, and a third pattern portion 34c was set to 1.25 mm, and the interval between the pattern portions was set to 1.25 mm. The inner diameter of the first pattern portion 34a was set to 14 mm, and the outermost diameter of the third pattern portion 34c was set to 26.5 mm.
Example 27 was configured to have a magnetic pattern portion shown in Fig. 7, in which the width of each of a first pattern portion 36a, a second pattern portion 36b, a third pattern portion 36c, and a fourth pattern portion 36d was

set to 1.25 mm, and the interval between the pattern portions was set to 1.25 mm. The inner diameter of the first pattern portion 36a was set to 14 mm, and the outermost diameter of the fourth pattern portion 36d was set to 27.5 mm.

Example 28 was configured to have a magnetic pattern portion shown in Fig. 8, in which the width of each of a first pattern portion 38a, a second pattern portion 38b, and a third pattern portion 38c was set to 1.25 mm, and the interval between the pattern portions was set to 1.25 mm. The internal height of the first pattern portion 38a was set to 6.5 mm, and the maximum height of the third pattern portion 38c was set to 25.25 mm.

Example 29 was configured to have a magnetic pattern portion shown in Fig. 9, in which the width of each of a first pattern portion 40a, a second pattern portion 40b, and a third pattern portion 40c was set to 1.25 mm, and the interval between the pattern portions was set to 1.25 mm. The length of the inner side of the first pattern portion 40a was set to 7 mm, and the length of the outer side of the third pattern portion 40c was set to 19.5 mm.

Example 30 was configured to have a magnetic pattern portion shown in Fig. 10, in which the width of each of a first pattern portion 42a, a second pattern portion 42b, and a third pattern portion 42c was set to 1.25 mm, and the interval between the pattern portions was set to 1.25 mm. The maximum length inside the first pattern portion 42a was set to 11.55 mm, and the maximum length outside the third pattern portion 42c, that is, the diameter of the circumscribing circle of the third pattern portion 42c was set to 25.60 mm.

Example 31 was configured to have a magnetic pattern portion shown in Fig. 11, in which the width of each of a first pattern portion 44a, a second pattern portion 44b, and a third pattern portion 44c was set to 1.25 mm, and the interval between the pattern portions was set to 1.25 mm. The maximum length inside the first pattern portion 44a was 10.67 mm, and the maximum length outside the third pattern portion 44c was 22.44 mm.

Example 32 was configured to have a magnetic pattern portion shown in Fig. 12, in which the width of each of a first pattern portion 42a, a second pattern portion 42b, and a third pattern portion 42c was set to 1.25 mm, and the interval between the pattern portions was set to 1.25 mm. The maximum length inside the first pattern portion 42a was set to 11.55 mm, and the maximum length outside the third pattern portion 42c, that is, the diameter of the circumscribing circle of the third pattern portion 42c was set to 24.69 mm.

Example 33 was configured to have a magnetic pattern portion shown in Fig. 24. In Example 33, the width of the magnetic pattern portion was set to 1.25 mm, a sub-pattern portion 62d was set to 7.5 mm, a sub-pattern portion 62e was set to 6.25 mm, and a sub-pattern portion 62f was set to 3.75 mm. A pattern portion 62b was set to 12.5 mm, and a pattern portion 62c was set to 13.75 mm.

Example 34 was configured to have a magnetic pattern portion shown in Fig. 25. In Example 34, the width of the magnetic pattern portion was set to 1.25 mm, and each of a length Lt and a length Lw was set to 3.75 mm.

Example 35 was configured to have a magnetic pattern portion shown in Fig. 26. In Example 35, the width of the magnetic pattern portion was set to 1.25 mm, and each of a length Lt and a length Lw was set to 3.75 mm.

Example 36 was configured to have a magnetic pattern portion shown in Fig. 27. In Example 36, the width of the magnetic pattern portion was set to 1.25 mm, and each of a length Lt and a length Lw was set to 3.75 mm.

Example 37 was configured to have a magnetic pattern portion shown in Fig. 29. In Example 37, the width of a pattern portion 70a was set to 1.25 mm, and a length Ld was set to 3.75 mm. In addition, a pitch Pw of the pattern portion 70a in a direction from an antenna 27 toward a semiconductor element 28 was set to 3.13 mm, and a pitch Pt of the pattern portion 70a in a direction orthogonal to the above-mentioned direction was set to 3.59 mm.

Example 38 was configured to have a magnetic pattern portion shown in Fig. 30. In Example 38, each of a length Lt and a length Lw was set to 3.75 mm.

Example 39 was configured to have a magnetic pattern portion shown in Fig. 28. In Example 39, an opening portion 69a was formed into a square having a side length of 5 mm.

Each of Example 40 to Example 46 was configured to have a magnetic pattern portion shown in Fig. 13. Each of Example 40 to Example 46 has a pattern in which three lines and spaces are combined. The width of each of a first pattern portion 48a to a sixth pattern portion 48f was set to 1.25 mm, the interval between the first pattern portion 48a to the third pattern portion 48c was set to 1.25 mm, and the interval between the fourth pattern portion 48d to the sixth pattern portion 48f was set to 1.25 mm. The length of the first pattern portion 48a to the third pattern portion 48c in a direction from the antenna 27 toward the semiconductor element 28 was set to 12 mm. The length of the fourth pattern portion 48d to the sixth pattern portion 48f in a direction orthogonal to the direction from the antenna 27 toward the semiconductor element 28 was set to 25.5 mm. In Example 40 to Example 46, the length in a direction from the antenna 27 toward the semiconductor element 28 was 26.5 mm. In addition, the distance between the first pattern portions 48a facing each other with the antenna 27 interposed therebetween was 14 mm, and the distance between the fourth pattern portions 48d facing each other with the antenna 27 interposed therebetween was 14 mm.

[Table 2]

| | | Example 12 | Example 13 | Example 14 | Example 15 | Example 16 | Example 17 |
|---|---|---|---|---|---|---|---|
| Pattern | | Fig. 18 | Fig. 19 | Fig. 20 | Fig. 21 | Fig. 22 | Fig. 14 |
| Magnetic particle size | | 100 nm | 100 nm | 100 nm | 100 nm | 100 nm | 100 nm |
| Film thickness | | 20 μm | 20 μm | 20 μm | 20 μm | 20 μm | 20 μm |
| L/S resolution | | 100 μm | 100 μm | 100 μm | 100 μm | 100 μm | 100 μm |
| Evaluation | Attenuation due to electromagnetic wave shielding | C | B | B | B | B | B |

[Table 3]

| | | Example 18 | Example 19 | Example 20 | Example 21 | Example 22 | Example 23 |
|---|---|---|---|---|---|---|---|
| Pattern | | Fig. 15 | Fig. 16 | Fig. 17 | Fig. 14 (L/S = 1/5) | Fig. 14 (L/S = 1/6) | Fig. 14 (L/S = 1/7) |
| Magnetic particle size | | 100 nm | 100 nm | 100 nm | 100 nm | 100 nm | 100 nm |
| Film thickness | | 20 μm | 20 μm | 20 μm | 20 μm | 20 μm | 20 μm |
| L/S resolution | | 100 μm | 100 μm | 100 μm | 100 μm | 100 μm | 100 μm |
| Evaluation | Attenuation due to electromagnetic wave shielding | B | B | B | B | B | B |

[Table 4]

| | | Example 24 | Example 25 | Example 26 | Example 27 | Example 28 | Example 29 |
|---|---|---|---|---|---|---|---|
| Pattern | | Fig. 4 | Fig. 5 | Fig. 6 | Fig. 7 | Fig. 8 | Fig. 9 |
| Magnetic particle size | | 100 nm | 100 nm | 100 nm | 100 nm | 100 nm | 100 nm |
| Film thickness | | 20 μm | 20 μm | 20 μm | 20 μm | 20 μm | 20 μm |
| L/S resolution | | 100 μm | 100 μm | 100 μm | 100 μm | 100 μm | 100 μm |
| Evaluation | Attenuation due to electromagnetic wave shielding | B | B | B | A | A | A |

[Table 5]

| | Example 30 | Example 31 | Example 32 | Example 33 | Example 34 | Example 35 |
|---|---|---|---|---|---|---|
| Pattern | Fig. 10 | Fig. 11 | Fig. 12 | Fig. 24 | Fig. 25 | Fig. 26 |
| Magnetic particle size | 100 nm | 100 nm | 100 nm | 100 nm | 100 nm | 100 nm |
| Film thickness | 20 μm | 20 μm | 20 μm | 20 μm | 20 μm | 20 μm |

(continued)

| | | Example 30 | Example 31 | Example 32 | Example 33 | Example 34 | Example 35 |
|---|---|---|---|---|---|---|---|
| L/S resolution | | 100 μm | 100 μm | 100 μm | 100 μm | 100 μm | 100 μm |
| Evaluation | Attenuation due to electromagnetic wave shielding | A | B | B | A | A | A |

[Table 6]

| | | Example 36 | Example 37 | Example 38 | Example 39 | Example 40 | Example 41 |
|---|---|---|---|---|---|---|---|
| Pattern | | Fig. 27 | Fig. 29 | Fig. 30 | Fig. 28 | Fig. 13 | Fig. 13 |
| Magnetic particle size | | 100 nm | 100 nm | 100 nm | 100 nm | 25 nm | 500 nm |
| Film thickness | | 20 μm | 20 μm | 20 μm | 20 μm | 20 μm | 20 μm |
| L/S resolution | | 100 μm | 100 μm | 100 μm | 100 μm | 100 μm | 100 μm |
| Evaluation | Attenuation due to electromagnetic wave shielding | A | B | B | C | B | B |

[Table 7]

| | | Example 42 | Example 43 | Example 44 | Example 45 | Example 46 |
|---|---|---|---|---|---|---|
| Pattern | | Fig. 13 | Fig. 13 | Fig. 13 | Fig. 13 | Fig. 13 |
| Magnetic particle size | | 1000 nm | 100 nm | 100 nm | 100 nm | 100 nm |
| Film thickness | | 20 μm | 20 μm | 50 μm | 100 μm | 300 μm |
| L/S resolution | | 100 μm | 100 μm | 100 μm | 100 μm | 100 μm |
| Evaluation | Attenuation due to electromagnetic wave shielding | B | B | B | B | B |

As shown in Tables 2 to 7, it was confirmed that a desired effect could be obtained by the method for producing a laminate according to the embodiment of the present invention.

Example 12 has a configuration in which four annular pattern portions are disposed around the antenna. Example 13 has a configuration in which eight annular pattern portions are disposed around the antenna, and surround the entire periphery of the antenna. The gap through which electromagnetic waves leak is smaller in Example 13 than in Example 12, and therefore Example 13 has a higher ability to shield electromagnetic waves.

Example 14 to Example 16 have a configuration in which a single row of magnetic pattern portions is provided between the antenna and the dummy pattern, which is not a configuration in which the magnetic pattern portions surround the entire periphery of the antenna. Meanwhile, the gap through which electromagnetic waves leak is smaller than that of Example 12, and therefore an ability to shield electromagnetic wave is higher in Example 14 to Example 16.

Example 17 to Example 23 are so-called line-and-space patterns. An increase in L/S ratio leads to an increase in ability to shield electromagnetic waves in calculation, but no difference is observed in Example 17 to Example 23.

Example 24 is a single annular magnetic pattern portion that surrounds the entire periphery of the antenna, Example 25 is a double annular magnetic pattern portion that surrounds the entire periphery of the antenna, Example 26 is a triple annular magnetic pattern portion that surrounds the entire periphery of the antenna, and Example 27 is a quadruple annular magnetic pattern portion that surrounds the entire periphery of the antenna. From Example 24 to Example 27, the quadruple annular magnetic pattern portion of Example 27 has a high ability to shield electromagnetic

waves.

Example 28 to Example 32 each have a triple polygonal magnetic pattern portion. Among Example 28 to Example 32, Example 28 having a triangular pattern portion, Example 29 having a rectangular pattern portion, and Example 30 having a hexagonal pattern portion have a higher ability to shield electromagnetic waves than Example 26 having a triple annular pattern portion. Examples 31 having an octagonal pattern portion and Example 32 having a decagonal pattern portion have an ability to shield electromagnetic waves equivalent to that of Example 26 having a triple annular pattern portion. This is presumed to be due to the fact that Example 31 and Example 32 have an outer shape of the pattern portion close to a circle, resulting in a decrease in electromagnetic wave absorption power due to the shape of the magnetic pattern portion.

Example 33 to Example 36 have an FSS element-like configuration and exhibit a high ability to shield electromagnetic waves. Example 37 and Example 38 also have a repeating pattern. Example 38 has an FSS element-like configuration, but has a configuration in which continuous magnetic bodies are connected in a direction from an antenna toward a dummy pattern, that is, in a horizontal direction, and exhibits a decreased ability to shield electromagnetic waves, which is, however, higher than that of Example 39 having a beta film configuration.

Example 40 to Example 46 have a pattern configuration in which three lines and spaces are combined, but the three combined lines and spaces are not connected to each other. This leads to the suppression of electromagnetic wave energy transmission and resonance, so that an ability to shield electromagnetic waves is obtained, and an ability to shield electromagnetic waves is high.

Explanation of References

10: laminate
12: substrate
12a: surface
14: array antenna
15, 27: antenna
16: A/D circuit
17: memory
18: ASIC
20: magnetic pattern portion
22: composition layer
24: photo mask
25: mask portion
26: region
28: semiconductor element
30, 32, 34, 36, 37 magnetic pattern portion
32a, 34a, 36a, 37a, 38a, 40a: first pattern portion
32b, 34b, 36b, 37b, 38b, 40b: second pattern portion
34c, 36c, 37c, 38c, 40c: third pattern portion
36d, 48d: fourth pattern portion
37d: notched portion
38, 40, 42, 44: magnetic pattern portion
42a, 44a, 46a, 48a, 50a: first pattern portion
42b, 44b, 46b, 48b, 50b: second pattern portion
42c, 44c, 46c, 48c, 50c: third pattern portion
46, 48, 50, 52, 54: magnetic pattern portion
48e: fifth pattern portion
48f: sixth pattern portion
53: pattern portion
53a: notched portion
53b: virtual square
56, 58, 60, 62: magnetic pattern portion
58a, 60a, 62a, 62b, 62c: pattern portion
62d, 62e, 62f: sub-pattern portion
62g: configuration pattern portion
64, 66, 68, 69, 70, 72: magnetic pattern portion

66a: spiral pattern portion
66b, 68a, 68b, 70a, 72b: pattern portion
69a, 70b, 72a: opening portion
Ld, Lf, Lg, Lh, Lt, Lw: length
Lv: exposure light
Pt, Pw: pitch

**Claims**

1. A method for producing a laminate comprising:

   a step of applying a composition containing magnetic particles and a polymerizable compound onto a substrate on which an antenna is disposed to form a composition layer; and
   a step of subjecting the composition layer to an exposure treatment and a development treatment to form a magnetic pattern portion,
   wherein the magnetic pattern portion is disposed on at least a part of a periphery of the antenna while being spaced apart from the antenna on the substrate.

2. The method for producing a laminate according to claim 1,

   wherein a semiconductor element is further disposed on the substrate, and
   the magnetic pattern portion is disposed between the antenna and the semiconductor element on the substrate.

3. The method for producing a laminate according to claim 1 or 2, wherein the magnetic pattern portion is present on an entire periphery of the antenna.

4. The method for producing a laminate according to any one of claims 1 to 3, wherein a width of the magnetic pattern portion is an integral multiple of 1/4 of a wavelength of an electromagnetic wave transmitted from or received by the antenna.

5. The method for producing a laminate according to any one of claims 1 to 4, wherein the magnetic pattern portion has an interval of an integral multiple of 1/4 of a wavelength of an electromagnetic wave transmitted from or received by the antenna.

6. The method for producing a laminate according to any one of claims 1 to 3, wherein the magnetic pattern portion is composed of a combination of a line and a space, in which each of the line and the space has a width of an integral multiple of a magnitude of 1/4 of a wavelength of an electromagnetic wave transmitted from or received by the antenna.

7. The method for producing a laminate according to any one of claims 1 to 6, wherein a thickness of the magnetic pattern portion is 300 μm or less.

8. The method for producing a laminate according to any one of claims 1 to 7,

   wherein the magnetic particles are magnetic particles containing at least one metal atom selected from the group consisting of Fe, Ni, and Co, and
   an average primary particle diameter of the magnetic particles is 20 to 1,000 nm.

9. A method for producing an antenna-in-package, comprising: the method for producing a laminate according to any one of claims 1 to 8.

10. A laminate comprising:

    a substrate;
    an antenna disposed on the substrate; and
    a magnetic pattern portion disposed on at least a part of a periphery of the antenna while being spaced apart from the antenna.

**11.** A composition for use in forming the magnetic pattern portion in the laminate according to claim 10, the composition comprising:

magnetic particles; and
a polymerizable compound.

FIG. 1

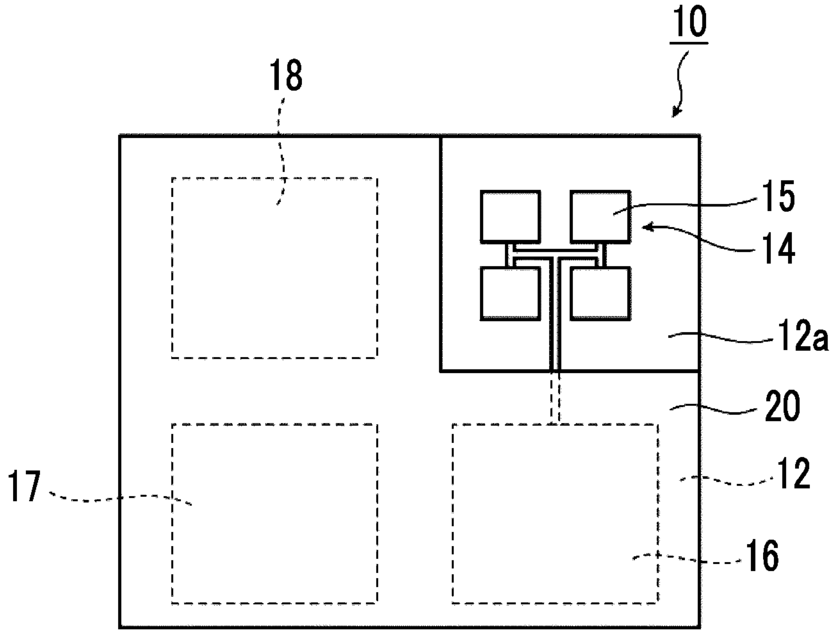


FIG. 2

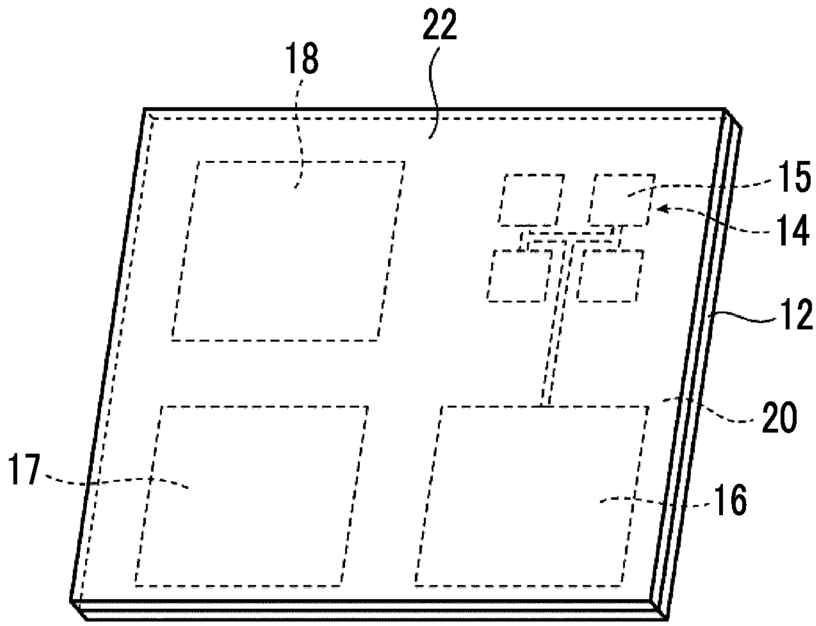

FIG. 3

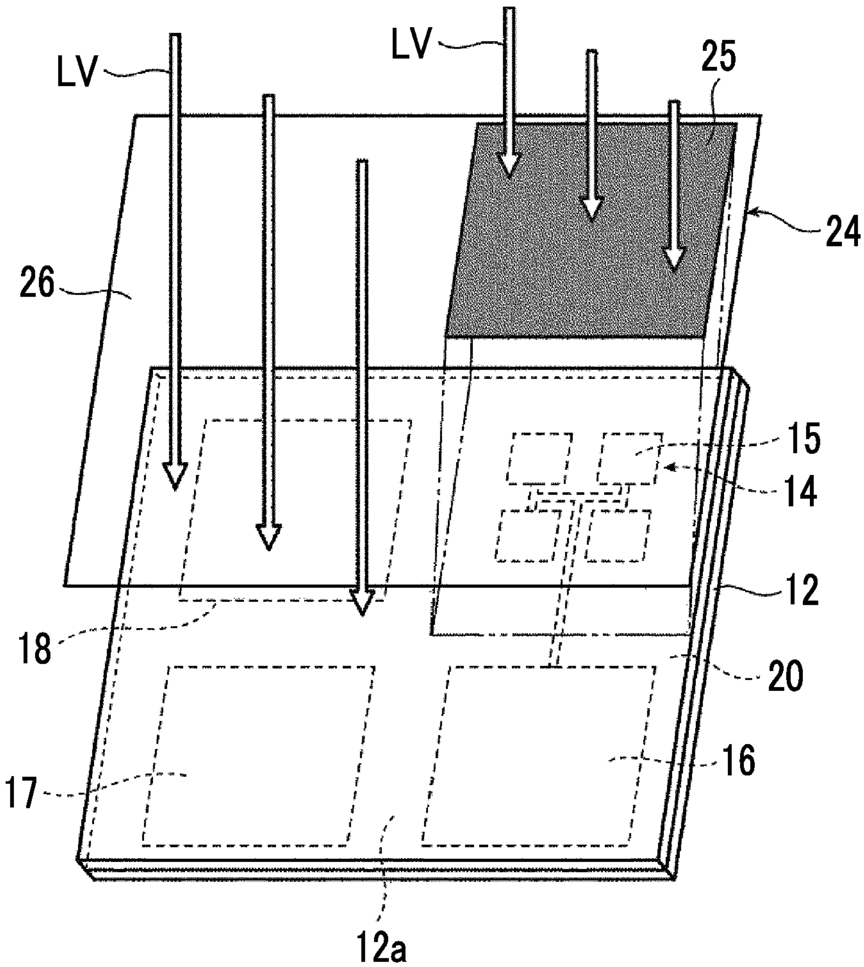

FIG. 4

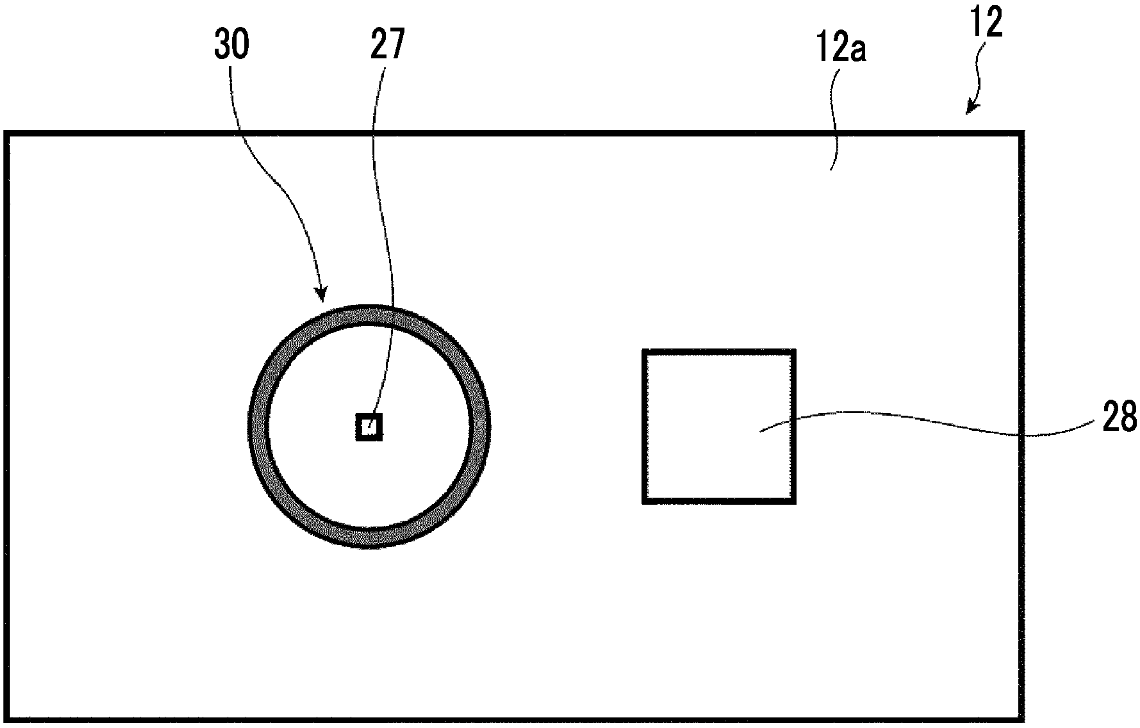


FIG. 5

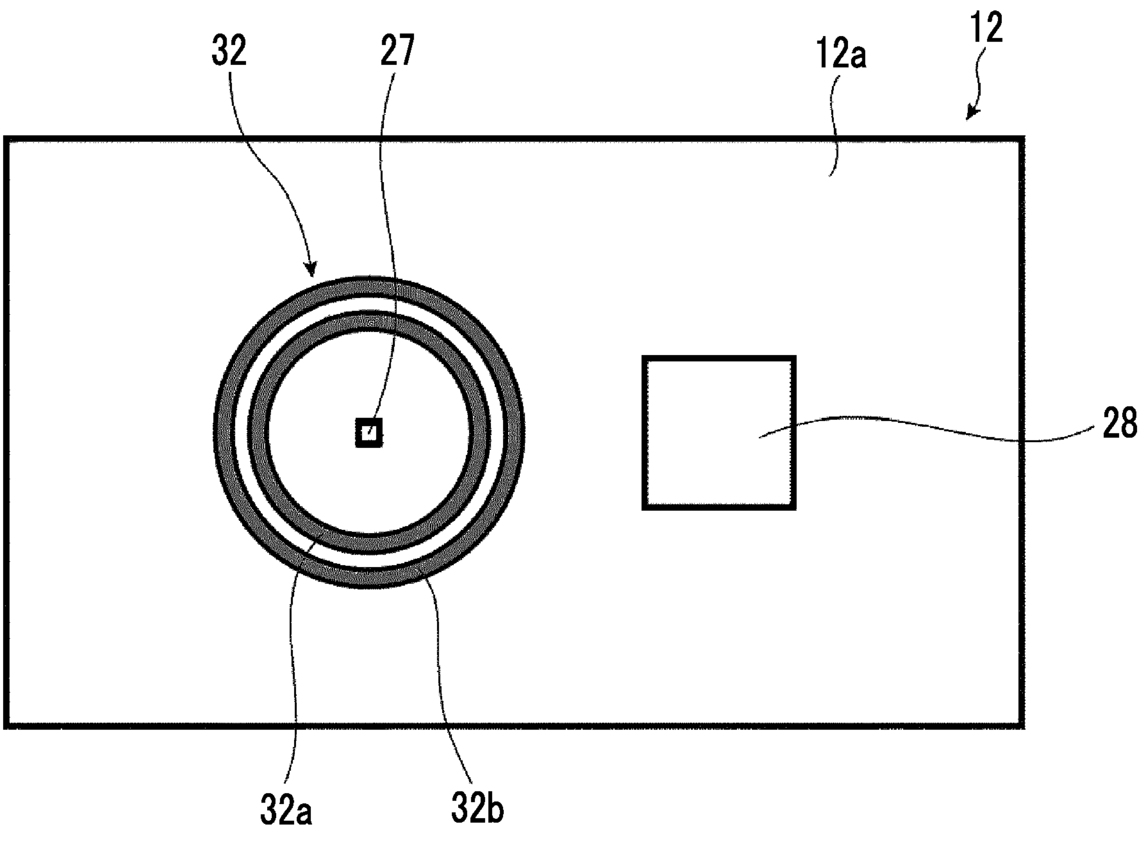

FIG. 6

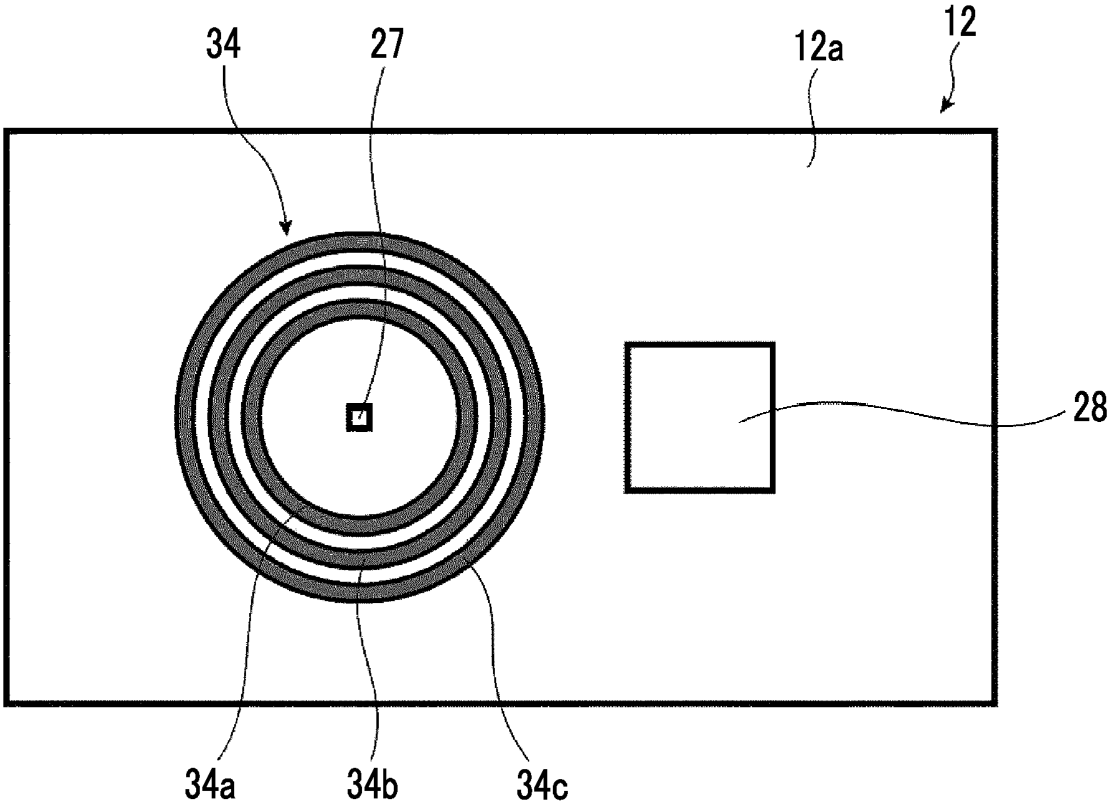


FIG. 7

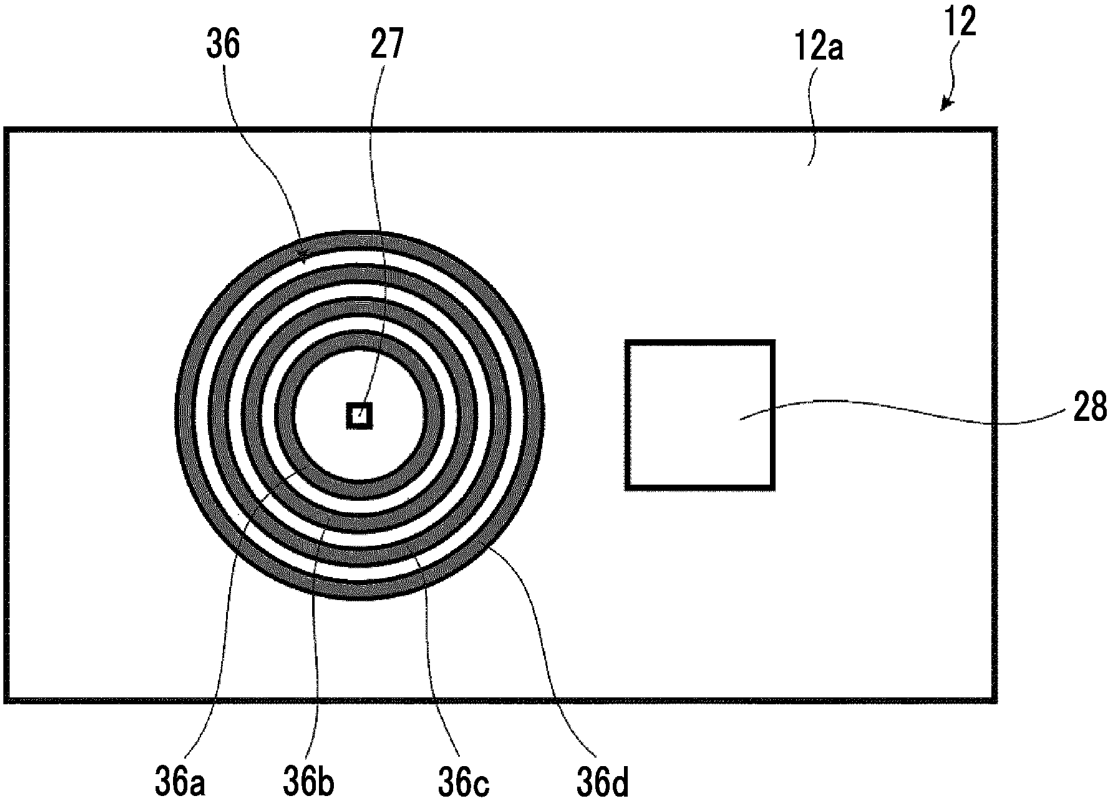

FIG. 8

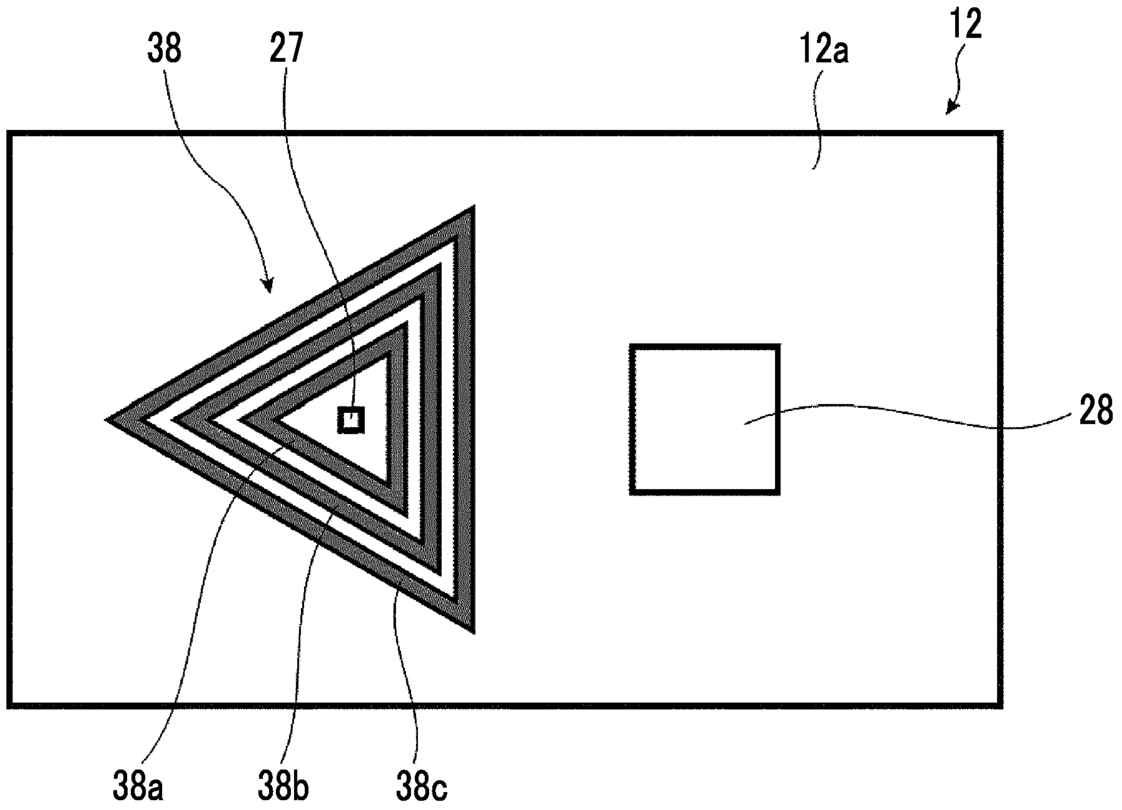


FIG. 9

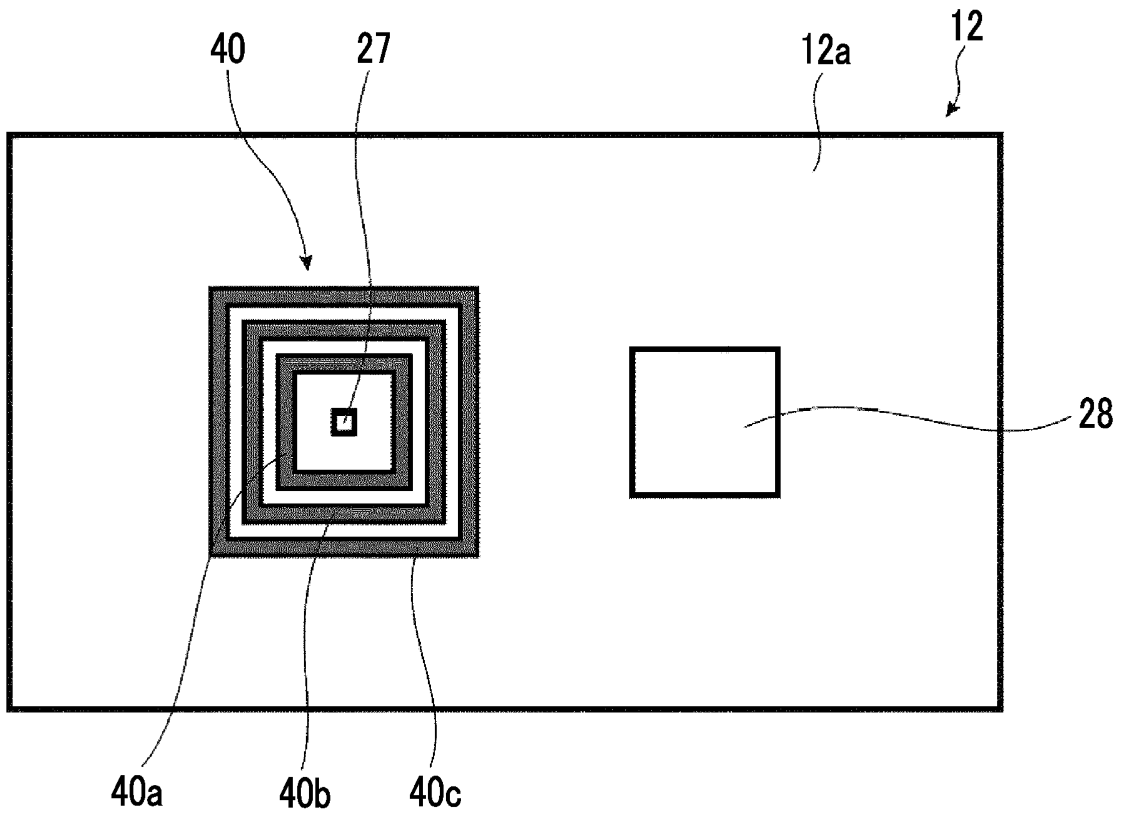

FIG. 10

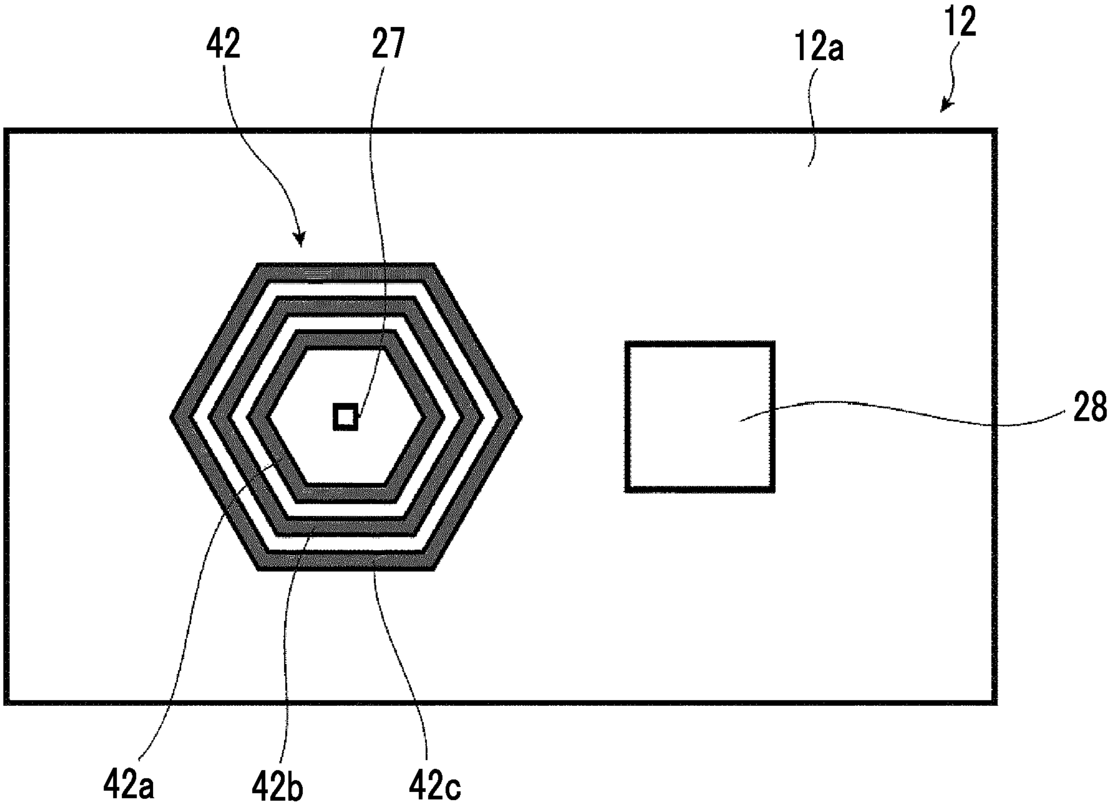


FIG. 11

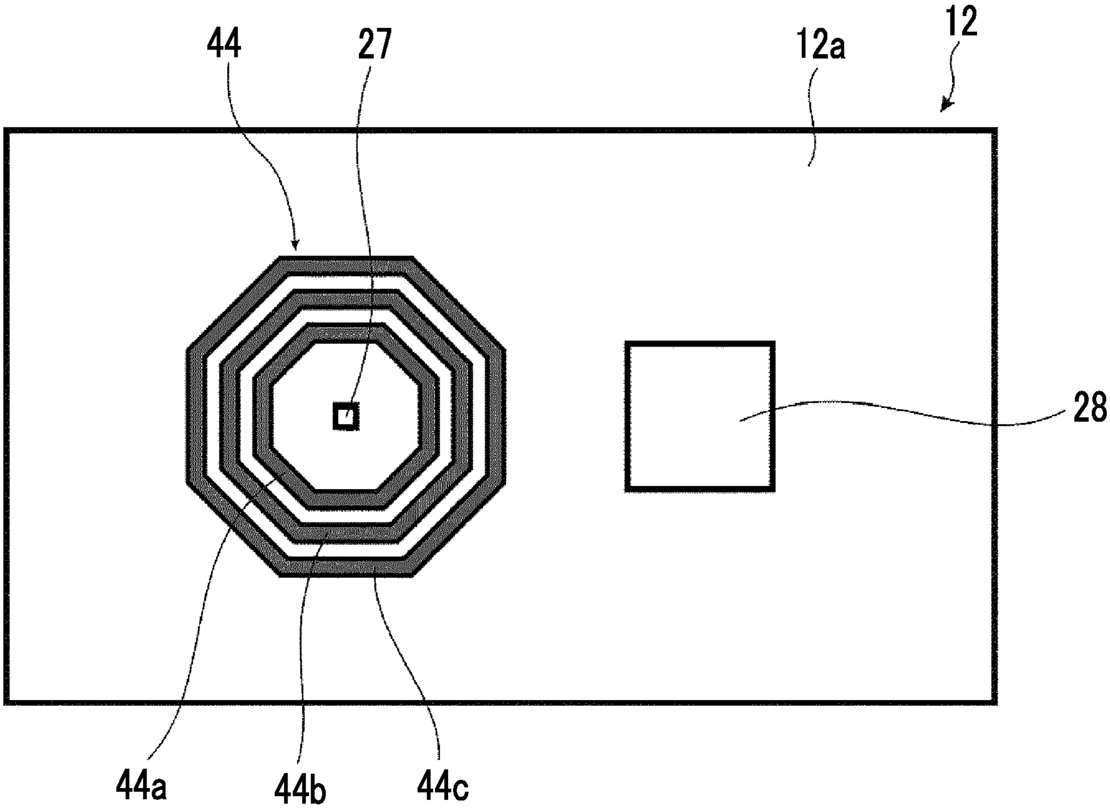

FIG. 12

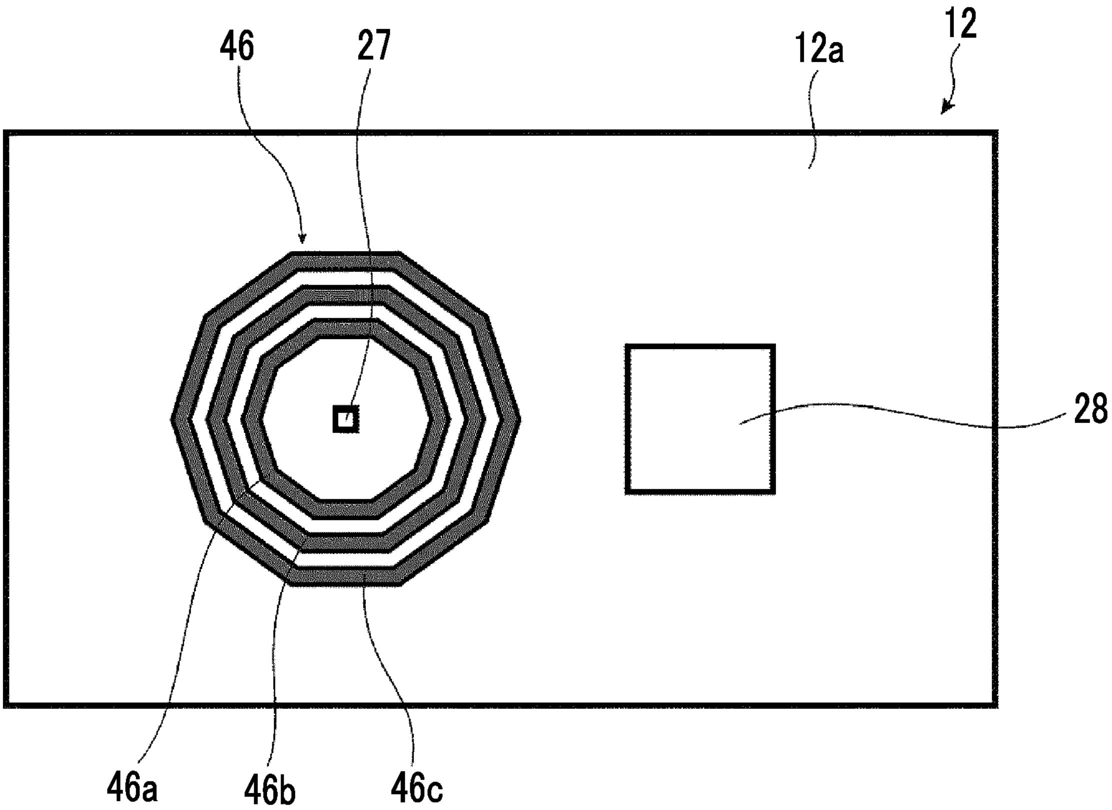
46
27
12a
12
28
46a
46b
46c

FIG. 13

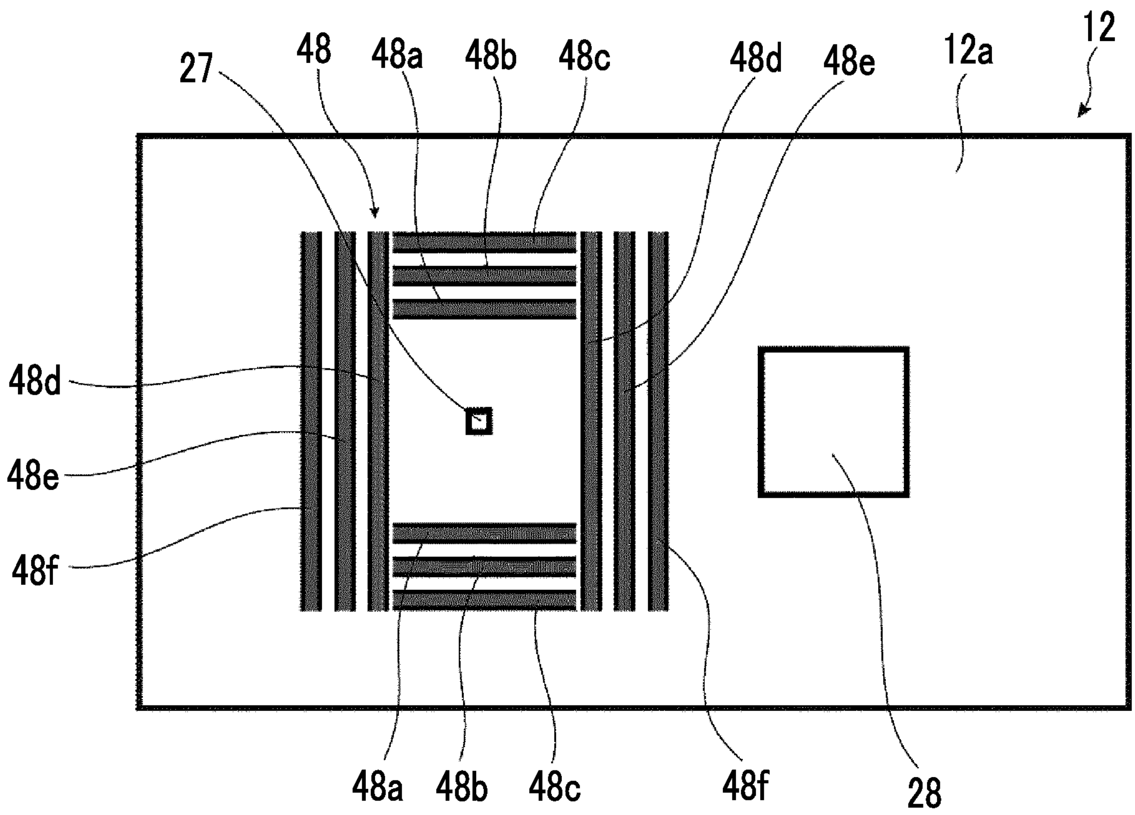
27
48
48a
48b
48c
48d
48e
12a
12
48d
48e
48f
48a
48b
48c
48f
28

FIG. 14

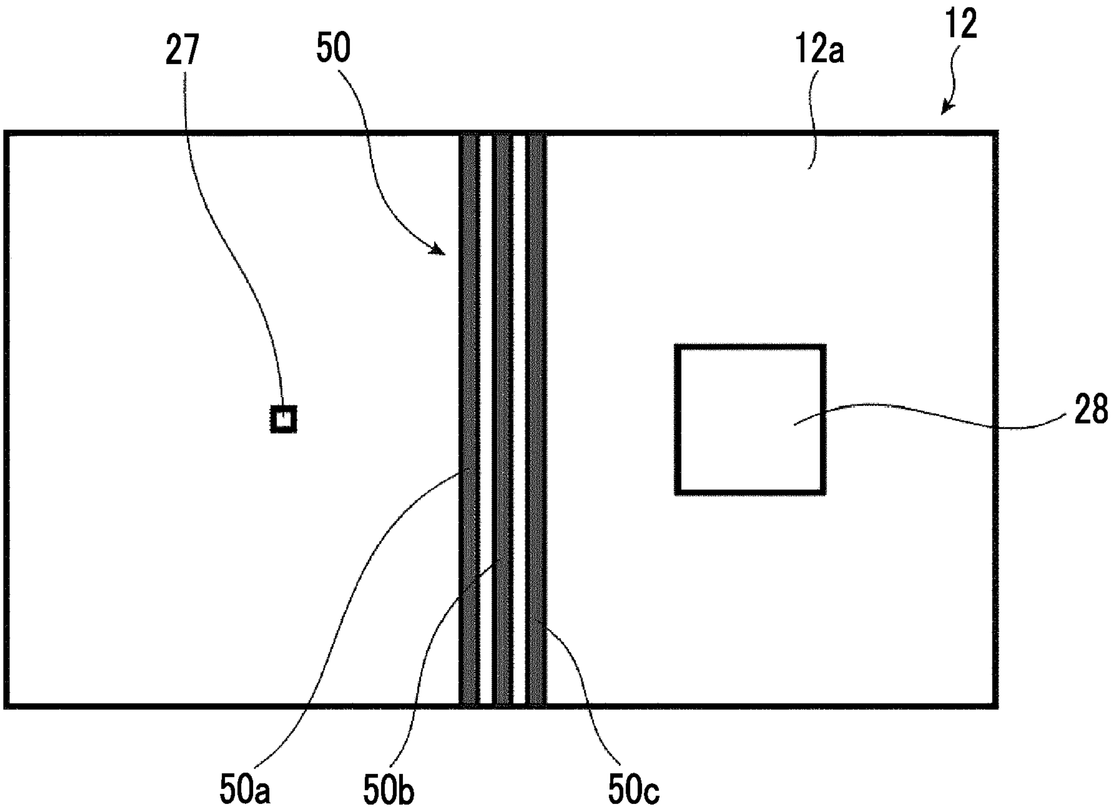


FIG. 15

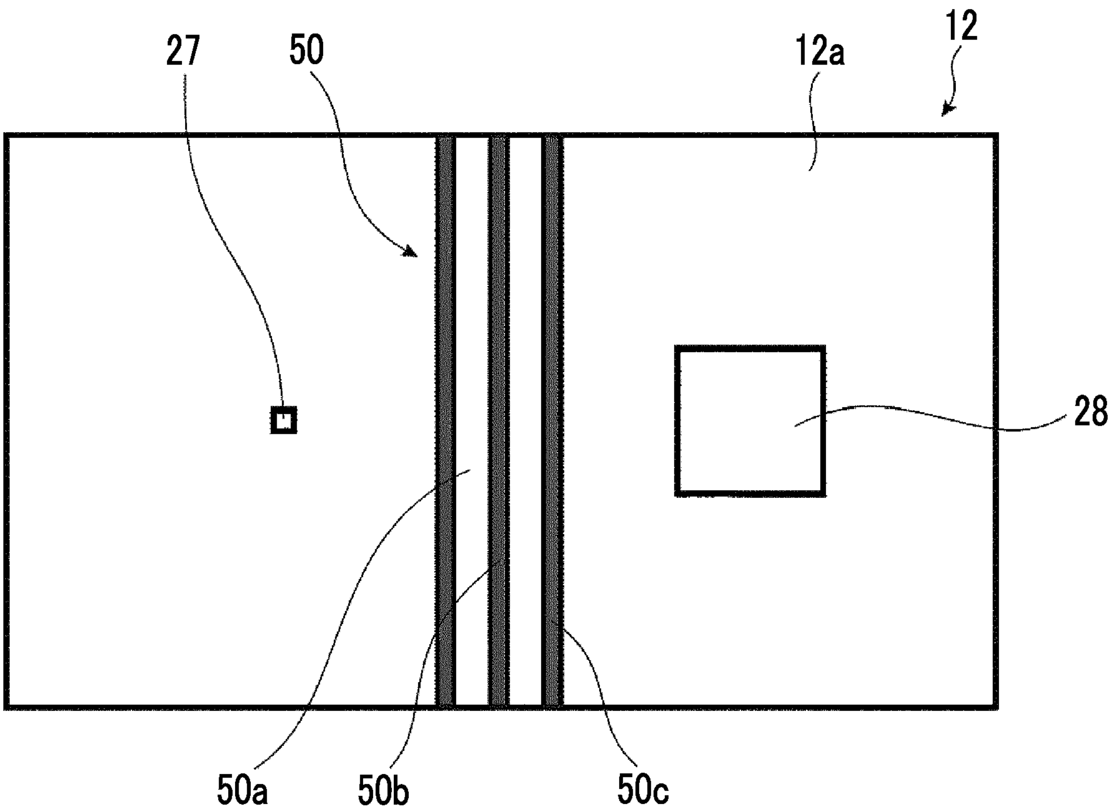

FIG. 16

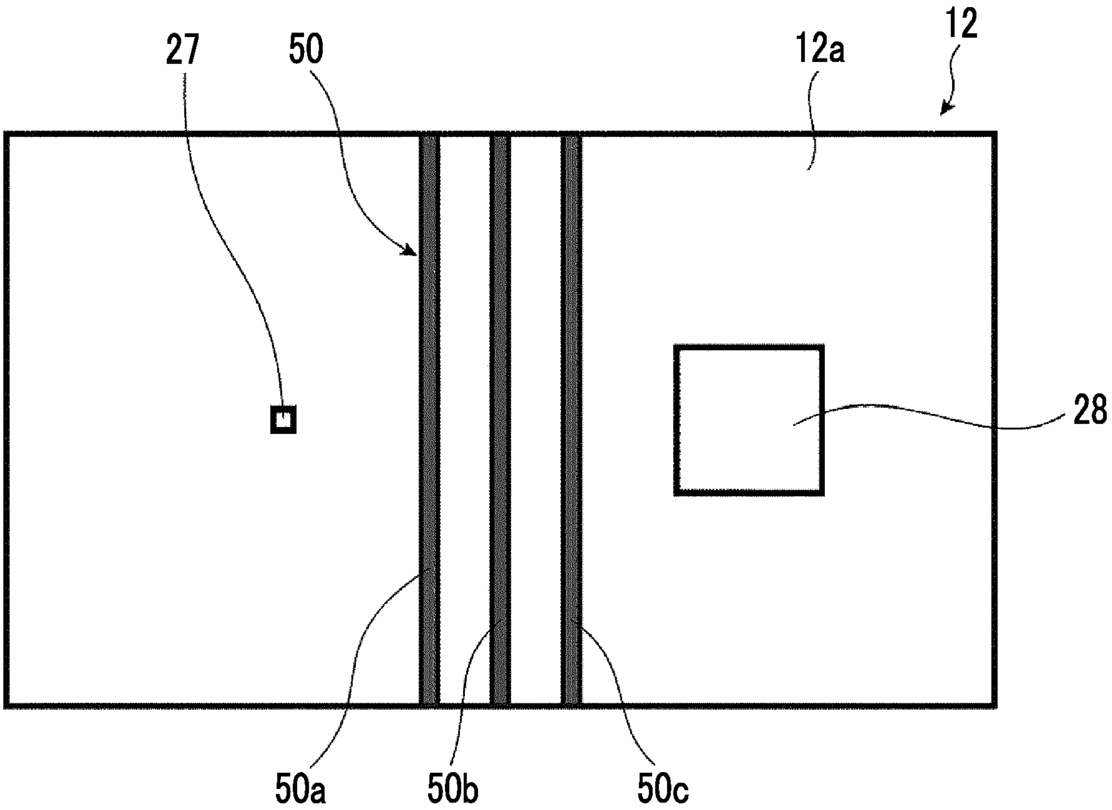


FIG. 17

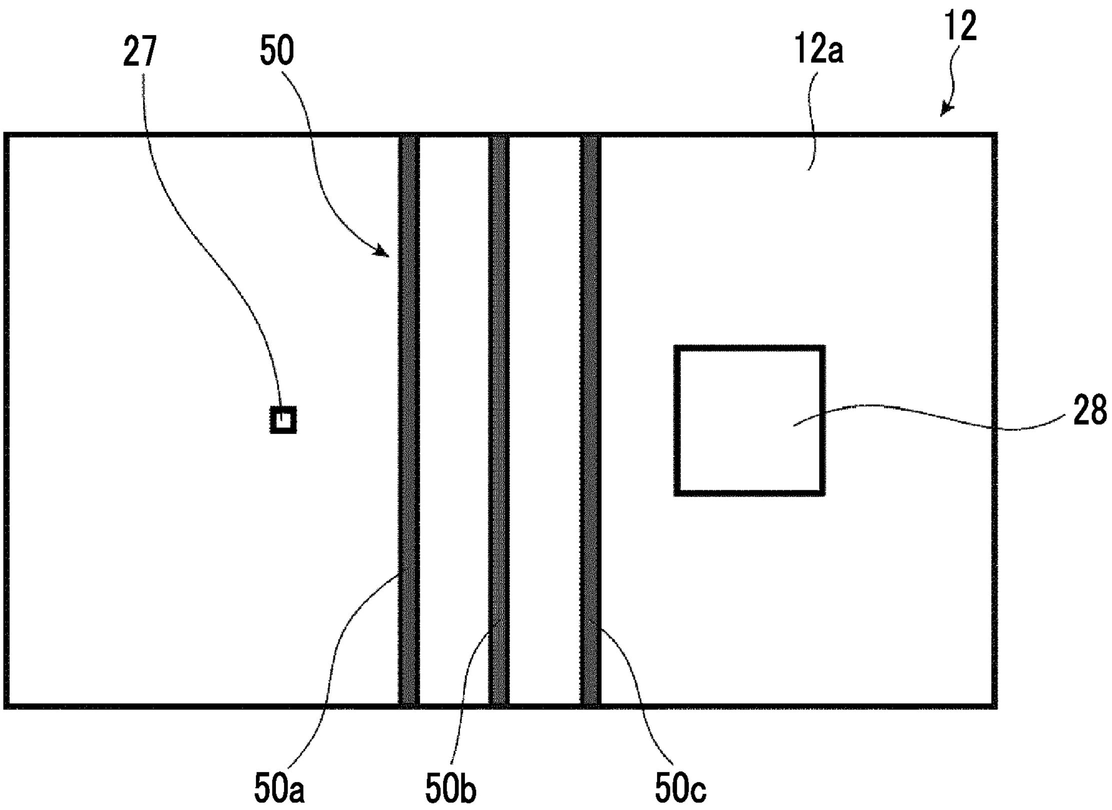

FIG. 18

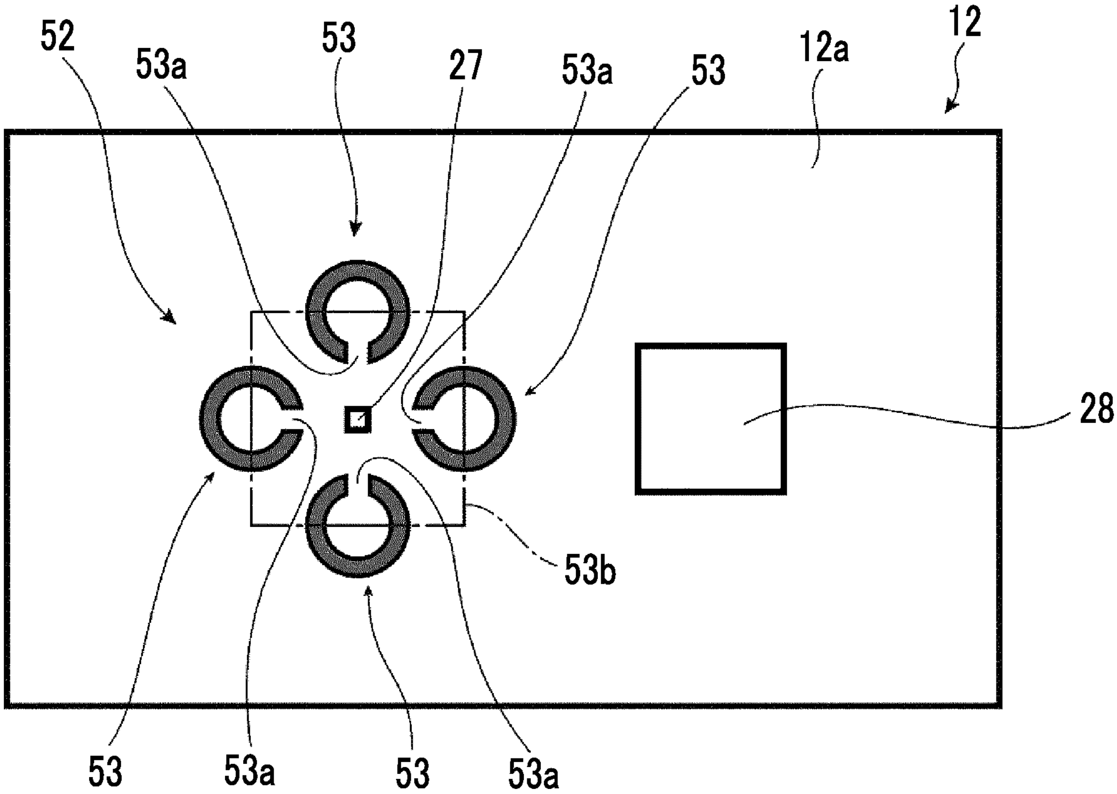
52
53a
53
27
53a
53
12a
12
28
53b
53
53a
53
53a

FIG. 19

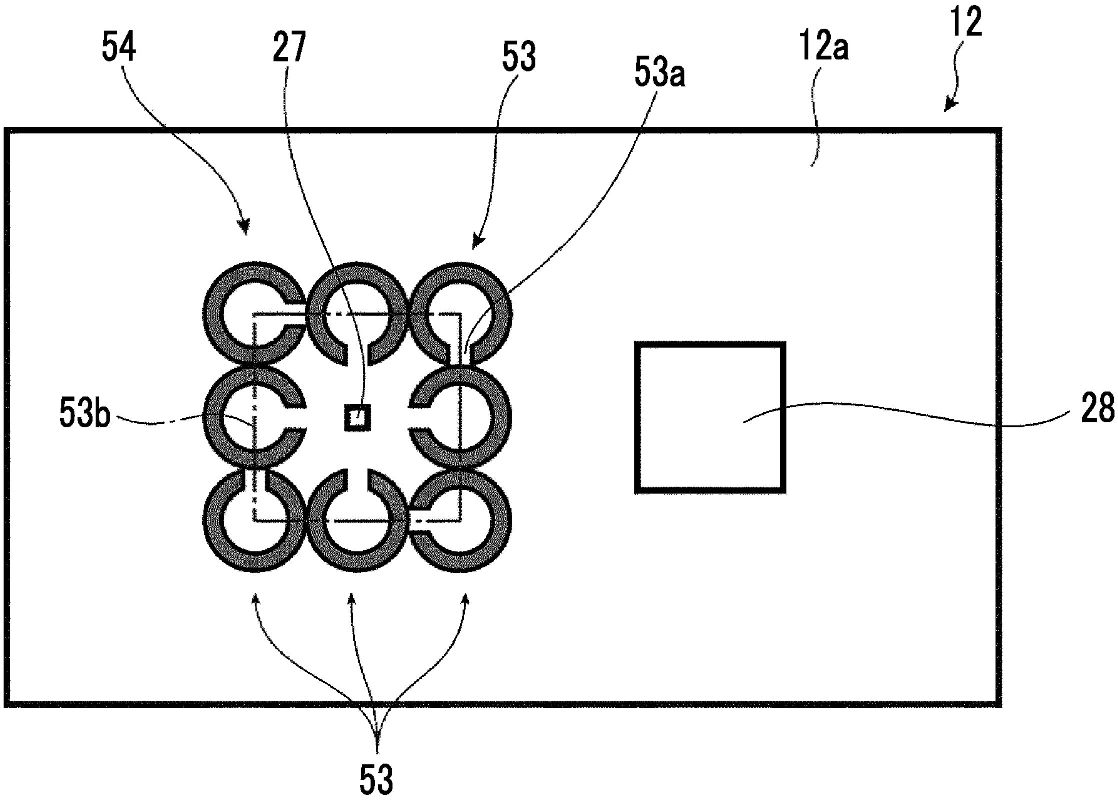
54
27
53
53a
12a
12
53b
28
53

FIG. 20

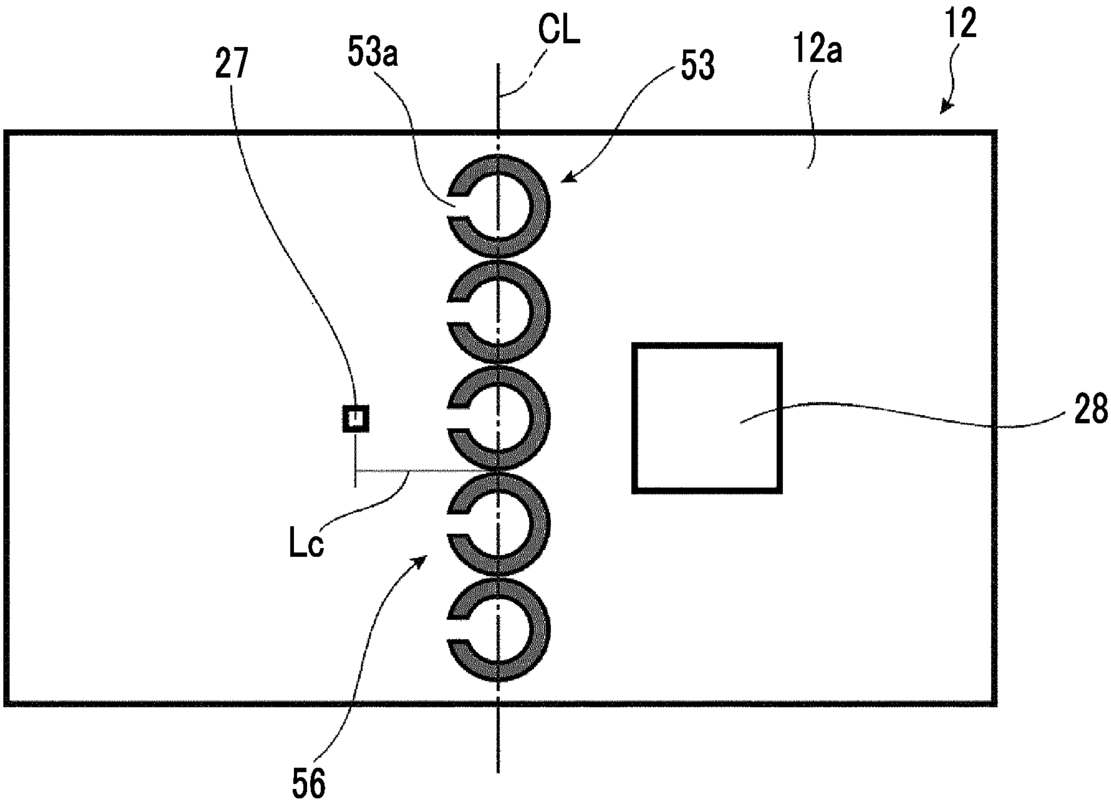


FIG. 21

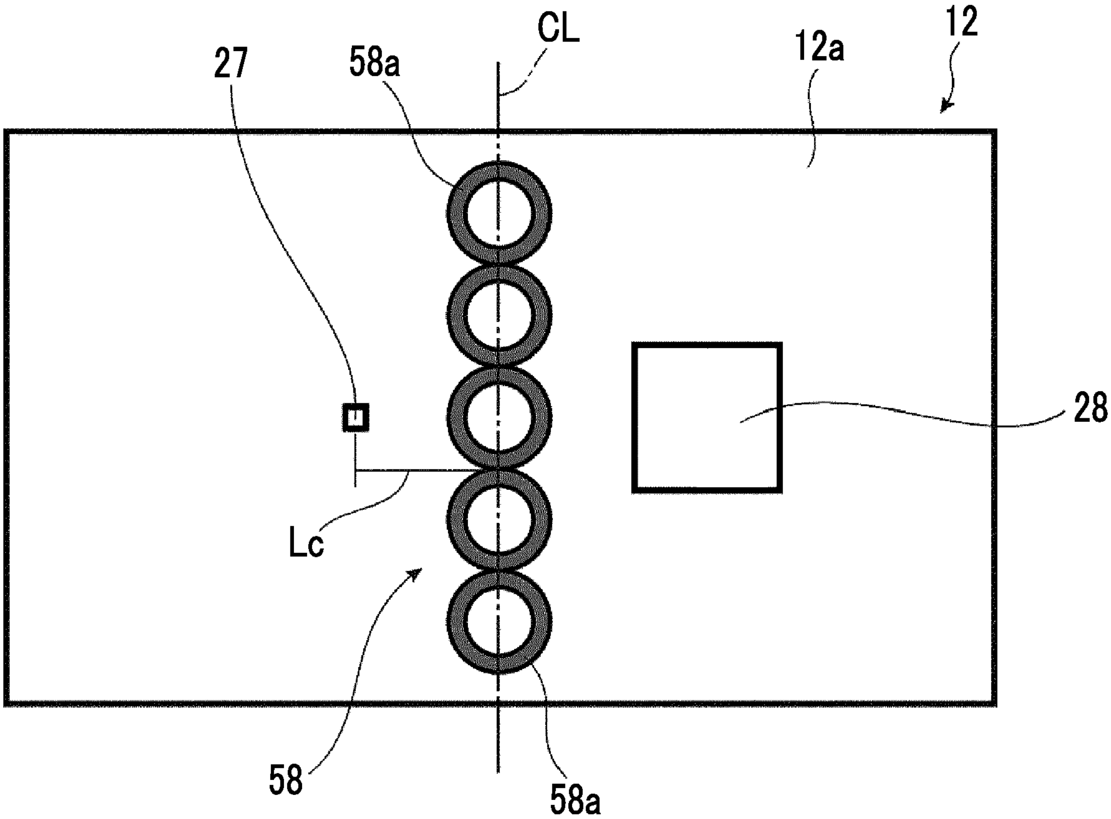

FIG. 22

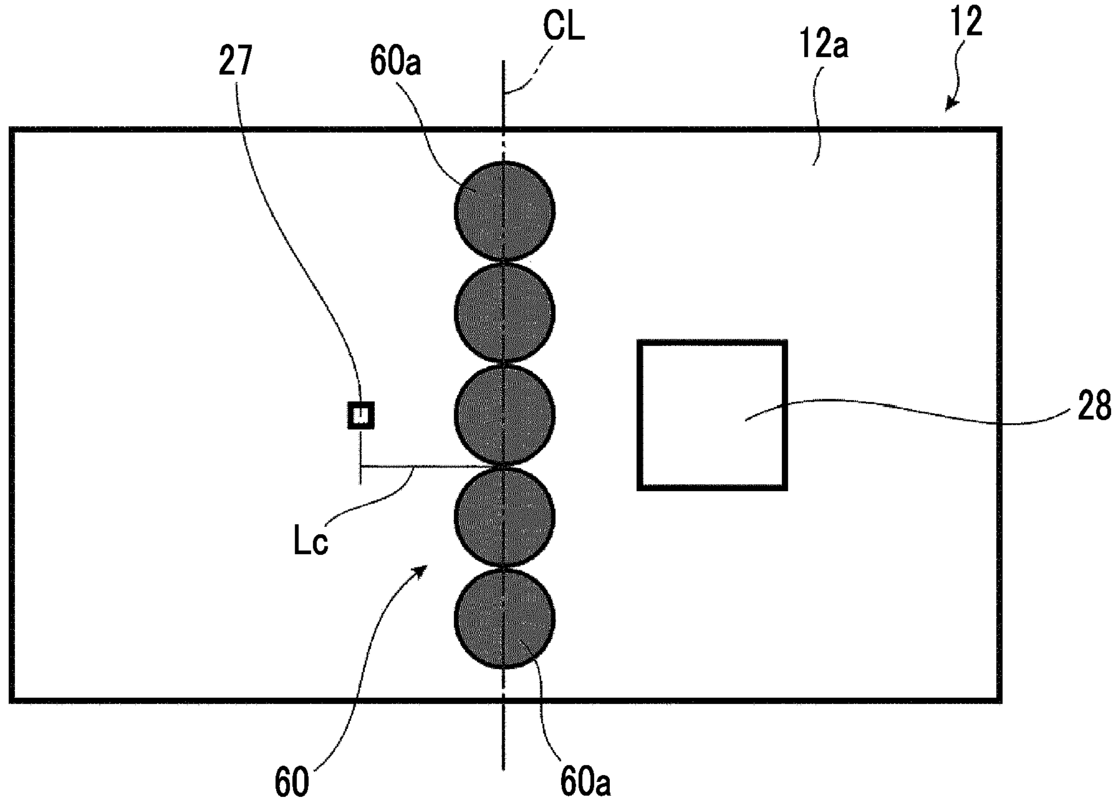


FIG. 23

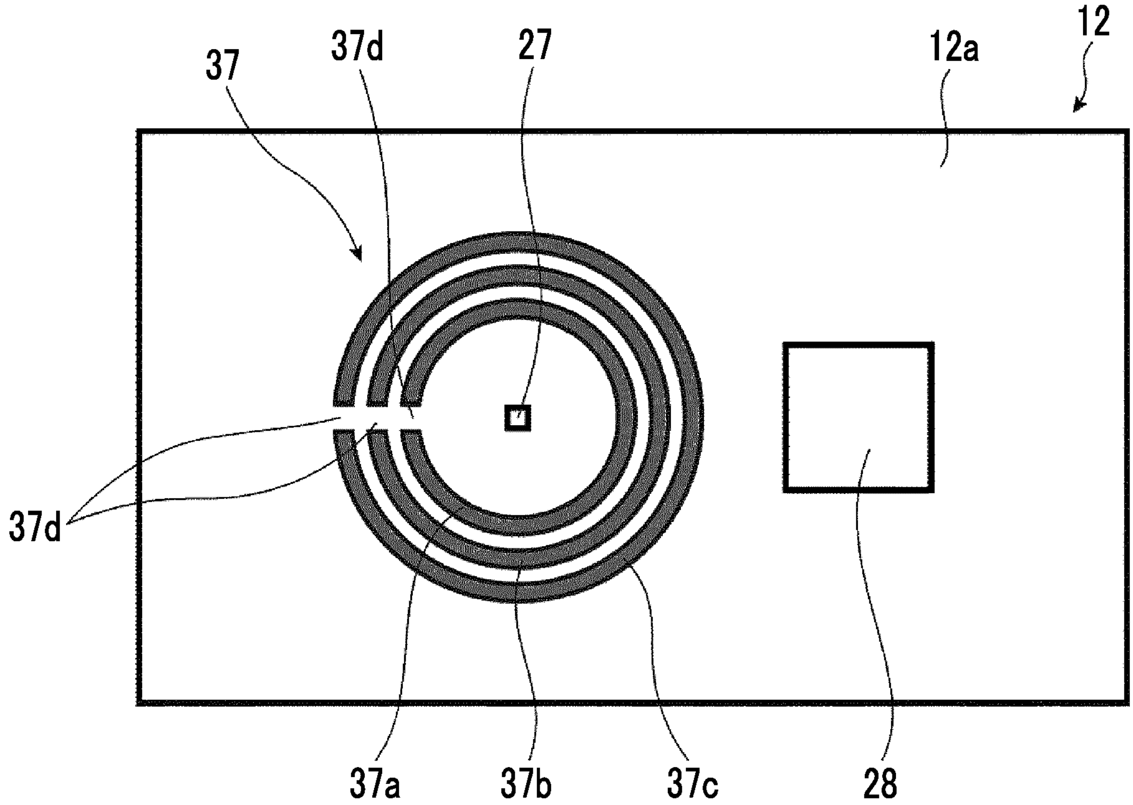

FIG. 24

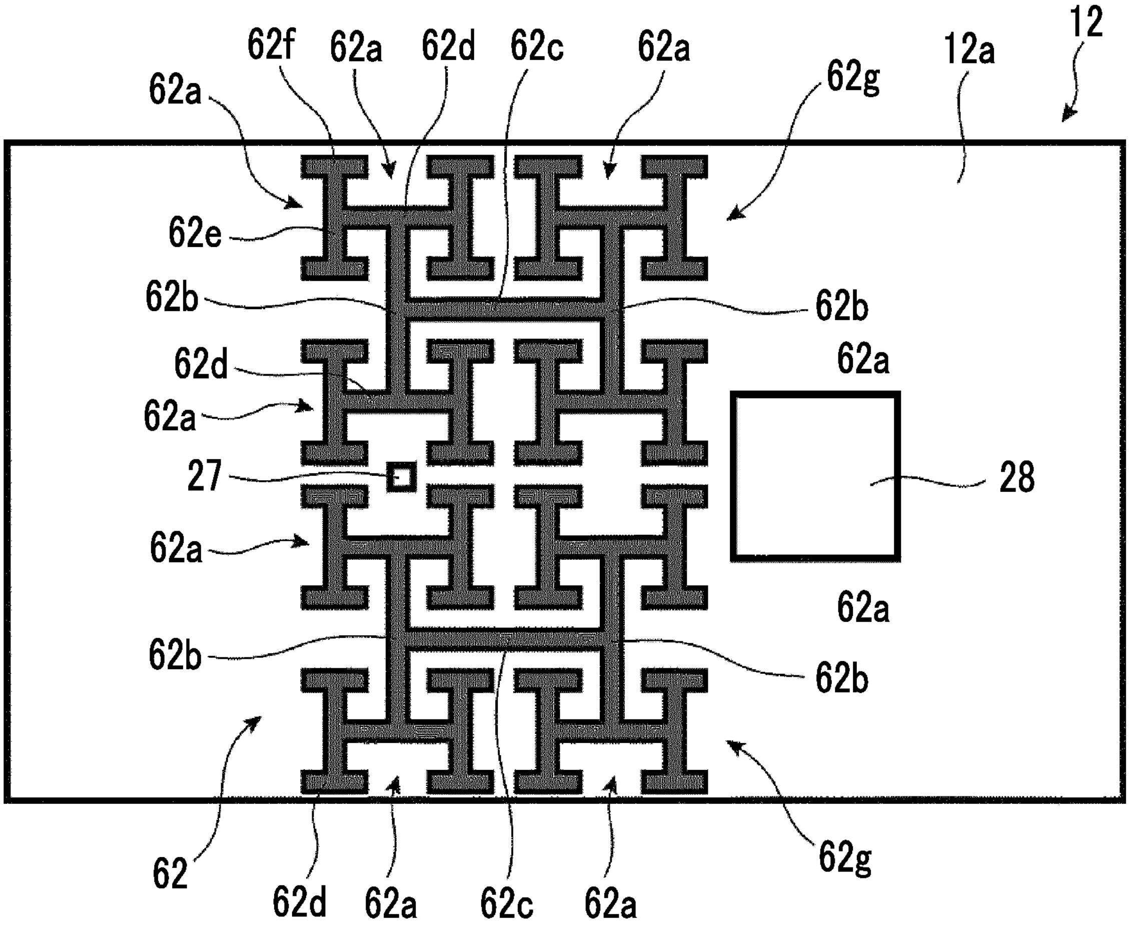
62f
62a
62d
62c
62a
12
12a
62g
62a
62e
62b
62b
62a
62d
62a
27
28
62a
62a
62b
62b
62
62d
62a
62c
62a
62g

FIG. 25

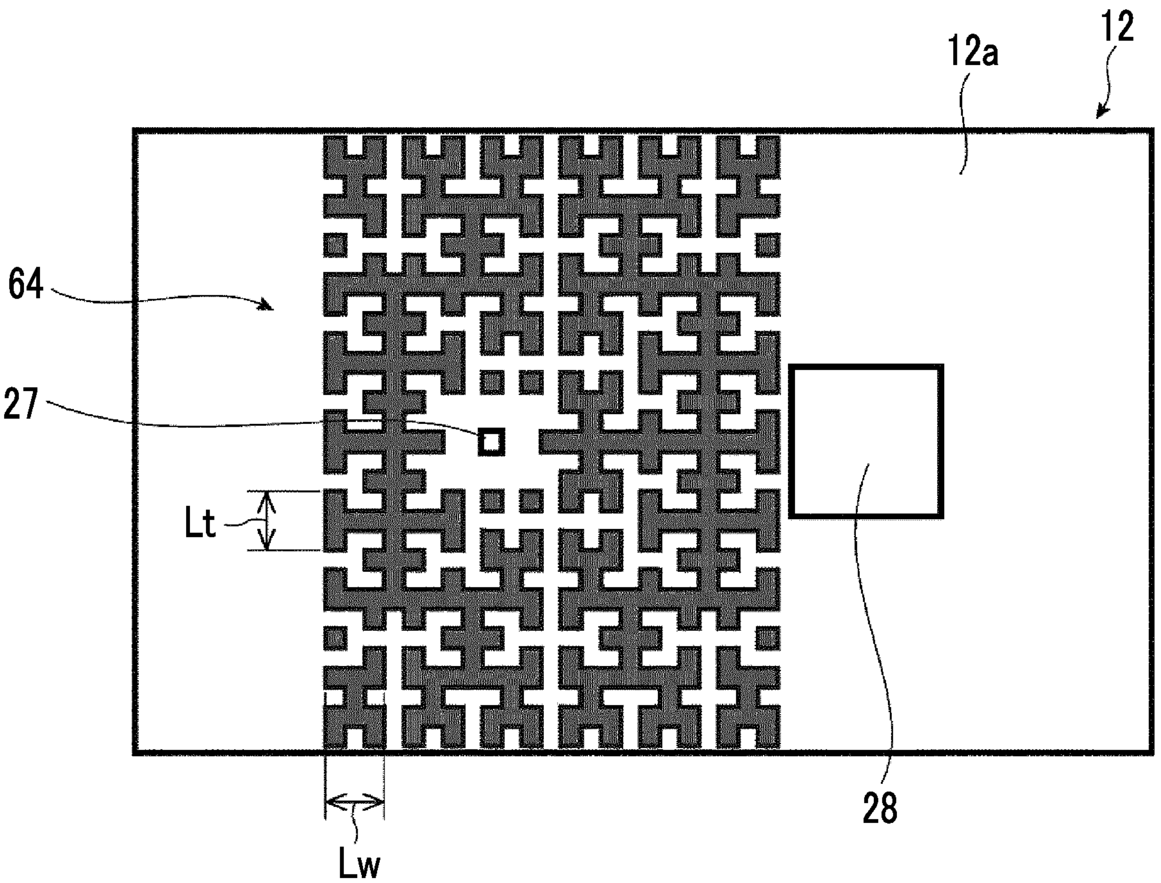

FIG. 26

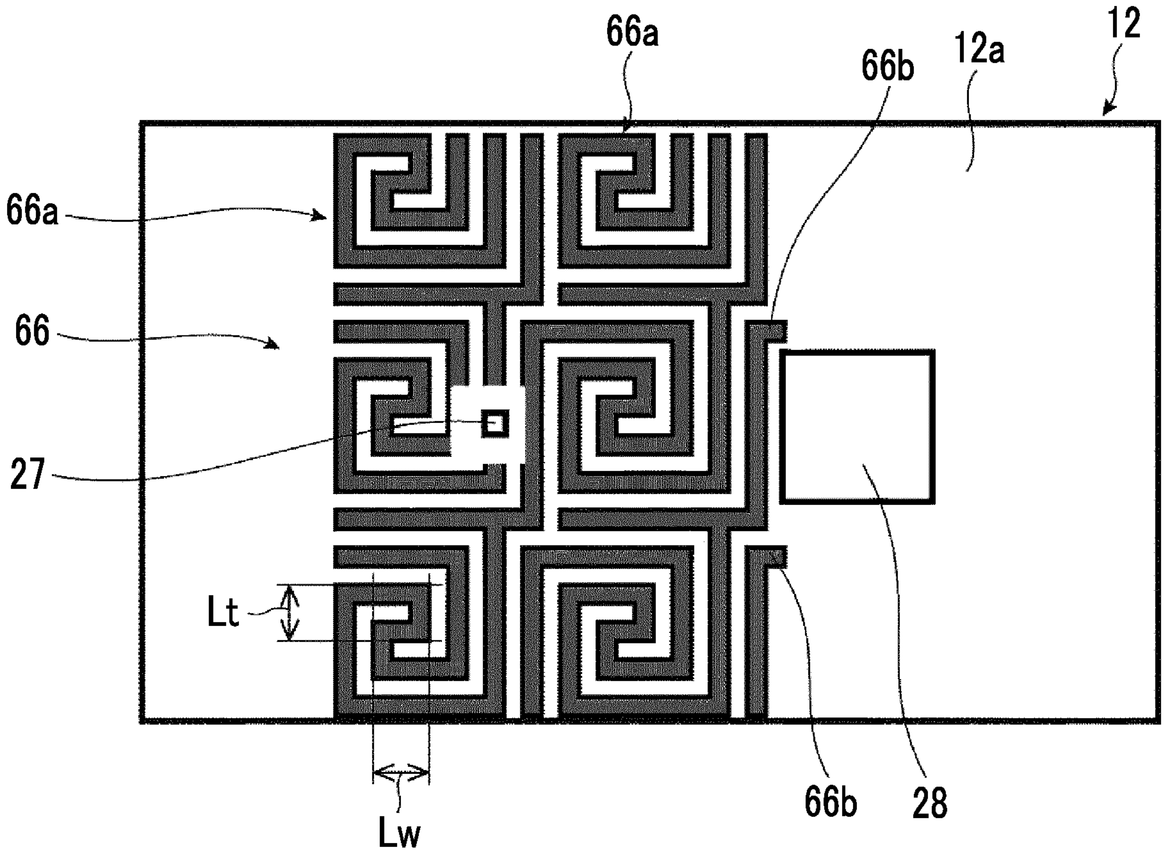

FIG. 27

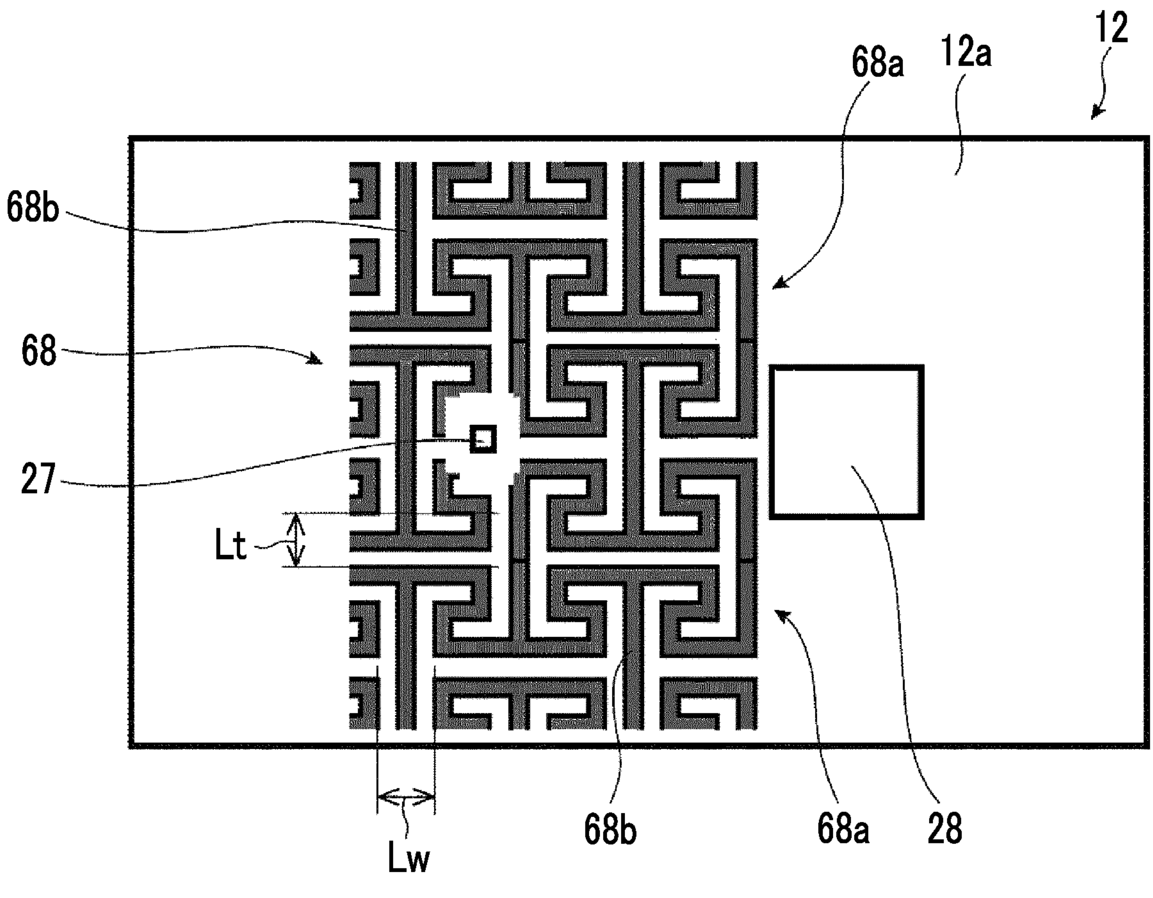

FIG. 28

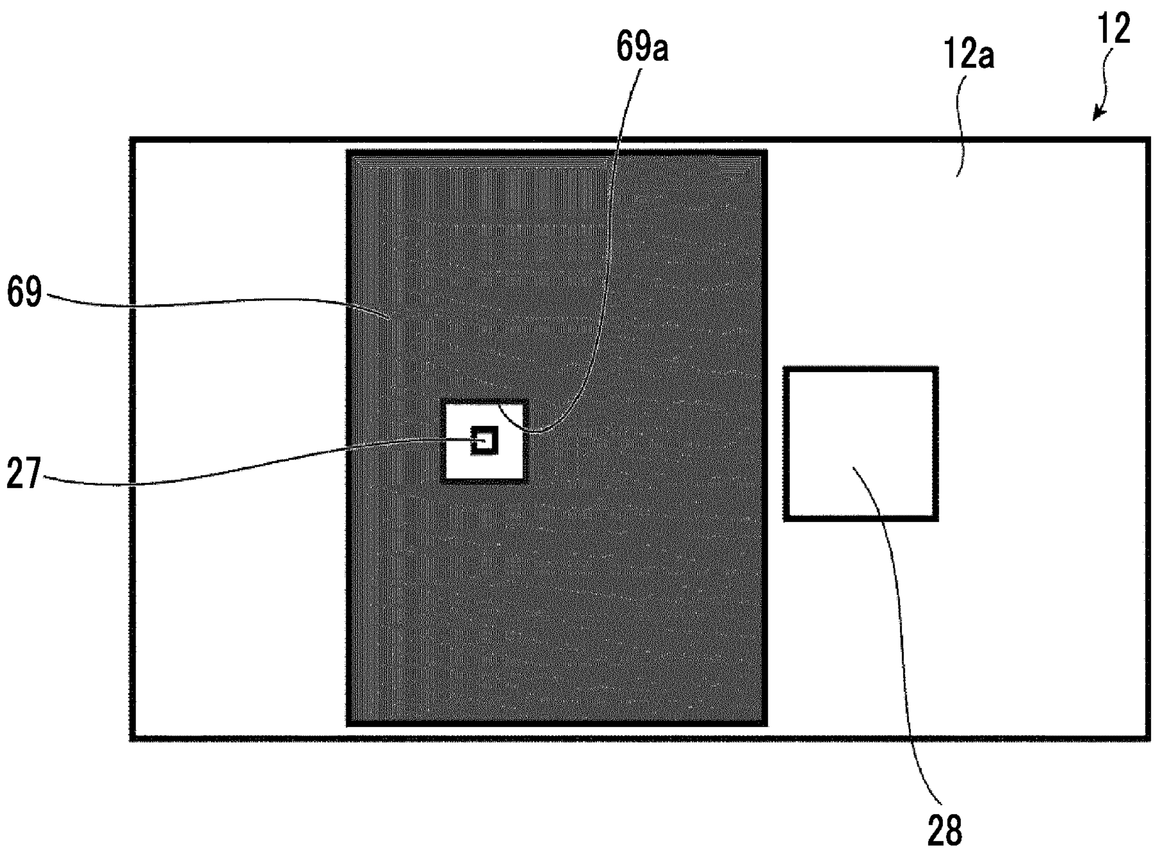

FIG. 29

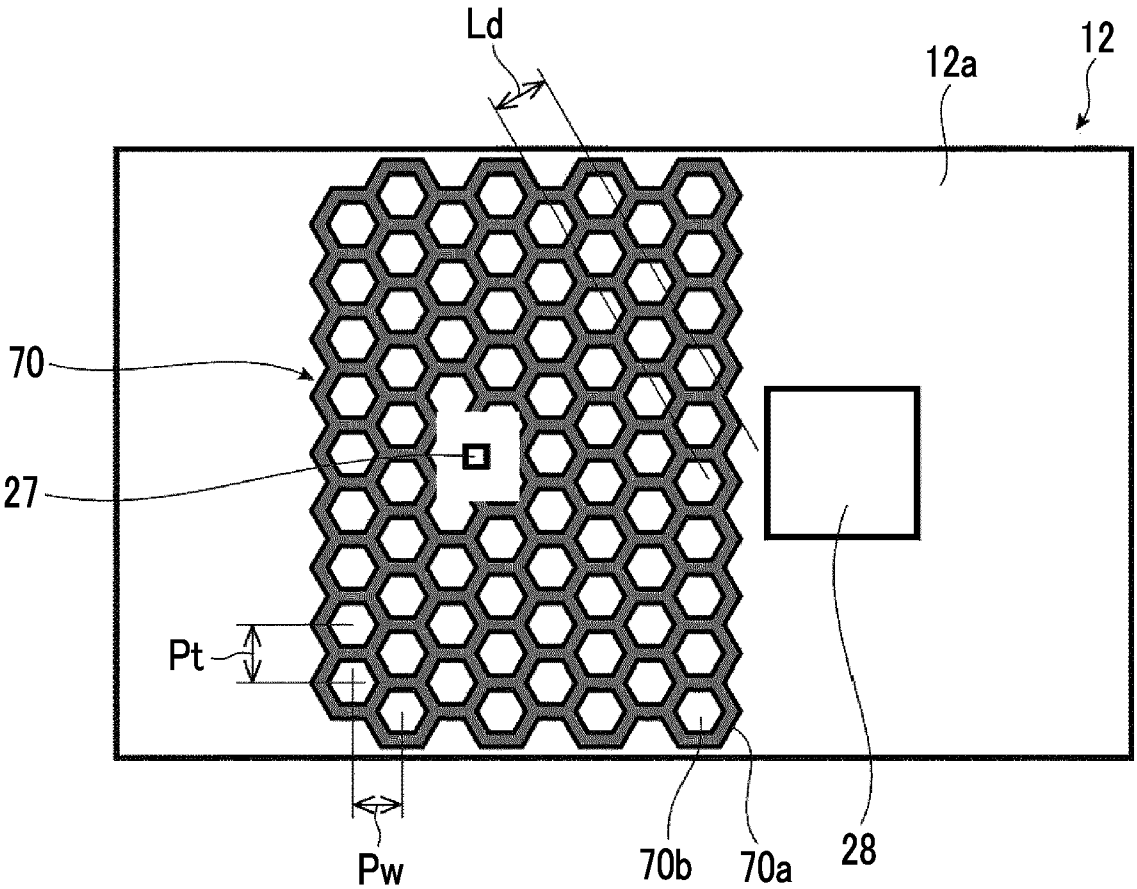

FIG. 30

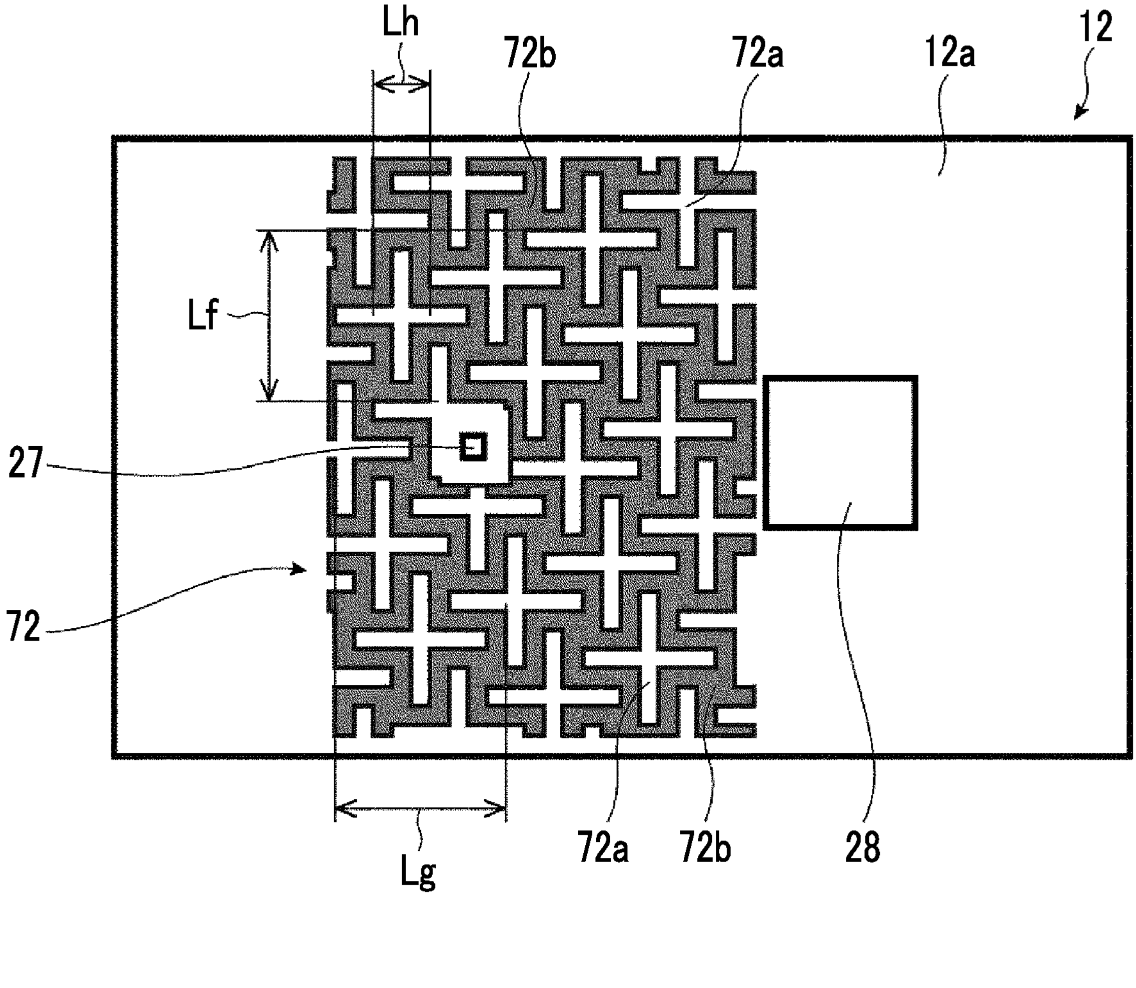

**INTERNATIONAL SEARCH REPORT**

International application No.
**PCT/JP2021/032590**

**A. CLASSIFICATION OF SUBJECT MATTER**

***H01Q 1/52***(2006.01)i; ***H01Q 17/00***(2006.01)i; ***H05K 9/00***(2006.01)i
FI: H01Q1/52; H01Q17/00; H05K9/00 M

According to International Patent Classification (IPC) or to both national classification and IPC

**B. FIELDS SEARCHED**

Minimum documentation searched (classification system followed by classification symbols)

H01Q1/52; H01Q17/00; H05K9/00

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | WO 2017/110113 A1 (TOKIN CORP.) 29 June 2017 (2017-06-29) paragraphs [0025]-[0028], fig. 1, paragraphs [0057], [0058], fig. 22, 23 (particularly, fig. 23) | 10 |
| Y | | 11 |
| A | | 1–9 |
| Y | JP 62-88141 A (FUJI PHOTO FILM CO., LTD.) 22 April 1987 (1987-04-22) page 2, upper right column, line 5 to page 5, upper left column, line 9 | 11 |
| A | JP 2006-304080 A (HITACHI METALS, LTD.) 02 November 2006 (2006-11-02) | 1-11 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **04 November 2021** | **16 November 2021** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (January 2015)

**INTERNATIONAL SEARCH REPORT**
**Information on patent family members**

International application No.
**PCT/JP2021/032590**

| Patent document cited in search report | Publication date (day/month/year) | Patent family member(s) | Publication date (day/month/year) |
|---|---|---|---|
| WO 2017/110113 A1 | 29 June 2017 | US 2019/0008079 A1 paragraphs [0053]-[0056], fig. 1, paragraphs [0086], [0087], fig. 22, 23 (particularly, fig. 23) | |
| | | CN 108370655 A | |
| | | KR 10-2018-0098368 A | |
| | | TW 201724962 A | |
| JP 62-88141 A | 22 April 1987 | (Family: none) | |
| JP 2006-304080 A | 02 November 2006 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2019057730 A
- JP 2008260927 A
- JP 2015068893 A
- JP 2013029760 A
- JP 2008292970 A
- JP 5923557 B
- JP 2010097210 A
- JP 2010168539 A
- JP 2014130173 A
- JP 6301489 B
- WO 2018221177 A
- WO 2018110179 A
- JP 2019043864 A
- JP 2019044030 A
- JP 2019167313 A
- JP 2020055992 A
- JP 2013190459 A
- JP 2001233842 A
- JP 2000080068 A
- JP 2006342166 A
- JP 2000066385 A
- JP 2004534797 A
- JP 2017019766 A
- JP 6065596 B
- WO 2015152153 A
- WO 2017051680 A
- JP 2017198865 A
- WO 2017164127 A
- WO 2013167515 A
- JP 2012014052 A
- JP 2014137466 A
- JP 6636081 B
- KR 1020160109444 A
- WO 2013083505 A
- JP 2010262028 A
- JP 2014500852 A
- JP 2013164471 A
- JP 2013114249 A
- JP 4223071 B
- WO 2015036910 A
- WO 2019088055 A
- JP 2010527339 A
- JP 2011524436 A
- WO 2015004565 A
- JP 2016532675 A
- WO 2017033680 A
- JP 2013522445 A
- WO 2016034963 A
- JP 2017523465 A
- JP 2017167399 A
- JP 2017151342 A
- JP 6469669 B
- WO 2015166779 A
- JP 2014041318 A
- WO 2014017669 A
- JP 2011132503 A
- JP 2020008634 A
- JP 2016216602 A
- JP 2010032698 A
- JP 2010164965 A
- JP 2015117327 A
- WO 2020084854 A

### Non-patent literature cited in the description

- **A. J. LEO.** Comprehensive Medicinal Chemistry. Pergamon Press, 1990, vol. 4, 295
- **C. HANSCH ; A. J. LEO.** Substituent Constants For Correlation Analysis in Chemistry and Biology. John Wiley & Sons
- **A. J. LEO.** Calculating log Poct from structure. *Chem. Rev.,* 1993, vol. 93, 1281-1306
- *MATERIAL STAGE,* 2019, vol. 19 (3), 37-60
- *J. C. S. Perkin II,* 1979, 1653-1660
- *J. C. S. Perkin II,* 1979, 156-162
- *Journal of Photopolymer Science and Technology,* 1995, 202-232